(19) Europäisches Patentamt
European Patent Office
Office européen des brevets

(11) EP 3 196 615 B1

(12) FASCICULE DE BREVET EUROPEEN

(45) Date de publication et mention de la délivrance du brevet:
**08.03.2023 Bulletin 2023/10**

(21) Numéro de dépôt: **17151542.2**

(22) Date de dépôt: **16.01.2017**

(51) Classification Internationale des Brevets (IPC):
***H01L 27/146*** (2006.01) ***G01J 5/02*** (2006.01)
***G01J 5/04*** (2006.01) ***G01J 5/20*** (2006.01)

(52) Classification Coopérative des Brevets (CPC):
**H01L 27/14618; G01J 5/024; G01J 5/045; G01J 5/20; H01L 27/1462; H01L 27/14629; H01L 27/14649; H01L 27/14685; H01L 27/14687;**
G01J 2005/204

# (54) PROCEDE DE FABRICATION D'UN DETECTEUR DE RAYONNEMENT ELECTROMAGNETIQUE A MICRO-ENCAPSULATION

HERSTELLUNGSVERFAHREN EINES DETEKTORS VON ELEKTROMAGNETISCHER STRAHLUNG MIT MIKRO-EINKAPSELUNG

METHOD FOR MANUFACTURING AN ELECTROMAGNETIC-RADIATION DETECTOR WITH MICROENCAPSULATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.01.2016 FR 1650438**

(43) Date de publication de la demande:
**26.07.2017 Bulletin 2017/30**

(73) Titulaires:
- **LYNRED**
  **91120 Palaiseau (FR)**
- **COMMISSARIAT À L'ÉNERGIE ATOMIQUE ET AUX ÉNERGIES ALTERNATIVES**
  **75015 Paris (FR)**

(72) Inventeurs:
- **VILAIN, Michel**
  **38450 Saint Georges des Commiers (FR)**
- **FAVIER, Jérôme**
  **38380 Saint Laurent du Pont (FR)**
- **YON, Jean-Jacques**
  **38360 Sassenage (FR)**
- **FREY, Laurent**
  **38600 Fontaine (FR)**

(74) Mandataire: **Cabinet Laurent & Charras**
**Le Contemporain**
**50 Chemin de la Bruyère**
**69574 Dardilly Cedex (FR)**

(56) Documents cités:
**EP-A1- 2 447 705** **WO-A1-2013/139403**
**WO-A2-2004/025694** **FR-A1- 2 901 264**
**FR-A1- 2 983 297** **US-A1- 2003 062 480**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE DE L'INVENTION**

La présente invention a trait au domaine des détecteurs de rayonnement électromagnétique comportant une matrice de détecteurs élémentaires intégrés de manière individuelle ou collective hermétique sous atmosphère contrôlée. Plus particulièrement, l'invention a trait à de tels détecteurs conçus pour la détection de rayonnement infrarouge, notamment le rayonnement infrarouge lointain (ou *LWIR* pour « *long-wavelength infrared* »), situé entre 8μm et 14μm.

L'invention trouve application dans le domaine des imageurs thermiques et les pyromètres, notamment les détecteurs bolométriques fonctionnant à température ambiante.

**ETAT DE LA TECHNIQUE**

Pour l'imagerie ou la thermographie (pyrométrie) infrarouge, il est connu d'utiliser un détecteur fonctionnant à température ambiante et comprenant une matrice de structures sensibles élémentaires qui exploitent la variation en fonction de la température d'une grandeur physique d'un matériau ou assemblage de matériaux approprié(s). Dans le cas particulier des détecteurs bolométriques, les plus couramment utilisés, cette grandeur physique est la résistivité électrique.

Un tel détecteur bolométrique comprend usuellement :

- un substrat, typiquement en silicium ;
- un ensemble matriciel de structures sensibles élémentaires, comportant chacune une membrane dite « bolométrique » (ou « bolomètre élémentaire ») maintenue en suspension au-dessus du substrat au moyen de bras de suspension à forte résistance thermique. Cet ensemble est communément désigné par le terme de « rétine sensible » ;
- des moyens électroniques d'adressage matriciel des bolomètres élémentaires et de formation d'un signal électrique à partir de chaque bolomètre élémentaire. Ces moyens sont intégrés au substrat, et le substrat et ses moyens électroniques est communément désigné par le terme « circuit de lecture » (ou *ROIC* pour « *Read-Out Integrated Circuit* ») ;
- un boîtier hermétique maintenu sous vide, ou plus exactement sous très faible pression interne (e.g. une pression inférieure à $10^{-3}$ mbar), dans lequel est logée la rétine sensible. Ce boitier comprend une fenêtre transparente au rayonnement d'intérêt disposée en regard de la rétine sensible. Le boitier comprend également des interconnexions électriques entre le circuit de lecture et l'extérieur du boitier. Le « vide » régnant dans le boitier a pour but de rendre les échanges thermiques entre les membranes sensibles et leur environnement via le gaz ambiant négligeable devant la conduction thermique des bras de suspension.

Le détecteur ainsi constitué est destiné à être intégré dans un système d'imagerie (e.g. une caméra) munie de l'électronique de pilotage et exploitation des signaux fournis par le circuit de lecture du détecteur, et d'une optique adaptée à la focalisation sur la rétine sensible de la scène thermique à observer. Ce système produit ainsi un signal vidéo représentatif de la température atteinte par chacun desdits détecteurs élémentaires, c'est à dire une « image thermique » de la scène observée.

Les techniques de fabrication, essentiellement de type microélectronique, mises en oeuvre pour fabriquer la rétine (dépôt chimique et physique en phase vapeur, photolithographie, gravure sèche ou humide, etc...) permettent d'atteindre des coûts de fabrication compatibles avec la diffusion de masse, mais le cout du boitier hermétique et des opérations d'assemblage sous vide, en d'autres termes du « packaging », demeure important et domine nettement le coût de fabrication du détecteur complet.

Le développement des détecteurs bolométriques à température ambiante, peu après leur apparition commerciale à la fin des années 1990, a ainsi porté une attention particulière à la fabrication du boitier afin d'en réduire le cout. Diverses techniques ont alors été développées pour limiter le cout du boitier, les premières d'entre elles étant des techniques dites de « *Wafer Level Packaging* » (*WLP*), dans lesquelles l'assemblage en une seule opération de deux substrats (un substrat *ROIC* comprenant une pluralité de rétines sensibles d'un côté, et un substrat comprenant une pluralité de fenêtres de l'autre) forme simultanément une pluralité de boitiers hermétiques. Dans ce domaine de la fabrication par report, les documents EP 2 447 705 et WO 2013/139403 décrivent un détecteur intégrant une optique particulièrement optimisée pour filtrer efficacement les rayonnements électromagnétiques. Cette fabrication collective de détecteurs par report de substrat permet une baisse du coût de fabrication de chaque détecteur, mais la validité économique reste tributaire des rendements cumulés des diverses opérations, qui restent malgré tout très complexes à maîtriser et qui nécessitent une série d'équipements très onéreux.

Le document FR2901264 A1 décrit un procédé de fabrication d'un microcomposant comprenant un capot. Ledit capot comporte une paroi sommitale comportant des moyens de rigidification formés d'au moins un élément de rigidification en saillie. Ledit capot est formé sur une couche sacrificielle comportant des dépressions. La couche sacrificielle est éliminée en l'évacuant par l'ouverture formée dans ledit capot.

Une manière de pallier en partie ces limitations est décrite dans le document FR 2 822 541. Ce document de 2001, soit seulement quelques années après l'émergence des rétines bolométriques, décrit une technique de fabrication collective d'un objet comportant des microcavités ou microcapsules formées au-dessus de chaque site de détection, ou de plusieurs sites simultanément jusqu'à la mise sous vide fonctionnelle à l'aide de techniques micro-électroniques collectives. Selon cette technologie, dite « monolithique », le confinement hermétique est fabriqué de manière analogue à la fabrication des membranes suspendues de la rétine sensible en utilisant des couches sacrificielles sur laquelle est formée la fenêtre-capot du « boitier » (ou plus précisément : microcavité, ou encore capsule). A la différence des techniques « *WLP* », il n'y a plus besoin d'un second substrat fenêtre de technologie elle-même complexe, ni des techniques et matériaux spécifiques d'assemblage hermétique de deux substrats, usuellement par brasage sans flux. Les difficultés propres aux techniques « *WLP* » et le recours à de nombreuses techniques inhabituelles en microélectronique sont ainsi éliminées, avec un nombre total d'opérations sensiblement réduit. De plus, la vulnérabilité des structures sensibles avant intégration sous vide et la contamination particulaire au cours de ces opérations, c'est-à-dire les pertes de rendement associées ou le coût des précautions nécessaires pour en limiter l'effet peuvent être considérées comme négligeables. Il en résulte un gain substantiel en termes de coût de fabrication du « packaging » par rapport aux techniques multi-substrats.

Les avantages de cette technique de fabrication étant nombreux, la solution présentée dans le document FR 2 822 541 a été et est toujours l'objet d'une recherche continue et intensive (voir par exemple le demande de brevet français FR 2 936 868 publié en 2010 ou encore dans le document « Latest improvements in microbolometer thin film packaging: paving the way for low-cost consumer applications » de J.J. Yon et al., Proc. SPIE 9070, Infrared Technology and Applications XL, juin 2014, la demande de brevet chinoise CN 102935994 publié en 2013, ou encore la demande de brevet internationale WO 2014/100648 publiée en 2014.

Cependant, la technique de confinement monolithique, tant dans sa version originale du document FR 2 822 541, que dans ses variantes améliorées, comme par exemple celle décrite dans les documents FR 2 936 868 US 2003/062480 et FR 2 983 297, n'est pas exempte de défauts. En effet, cette technique induit une transmission optique imparfaite de la partie « fenêtre » des capsules. Les principes généraux de cette technique et ses limitations propres sont à présent décrits en relation avec les vues en coupes schématiques des figures 1 et 2. Sur ces figures, il est illustré la réalisation d'une capsule individuelle, ladite capsule pouvant par exemple loger plusieurs membranes ou être une structure unique qui loge l'ensemble de la rétine, le positionnement, la répartition, les dimensions, la structure des parois latérales pouvant par ailleurs être très divers. De même les figures 1 et 2 illustrent un type de support mécanique des membranes sensibles au moyen de piliers. Le support des membranes n'est pas non plus une caractéristique essentielle, d'autres types de support mécanique étant possibles, par exemple au moyen de bras enchâssés dans les parois latérales des boitiers hermétiques ou de structures de renforts de ceux-ci, tel que par exemple décrit dans le document FR 2 930 639.

La figure 1 illustre le détecteur final fabriqué selon la technique monolithique, comprenant le substrat/circuit de lecture **10**, les membranes bolométriques **12** suspendues au-dessus du substrat **10** par des piliers **14** assurant également la continuité électrique entre les membranes et le substrat, et une microcavité **16**, par exemple hermétique, formée du substrat **10**, de parois latérales solidaire du substrat et du capot/fenêtre **20** solidaire des parois latérales **18**.

Selon la technique monolithique, tous les éléments venant d'être décrits sont fabriqués par dépôts successifs de couches de divers matériaux, sans jamais reporter un élément sur un autre, en d'autres termes sans assemblage de deux éléments préfabriqués indépendamment l'un de l'autre, puis solidarisés à l'aide par exemple de soudure, de brasure, d'adhésif, de collage moléculaire, etc.). La technique monolithique s'appuie au contraire sur des couches de matériau temporaires (plus communément appelées « couche sacrificielle »). Notamment, la fabrication monolithique des boitiers poursuit avantageusement la fabrication monolithique des membranes bolométriques suspendues de la rétine sensible illustrée à la figure 2A. Comme cela est connu, et par exemple décrit dans le document FR 2 752 299, une couche sacrificielle **22** est déposée sur le substrat **10** et les diverses couches constitutives des membranes **12** sont formées sur celle-ci, les piliers **14** étant par ailleurs fabriqués après gravure d'ouvertures (ou « vias ») dans la couche sacrificielle **22**.

Pour la fabrication monolithique du boitier **16**, une seconde couche sacrificielle **24** est déposée sur la première couche sacrificielle **22** et les membranes **12** (figure 2B). Une première couche **26** de matériau transparente aux rayonnements d'intérêt est ensuite déposée sur la seconde couche sacrificielle **24** (figure 2C).

Selon l'état de la technique, la première couche de matériau **26** est jugée comme étant d'une importance primordiale dans la fabrication monolithique, et doit mettre en oeuvre au moins six fonctions :

1. elle joue le rôle de « contre-masque dur » (ou « *hard mask* » en anglais) visant à protéger la surface de la seconde couche sacrificielle **24** pendant la gravure ultérieure directionnelle (anisotrope) des deux couches sacrificielles **22** et **24** afin de former les parois latérales **18**, sa surface étant par définition exposée à la gravure choisie à dessein pour graver le matériau des couches **22**, **24** ;

2. elle est inerte au processus de retrait des couches sacrificielles **22**, **24**. Ces couches ayant vocation à être retirées en totalité, en ne laissant aucune trace, sont généralement de nature organique (par exemple en polyimide) et sont dans ce cas ôtées à l'aide d'un plasma à base d'oxygène, particulièrement agressif. Alternativement, les matériaux sacrificiels minéraux de type *SiO* peuvent être préférés, auquel cas il est fait recours à l'acide fluorhydrique en phase vapeur (*HFv*) pour leur élimination, très agressif envers de nombreux matériaux usuels des assemblages microbolométriques.

3. elle est optiquement appropriée et plus précisément :

    ◦ transparente pour laisser passer le rayonnement à détecter ; et
    ◦ naturellement sans défaut local (continuité, lacunes, ou perforations dites « *pinholes* ») ou défaut topologique (surépaisseurs, inclusions ou particules adhérentes ou incluses perturbant la transmission optique qui compromettraient la qualité optique de la fenêtre **20**) ;

4. elle est hermétique, signifiant qu'elle ne présente pas les défauts structurels listés au point ci-dessus qui compromettent également l'herméticité finale du boitier ;

5. elle présente une très bonne qualité d'adhérence avec la couche sacrificielle supérieure **24** organique ou minérale ;

6. elle permet la réalisation d'ouvertures par gravure des évents, tels que décrits ci-dessous, de dimensions submicroniques de manière à maximiser la surface utile de collection de l'énergie radiative incidente sur l'emprise de chaque membrane de la rétine sensible.

La fabrication se poursuit (figure 2D) par la gravure anisotrope de la couche **26** et des couches sacrificielles **22**, **24** jusqu'au substrat **10**, afin de réaliser les séparations ou vias **28** dans lesquels sont formées les parois latérales **18**, par exemple une tranchée réalisée tout autour de chaque membrane **12**. Une seconde couche **30** de matériau transparente aux rayonnements d'intérêt est ensuite déposée de manière à au moins recouvrir, voire combler totalement les vias **28** formant ainsi les parois latérales **18** délimitant les éléments ou groupes d'éléments sensibles, ou/et des piliers de solidarisation entre le capot/fenêtre **20** et le substrat **10** (figure 2E). Cette seconde couche **30** est également jugée comme importante dans l'état de la technique puisqu'elle doit remplir ou au moins compéter les fonctions 2 à 6 décrites ci-dessus.

Au moins une ouverture (ou « évent ») **32** par boitier (par capsule) de petites dimensions, typiquement de moins de 0,5μm de largeur ou diamètre, est ensuite pratiquée par gravure directionnelle à travers les couches **26** et **30** (figure 2F). L'intérieur de chaque boitier est ensuite vidé de toute matière sacrificielle à travers l'évent **32** au moyen d'une gravure isotrope complète des couches sacrificielles **22** et **24** (figure 2G). Les membranes sensibles **12** restent maintenues au moyen des piliers **14** solidaires du substrat **10**. Les membranes **12** sont dès lors « libres » mais protégées des agressions mécaniques et de la contamination particulaire ambiante, puisque logées dans une cavité **34** délimitée par le substrat **10**, les parois latérales **18** et la partie supérieure **26**, **30** formant la base de la future fenêtre **16**.

Le processus se poursuit par la mise sous vide des cavités **34** en plaçant l'ensemble obtenu dans une enceinte pompée, puis en déposant sans rupture du vide une troisième couche **36** transparente aux rayonnements d'intérêt, jusqu'à obturer les évents **32** de manière hermétique (figure 2H). L'évaporation thermique est usuellement préférée pour cette opération critique, du fait des très basses pressions opératoires à la fois caractéristiques de ces procédés et typiquement requises en final à l'intérieur des capsules (inférieure à $10^{-3}$ mbar). D'autres architectures d'obturation sont proposées par exemple dans les documents décrivant la technique de référence, mais le mode retenu ici, décrit par le document WO 2013/079855A1, est préféré pour sa simplicité et un taux de perturbation optique (occultation, diffusion, déflection) négligeable de la fenêtre dans sa partie essentiellement parallèle au substrat. La cavité interne **34** de chaque boitier est ainsi définitivement scellée, et donc hermétique, à la pression souhaitée pour le fonctionnement du détecteur.

Optionnellement, pour améliorer la qualité optique de l'empilement des première et deuxième couches **26**, **30** appartenant à la fenêtre au droit des membranes **12**, une quatrième couche **38**, également transparente au rayonnement d'intérêt, est déposée sur la deuxième couche **36**, par exemple par évaporation thermique.

Les détecteurs ainsi intégrés sous vide de manière avantageusement collective, donc économique, sur un substrat de format standard peuvent alors être « singularisés » (séparés par découpe traditionnelle) puis intégrés dans leur conditionnement final (boitier, support, *PCB* etc...).

En pratique, la première couche **26**, mais également la deuxième couche **30** et les parois latérales **18**, sont constituées de silicium amorphe (« *a-Si* ») obtenu par *CVD* (pour « *Chemical Vapor Deposition* »). En effet, le silicium amorphe ainsi obtenu est particulièrement indiqué pour la formation des couches **26** et **30**, du fait de sa transparence très acceptable en infrarouge, sa simplicité de mise en oeuvre, l'absence de défaut local et topologique. De plus, l'adhérence du silicium amorphe est constatée très satisfaisante en surface des matériaux sacrificiels usuels tels un polyimide ou oxyde de silicium *SiO,* ou entre couches successives de même nature ou apparentées. Le silicium amorphe se caractérise en outre par une sélectivité excellente vis à vis des procédés usuels de gravure en plasma oxygéné (*ashing*) des matériaux organiques sacrificiels ou sous *HFv* pour les matériaux minéraux de type *SiO,* et son adéquation parfaite à la définition par lithographie et gravure sèche (*RIE*) des vias **28** et des évents **32.** En effet, ces derniers doivent typiquement être de très faible dimension (microniques, voire submicroniques pour les évents **32**), de manière à maximiser la surface utile de collection de l'énergie radiative incidente sur l'emprise de chaque point élémentaire de la rétine. Le silicium amorphe est également inerte à l'acide fluorhydrique en phase vapeur, en cas de mise en oeuvre de matériau déposé de type *SiO* alternativement aux couches sacrificielles organiques.

Enfin, la couche **26** doit être résistante mécaniquement, non poreuse et parfaitement adhérente aux matériaux et structures préformés en surface du substrat **10**. Le silicium amorphe *CVD* ajoute à ces qualités une aptitude particulière à recouvrir les dépressions à haut facteur de forme (profondeur / largeur) des motifs **28**, de manière « conforme », c'est-à-dire sans faiblesse de continuité et selon une épaisseur pratiquement constante. De fait, ce matériau est naturellement capable de satisfaire à cout limité toutes les fonctions et contraintes précédemment précisées, et il n'est pas connu de matériau plus apte à la formation au moins de l'embase de la fenêtre **16** dans ce contexte.

La troisième couche **36** est quant à elle usuellement obtenue par évaporation de germanium (Ge). L'intérêt du germanium évaporé, bien connu dans la formation des multicouches traditionnels destinés aux traitements antireflets ou/et passe-bande des fenêtres épaisses usuellement mises en oeuvre dans le domaine de tous les détecteurs opérant dans l'infrarouge, réside dans son indice optique élevé (4 - 4,2) et sa très bonne transparence. Par ailleurs et de manière déterminante, l'obturation hermétique des évents **32** par évaporation de germanium est reconnue satisfaisante.

La quatrième couche **38** est quant à elle constituée de sulfure de zinc (*ZnS*). Le sulfure de zinc est également d'usage commun dans le domaine des multicouches optiques infrarouges pour son relativement bas indice de réfraction (2,2 - 2,3), malgré ses limitations en termes de constantes mécaniques (dureté, résistance à l'abrasion) et de stabilité thermique problématique au-delà de 300°C.

La constitution matérielle optique des fenêtres de l'état de la technique est ainsi constituée d'un assemblage de trois matériaux de base (*a-Si*, *Ge*, *ZnS*) dont le choix est essentiellement dicté par un compromis complexe induit par la technique de fabrication monolithique.

Toutefois, l'épaisseur des différentes couches en présence définit également la transmittance de la fenêtre et notamment la qualité de cette transmittance. Plus particulièrement, il est recherché une transmittance entre 8 et 14$\mu$m pour l'infrarouge thermique (*LWIR*) qui :

- présente une valeur moyenne élevée dans la bande de longueur d'onde d'intérêt ; et
- présente des variations minimes dans ladite bande, ou en d'autres termes une transmittance la plus « plate » possible dans ladite bande.

A ces deux critères, qui impactent la sensibilité et la linéarité en réponse du détecteur, s'ajoute dans la grande majorité des cas un critère de filtrage de longueurs d'onde hors de la bande d'intérêt. Par exemple, dans le cadre d'une détection bolométrique *LWIR,* il est recherché un transmittance qui a une décroissance franche et profonde au moins du côté des courtes longueurs d'onde (<8$\mu$m), la fenêtre jouant ainsi le rôle de filtre coupe bas améliorant grandement la qualité de la détection.

La satisfaction simultanée de ces divers caractères spectraux est accessible lorsque le concepteur admet la mise en oeuvre d'un empilement optique « épais » formé de nombreuses couches superposées dont l'épaisseur optique totale est bien au-delà de la longueur d'onde centrale $\lambda_{10}$ de la bande d'intérêt. En effet, les interférences multiples très complexes de tels empilements offrent de nombreux degrés de liberté pour l'ajustement du spectre de transmittance, à tel point qu'il n'y a pas de critères, principes ou lois prédéfinis (hormis une absorption optique négligeable, dans la bande d'intérêt de toutes les couches mises en oeuvre pour leurs épaisseurs respectives) pour obtenir le meilleur compromis. Cette recherche de spectre de transmittance particulier relève de fait de la simulation numérique « aléatoire » et du savoir-faire du concepteur.

Dans le cas d'empilements simples réduits à quelques couches seulement, typique et particulier du présent contexte, le concepteur doit privilégier le premier critère de transmittance élevée dans la bande d'intérêt, au moyen de règles de conception simplifiées usuelles du domaine des filtres multicouches. Notamment, il est conduit pour chacune des couches formée d'un matériau d'indice optique (ou de réfraction) $n_i$ à préférer une épaisseur voisine de $p_i.\lambda_{10}/4n_i$, où $p_i$ est un entier et $\lambda_{10}$ est une longueur d'onde de la bande d'intérêt sur laquelle le multicouche est réglé (usuellement la longueur d'onde centrale de ladite bande). Dans l'état de la technique, ces critères préférentiels conduisent à retenir des épaisseurs respectivement de l'ordre de 0,6 à 1$\mu$m pour le silicium amorphe (somme des couches **26** et **30**), 1 à 2$\mu$m pour le germanium (couche **36**), 1,2$\mu$m environ pour le sulfure de zinc (couche **38**), de manière à former des structures adaptées à la détection entre 8$\mu$m et 14$\mu$m.

Un exemple de spectre de transmittance (rapport *I/I0*, *I0* étant l'intensité d'un rayonnement d'incidence normale sur la couche **38** et *I* étant l'intensité du rayonnement transmis sortant au-delà de la couche **26**) de la fenêtre seule est illustrée à la figure 3A avec des épaisseurs choisies selon la règle $p_i.\lambda_{10}/4n_i$, menant à un empilement de 0,7$\mu$m de *a-*

*Si* ($n$ =3,65), de 0,6µm de *Ge* ($n$ =4,2) et de 1,2µm de *ZnS* (n = 2,2), c'est à dire trois couches quart d'onde ($p_i$ = 1) accordées à 10µm. On observe que la transmittance moyenne sur la bande d'intérêt [8 ; 14µm] est voisine de 83%. Toutes les autres combinaisons d'épaisseur, accordées quart d'onde (ou multi quart d'onde c'est-à-dire avec $p_i$ > 1) ou non accordées conduisent à des spectres non concurrentiels, c'est-à-dire plus dispersés en amplitude intra-bande ou/et inférieurs en valeur moyenne.

Pour encore complexifier la problématique, les épaisseurs ci-dessus, considérées comme les meilleures au regard de la règle « $p_i.\lambda_{10}/4n_i$ », ne conviennent pas pour la fabrication monolithique. En particulier, l'épaisseur de 0,7µm de *a-Si* (couche **26** + **30**) peut être insuffisante pour réaliser des parois latérales **18** de résistance mécanique satisfaisante. De même, une épaisseur de 0,6µm de *Ge* de la troisième couche **36** n'est pas adéquate pour obturer de manière sécurisée les évents **32**, de sorte qu'une épaisseur nettement plus élevée au-delà de 1µm est préférable pour cette couche. Il convient donc de « dégrader » la transmittance par rapport à la règle «$p_i.\lambda_{10}/4n_i$» pour satisfaire pleinement aux contraintes mécaniques et d'herméticité. La figure 3B illustre ainsi un exemple de transmittance d'une fenêtre satisfaisant lesdites contraintes, constituée de 0,8µm de *a-Si,* de 1,6µm de *Ge* et de 1,2µm de *ZnS.* Il est ainsi obtenu un spectre de transmittance bien positionné entre 8 et 14µm, mais qui présente des oscillations notoirement plus marquées et une moyenne sensiblement moins favorable (-73%) que le « spectre idéal » de la figure 3A.

De plus, puisque dans ce contexte optique simplifié le filtrage coupe bas ne peut pas être optimisé conjointement à la transmittance dans la bande d'intérêt, il persiste un risque de sensibilité trop élevée aux courtes longueurs d'onde (e.g. en dessous de 8µm pour la bande *LWIR*), par suite de possibles correspondances « malencontreuses » des maxima respectifs de la transmittance spectrale de la fenêtre et du spectre d'absorption de la membrane sensible. En effet, les fortes irradiations accidentelles aux longueurs inférieures à 8µm sont susceptibles par exemple d'induire une dérive électrique problématique de la rétine sensible. En particulier, le spectre de la figure 3A par exemple présente plusieurs pics étroits, mais de transmittance très élevée, donc particulièrement redoutables, dans la bande en dessous de 7µm où une transmittance très faible est préférée.

Toutes ces problématiques imposent de prendre des mesures particulières, par exemple en termes de transmittance de la fenêtre, et/ou de résistance mécanique.

En synthèse, le réglage de la transmittance dans une bande d'un boitier fabriqué selon la technique monolithique est très complexe car il existe un grand nombre de contraintes de nature différentes à prendre en compte. Bien évidemment, si la fabrication monolithique d'un boitier hermétique a été illustrée ci-dessus en relation avec un détecteur infrarouge bolométrique, cette problématique survient également pour tout type de détecteur dont le boitier est fabriqué selon cette technique monolithique.

## EXPOSE DE L'INVENTION

Le but de la présente invention est donc de proposer un procédé de fabrication monolithique d'un boitier hermétique, en particulier logeant un dispositif de détection, permettant un réglage de la transmittance du capot/fenêtre de ce boitier vers des valeurs sensiblement plus élevées.

A cet effet l'invention a pour objet un procédé de fabrication d'un détecteur apte à détecter une gamme de longueurs d'onde [$\lambda_8$ ; $\lambda_{14}$] centrée sur une longueur d'onde $\lambda_{10}$, le détecteur comprenant un dispositif de détection apte à détecter ladite gamme [$\lambda_8$ ; $\lambda_{14}$] et un boitier hermétique sous une pression prédéterminée dans laquelle est logé ledit dispositif, ledit boitier étant formé d'un substrat, de parois latérales solidaires du substrat et d'un capot supérieur solidaire des parois latérales et comprenant une partie au droit du dispositif qui est transparente dans ladite gamme [$\lambda_8$ ; $\lambda_{14}$], le procédé comprenant :

- la réalisation dudit dispositif sur le substrat, ladite réalisation comprenant le dépôt d'une couche sacrificielle noyant totalement ledit dispositif ;
- la réalisation du capot sur la couche sacrificielle, ledit capot étant constitué d'un empilement de première, seconde et troisième structures optiques transparentes dans ladite gamme [$\lambda_8$ ; $\lambda_{14}$], la seconde et la troisième structures optiques ayant des indices de réfraction équivalents à la longueur d'onde $\lambda_{10}$ respectivement supérieur ou égal à 3,4 et inférieur ou égal à 2,3 ;
- suite à la réalisation d'une partie du capot comprenant au moins la première structure optique, la réalisation d'un évent d'accès à la couche sacrificielle au travers de ladite partie du capot, suivie de l'application, au travers de l'évent, d'une gravure pour retirer en totalité la couche sacrificielle,

Selon l'invention :

- l'épaisseur optique de la première structure optique est supérieure ou égale à $\lambda_{10}/10$ ;

- l'indice de réfraction équivalent $n_{eq}^1$ à la longueur d'onde $\lambda_{10}$ de la première structure optique est inférieur ou égal à 2,6 ;
- la face de la première structure optique formée sur la couche sacrificielle, est inerte à la gravure mise en oeuvre pour retirer la couche sacrificielle ; et

la réalisation de la première structure optique comporte en outre la formation d'un réseau périodique de dépressions dans la couche sacrificielle, le pas ou la période du réseau périodique étant inférieur à $\frac{\lambda_{10}}{3}$ ,la réalisation de la première structure optique conduisant au remplissage au moins partiel des dépressions dudit réseau.

En d'autres termes, dans l'état de la technique une première couche de silicium amorphe obtenu par dépôt *CVD* est déposée sur la couche sacrificielle et une seconde couche du même silicium est déposée sur la première couche pour les raisons évoquées ci-dessus. Or, ce matériau rend d'emblée difficile le réglage de la transmittance de la fenêtre en raison de son indice de réfraction élevé (égal en pratique à 3,4 $\pm$10% en bande LWIR) qui forme avec le vide interne du boitier une interface à grand saut d'indice. La formation d'une structure optique d'indice de réfraction équivalent (explicité ultérieurement) plus faible, en particulier inférieur ou égal à 2,6, minimise les pertes optiques liées à cette interface. A la lecture de la problématique exposée précédemment, ce qu'il faut comprendre d'une première structure optique constituée uniquement de silicium amorphe obtenu par dépôt *CVD* est qu'elle constitue aussi un verrou technologique important malgré ses nombreuses qualités remarquables. Toutefois, dans l'état de la technique, la première couche optique en *a-Si CVD* répond à de si nombreuses contraintes complexes, que chercher une alternative destinée à briser ce verrou sans générer de nouveaux problèmes technologiques insurmontables apparaît vain. De fait, son choix n'a jamais été remis en cause jusqu'à l'invention.

Selon un mode de réalisation non revendiqué :

- la réalisation de la première structure optique sur la couche sacrificielle comprend :

$$\frac{n_{s1}.e_{s1} + n_{s2}.e_{s2}}{e_{s1} + e_{s2}} \leq 2{,}6$$

expression dans laquelle :

- $n_{s1}$ et $n_{s2}$ sont respectivement les indices de réfraction à la longueur d'onde $\lambda_{10}$ de la première couche et de la deuxième couche ; et
- $e_{s1}$ et $e_{s2}$ sont respectivement les épaisseurs géométriques de la première couche et de la deuxième couche.

En d'autres termes, la première structure peut être constituée de plusieurs couches, chacune constituée d'un matériau unique.

Selon un mode de réalisation :

- la gravure isotrope prédéterminée est une gravure à base de vapeur acide fluorhydrique (*HFv*) ;
- et le matériau inerte à la gravure prédéterminée est du silicium amorphe *(a-Si)* ou du carbone amorphe (a-C) ou un alliage amorphe de carbone (C) et de silicium (Si) de type $a\text{-}Si_xC_{(1-x)}$ où $0 < x < 1$, ou un alliage amorphe de silicium (*Si*) et de Germanium (Ge) de type $a\text{-}Si_xGe_{(1-x)}$, où $0 < x < 1$.

En variante :

- la gravure isotrope prédéterminée est une gravure sèche oxydante ;
- et le matériau inerte à la gravure prédéterminée est du silicium amorphe *(a-Si)* ou un alliage amorphe de carbone (*C*) et de silicium (*Si*) de type $a\text{-}Si_xC_{(1-x)}$, où $0{,}05 \leq x < 1$, ou un alliage amorphe de silicium (*Si*) et de Germanium (*Ge*) de type $a\text{-}Si_xGe_{(1-x)}$, où $0 < x < 1$.

En d'autres termes, les matériaux permettent de remplir l'ensemble des contraintes décrites précédemment en relation avec le silicium amorphe déposé par *CVD.*

Notamment concernant le silicium amorphe, par exemple dans le cas d'une première structure optique constituée de ce matériau, celui-ci est déposé par dépôt chimique en phase vapeur assisté par plasma (ou *PECVD* pour « *Plasma-Enhanced Chemical Vapor Déposition* »), ce type de silicium présentant un indice de réfraction inférieur à celui du silicium amorphe déposé par *CVD.*

Selon une variante particulière non revendiquée, la deuxième couche de la première structure optique est constituée en entier de sulfure de zinc (*ZnS*), ce qui permet d'améliorer la transmittance de la fenêtre.

Selon l'invention, la réalisation de la première structure optique comporte la formation d'un réseau périodique de dépressions dans la couche sacrificielle, le pas ou la période du réseau périodique étant inférieur à $\frac{\lambda_{10}}{3}$, conduisant au remplissage au moins partiel des dépressions dudit réseau.

En d'autres termes, la première structure optique est ainsi constituée au moins en partie d'une texturation en réseau périodique correspondant au « moulage » des dépressions formées dans la couche sacrificielle, au moyen d'un ou plusieurs matériaux dont au moins le premier est inerte à la gravure destinée à l'élimination de ladite couche sacrificielle. Par exemple, cette réalisation comporte le dépôt d'une couche constituée d'un alliage amorphe de silicium (*Si*) et de Germanium (Ge) de type $a\text{-}Si_xGe_{(1-x)}$, où $0 < x < 1$, de manière à remplir au moins partiellement les dépressions dudit réseau.

Selon un mode de réalisation, la première structure optique a une épaisseur optique $e_1$ vérifiant la relation $e_1 = \frac{\lambda_{10}}{4}$.

Selon un mode de réalisation la deuxième structure optique est constituée entièrement de germanium (*Ge*) ou d'un empilement d'une couche de silicium amorphe *(a-Si)* et d'une couche de germanium (*Ge*).

Selon un mode de réalisation, la deuxième structure optique a une épaisseur optique $e_2$ vérifiant la relation $e_2 = p_2 \times \frac{\lambda_{10}}{4}$, expression dans laquelle $p_2$ = 1, 2 ou 4.

Selon un mode de réalisation, l'épaisseur géométrique totale des première, seconde et troisième structures optique est inférieure ou égale à $\frac{\lambda_{10}}{2}$.

Selon un mode de réalisation, la troisième structure optique est constituée entièrement de sulfure de zinc (*ZnS*).

Selon un mode de réalisation, la troisième structure optique est formée par la gravure d'un réseau périodique de dépressions dans l'épaisseur des matériaux formant la deuxième structure optique. En particulier, la troisième structure est formée au moins en partie par la gravure d'un réseau périodique de dépressions dans au moins une couche formée d'un alliage de type $a\text{-}Si_xC_{(1-x)}$, *ou* $a\text{-}Si_xGe(1-x)$ où $0 < x < 1$, notamment $x \leq 0{,}4$.

Selon un mode de réalisation, la troisième structure optique est formée par la gravure d'un réseau périodique de dépressions dans l'épaisseur des matériaux formant la deuxième structure optique, suivie du dépôt d'au moins une couche formée de carbone amorphe (*a-C*) ou d'un alliage amorphe de carbone (*C*) et de silicium (*Si*) de type $a\text{-}Si_xC_{(1-x)}$, où $0 < x < 1$, notamment $x \leq 0{,}4$, et de préférence $x \geq 0{,}05$.

Selon un mode de réalisation, la troisième structure optique a une épaisseur optique $e_3$ vérifiant la relation $e_3 = \frac{\lambda_{10}}{4}$.

Selon un mode de réalisation, le dispositif de détection comprend au moins une membrane bolométrique apte à absorber une partie du rayonnement dans ladite gamme [$\lambda_8$ ; $\lambda_{14}$] et suspendue au-dessus d'un réflecteur métallique, le procédé comportant :

- la détermination des variations de l'absorbance de ladite membrane en fonction de ladite structure optique de ladite fenêtre ;
- la détermination de gammes de valeurs pour l'indice de réfraction équivalent $n_{eq}^1$ de la première structure optique de la fenêtre, la distance entre la membrane bolométrique et le réflecteur métallique et/ou la distance entre la membrane bolométrique et la fenêtre en tenant compte des contraintes de fabrication et/ou de fonctionnement ; et
- la sélection, dans lesdites gammes déterminées, d'un quadruplet induisant une absorbance moyenne supérieure à 90% de ladite membrane dans ladite gamme [$\lambda_8$ ; $\lambda_{14}$];
- ledit quadruplet comportant au moins l'épaisseur géométrique, l'indice de réfraction équivalent $n_{eq}^1$ de la première structure optique de la fenêtre, la distance entre la membrane bolométrique et le réflecteur métallique et la distance entre la membrane bolométrique et la fenêtre.

Selon un mode de réalisation, la réalisation de la première structure optique comporte la formation d'un réseau périodique de motifs dans sa face au contact de la couche sacrificielle, et le facteur de remplissage du réseau, la distance entre la membrane et le réflecteur métallique et la distance entre la membrane et le capot sont choisies de manière à régler l'absorption moyenne de la membrane dans ladite gamme [$\lambda_8$ ; $\lambda_{14}$] sur une valeur supérieure à 90%.

En particulier, les motifs forment des plots ou une grille en silicium amorphe *(a-Si),* l'indice de réfraction du silicium amorphe *(a-Si)* étant compris entre 0,9×3,4, et 1,1×3,4, la période du réseau étant comprise entre 1 et 3μm, et :

- la distance *hP* entre la membrane et le capot est comprise entre 1μm et 1,5μm ;
- la distance *hR* entre la membrane et le réflecteur est comprise entre 1,8μm et 2,3μm ;
- la profondeur $e_T$ des plots du réseau est comprise entre 1,8μm et 2,1μm ; et

le facteur de remplissage *ff* du réseau de plots est compris entre 40% et 65% et le facteur de remplissage *ff* de la grille est compris entre 15% et 35%.

En variante, les motifs du réseau forment des plots ou une grille en silicium amorphe *(a-Si),* l'indice de réfraction du silicium amorphe *(a-Si)* étant compris entre 0,9×3,4 et 1,1x3,4, la période du réseau étant comprise entre 1 et 3μm, et :

- distance *hP* entre la membrane et le capot est comprise entre 1,5μm et 2μm ;
- la distance *hR* entre la membrane et le réflecteur est comprise entre 1,6μm et 2μm ;
- la profondeur $e_T$ des plots du réseau est comprise entre 1,8μm et 2,1μm ; et
- le facteur de remplissage *ff* du réseau de plots est compris entre 30% et 50% et le facteur de remplissage *ff* de la grille est compris entre 10% et 25%.

En variante, les motifs du réseau forment des plots ou une grille en silicium amorphe *(a-Si),* l'indice de réfraction du silicium amorphe *(a-Si)* étant compris entre 0,9×3,4 et 1,1x3,4, la période du réseau étant comprise entre 1 et 3μm, et :

- distance *hP* entre la membrane et le capot est comprise entre 2μm et 3μm ;
- la distance *hR* entre la membrane et le réflecteur est comprise entre 1,4μm et 1,8μm ;
- la profondeur $e_T$ des plots du réseau est comprise entre 1,5μm et 2,1μm ; et
- le facteur de remplissage *ff* du réseau de plots est compris entre 25% et 40% et le facteur de remplissage *ff* de la grille est compris entre 5% et 20%.

En particulier, pour une première structure optique formée d'une ou plusieurs couches de matériau non structurée :

- la distance *hP* entre la membrane et le capot est comprise entre 1μm et 1,5μm ;
- la distance *hR* entre la membrane et le réflecteur est comprise entre 1,8μm et 2,3μm ;
- l'épaisseur géométrique $e_1$ de la première structure optique est comprise entre 1,8μm et 2,1μm ; et
- l'indice de réfraction équivalent $n_{eq}^1$ de la première structure optique est compris entre 1,45 et 1,80.

En variante, pour une première structure optique formée d'une ou plusieurs couches de matériau non structurée :

- la distance *hP* entre la membrane et le capot est comprise entre 1μm et 2,5μm ;
- la distance *hR* entre la membrane et le réflecteur est comprise entre 1,6μm et 2μm ;
- l'épaisseur géométrique $e_1$ de la première structure optique est comprise entre 1,8μm et 2,1μm ; et
- l'indice de réfraction équivalent $n_{eq}^1$ de la première structure optique est compris entre 1,35 et 1,60.

En variante, pour une première structure optique formée d'une ou plusieurs couches de matériau non structurée :

- la distance *hP* entre la membrane et le capot est comprise entre 2μm et 3μm ;
- la distance *hR* entre la membrane et le réflecteur est comprise entre 1,5μm et 2,1μm ;
- l'épaisseur géométrique $e_1$ de la première structure optique est comprise entre 1,5μm et 2,1μm ; et
- l'indice de réfraction équivalent $n_{eq}^1$ de la première structure optique est compris entre 1,30 et 1,50.

Une première structure optique fabriquée en suivant ces paramètres permet d'obtenir une absorption dans la membrane suspendue entre le capot et le réflecteur supérieure ou égale à 95% dans la gamme de rayonnement [8 ; 14μm].

Selon un mode de réalisation, la membrane bolométrique est constituée de :

- une couche de nitrure de titane (*TiN*), de résistance de couche 380 Ohm/carré, d'épaisseur 8nm et d'indices $n$=10,5 et $k$=16, à 10μm de longueur d'onde ; et
- sur laquelle est déposée une couche de silicium amorphe (*a-Si*), d'épaisseur 200nm et d'indices $n$ = 3,42 et $k$ = 0 à 10μm.

L'invention a également pour objet un détecteur apte à détecter une gamme de longueurs d'onde [$\lambda_8$ ; $\lambda_{14}$] centrée sur une longueur d'onde $\lambda_{10}$, le détecteur comprenant un dispositif de détection apte à détecter ladite gamme [$\lambda_8$ ; $\lambda_{14}$] et un boitier hermétique sous une pression prédéterminée dans laquelle est logé ledit dispositif, ledit boitier étant formé d'un substrat, de parois latérales solidaires du substrat et d'un capot supérieur solidaire des parois latérales et comprenant une partie au droit du dispositif qui est transparente dans ladite gamme [$\lambda_8$ ; $\lambda_{14}$], ledit capot étant constitué d'un empilement de première, seconde et troisième structures optiques transparentes dans ladite gamme [$\lambda_8$ ; $\lambda_{14}$], la seconde et la troisième structures optiques ayant des indices de réfraction équivalents à la longueur d'onde $\lambda_{10}$ respectivement supérieur ou égal à 3,4 et inférieur ou égal à 2,3, et dans lequel :

- l'épaisseur optique de la première structure optique est supérieure ou égale à $\lambda_{10}$/10 ;
- l'indice de réfraction équivalent $n_{eq}^1$ à la longueur d'onde $\lambda_{10}$ de la première structure optique est inférieur ou égal à 2,6 ;
- et la première structure optique présente un réseau périodique de motifs bidimensionnels saillants (62), le pas ou la période du réseau périodique étant inférieur à $\lambda_{10}$/3.

## NOTATIONS ET DEFINITIONS

Dans le présent document, les notations et définitions suivantes sont utilisées :

- une « couche de matériau » ou « couche » désigne une matière, telle que par exemple obtenue par une technique de dépôt microélectronique (dépôt *CVD*, *PECVD*, *PVD*, etc.), définie entre deux surfaces opposées essentiellement parallèles (non nécessairement planes). L' « épaisseur d'une couche de matériau » désigne la distance géométrique entre ces deux surfaces particulièrement suivant un axe orthogonal au substrat. Une couche de matériau peut être constituée d'un unique matériau ou d'un empilement de plusieurs couches de matériaux différents. Une face d'une couche de matériau peut être ou non texturée. Sans autre précision explicite ou contextuelle, une couche de matériau se réfère à un élément constitué d'un unique matériau ayant des faces non texturées ;
- le terme « transmittance » *(T)* ne s'applique qu'à la structure complète du capot ou fenêtre et désigne le rapport spectral entre l'intensité transmise et l'intensité incidente mesurées dans les demi-espaces infinis de part et d'autre de la fenêtre, loin de celle-ci. On s'intéresse en outre particulièrement à la transmittance intégrée (ou moyenne) dans la bande d'intérêt, définie par l'expression :

$$\frac{1}{\lambda_{14}-\lambda_8}\int_{\lambda_8}^{\lambda_{14}} T(\lambda)d\lambda$$

  sans convolution avec la densité spectrale d'énergie de la scène thermique qu'il est question d'observer dans l'application finale. En effet, la loi de rayonnement du « corps noir » favoriserait sensiblement en bande *LWIR* la partie basse de la bande d'intérêt [8 ; 14μm] en termes d'énergie intégrée, lorsqu'on considère une scène thermique au voisinage de 300K, et ceci d'autant plus que la scène est chaude.
- la « transparence » d'un matériau ou d'une structure optique indique que la mise en oeuvre de ce matériau ou structure dans le contexte de l'invention (c'est-à-dire selon l'épaisseur envisagée de matériau ou/et la constitution de la structure) est associée à une perte négligeable d'énergie par absorption dans la bande d'intérêt, et plus précisément à moins de 2% de perte par absorption sur la transmittance intégrée telle que précédemment définie.
- l'« indice de réfraction » se réfère à l'indice de réfraction d'un unique matériau à la longueur d'onde centrale de la gamme de longueur d'onde d'intérêt, notamment les valeurs référencées dans « Handbook of Optical Materials (Laser & Optical Science & Technology », Marvin J. Weber, CRC Press, première édition, septembre 2002, ISBN-13: 978-0849335129 ;
- l'« indice de réfraction équivalent » se réfère à l'indice pondéré moyen d'un empilement de couches constituées chacune d'un unique matériau, à savoir l'indice $n_{eq} = (\Sigma_i n_i.e_i)/(\Sigma_i e_i)$, où $n_i$ est l'indice de réfraction du matériau d'une couche et $e_i$ est l'épaisseur géométrique de celle-ci. Lorsqu'une couche est constituée d'un unique matériau l'indice de réfraction équivalent est donc égal à l'indice de réfraction du matériau. Lorsqu'une couche est texturée, son

indice de réfraction $n_i$ est remplacé par l'indice de réfraction effectif ;

- l'« indice de réfraction effectif » se réfère à un indice de réfraction équivalent d'une couche de matériau présentant une texturation entre deux plans parallèles limitant le volume texturé. L'« indice de réfraction effectif » d'une telle structure texturée peut être approximé par exemple par l'expression $n_{eff} = \left(1/_{v} . \int_{v} n_{dv}^{2} . dv\right)^{0,5}$ , où $v$ est le volume par unité de surface (comprenant au moins une période complète de texturation dans les deux directions orthogonales à l'axe optique du système) compris entre les deux plans limitants, et $n_{dv}$ l'indice de réfraction local du matériau constitutif d'un volume infinitésimal particulier $dv$ à l'intérieur de ce volume. Dans le cadre d'une texturation consistant en des motifs périodiques juxtaposés constitués d'un matériau d'indice de réfraction $n_1$ séparés par un matériau ou milieu d'indice de réfraction $n_2$, l'indice de réfraction effectif peut être estimé par $n_{eff} = (ff.n_1^2 + (1 - ff).n_2^2)^{1/2}$ , où $ff$ est le taux de remplissage du réseau périodique. Cette expression se réduit à $n_{eff} = (ff.n^2 + (1 - ff))^{1/2}$ lorsque le milieu séparant les motifs est de l'air (e.g. le milieu extérieur de l'objet) ou le vide régnant typiquement dans la microcavité hermétique (e.g. lorsque la texturation concerne la surface interne de la cavité) ;
- l'« épaisseur optique » désigne pour une couche de matériau le trajet optique sous incidence normale, à savoir le produit $n_i.e_i$ de l'indice de réfraction équivalent de la couche par l'épaisseur géométrique $e_i$ de cette couche ; la notation « $e_i$ » désigne indifféremment l'épaisseur géométrique ou l'épaisseur optique, l'acception valide est attribuée explicitement à chaque occurrence ;
- une « structure optique » désigne un ensemble d'épaisseurs finies composé d'une superposition d'une ou plusieurs couches de matériaux planes ou texturées en réseau périodique dans le plan des couches, qui se comporte en pratique de manière indiscernable, en termes de propagation des ondes électromagnétiques dans la bande d'intérêt, d'une unique couche d'indice de réfraction égal à l'indice de réfraction équivalent à cet ensemble. Un tel comportement est par exemple obtenu lorsque les indices de réfraction réels ou effectifs des éléments constitutifs de cet ensemble sont proches les uns des autres, notamment diffèrent de moins de 15%, ou lorsque l'épaisseur optique d'une des couches de cet ensemble est insuffisante pour perturber notablement ce comportement à une longueur d'onde $\lambda$, soit typiquement inférieur à $\lambda/30$. Par exemple, l'ensemble constitué de la superposition d'une structure texturée d'indice effectif $n_{eff}$ pour une épaisseur géométrique $e_1$, et d'une couche de matériau essentiellement plane d'indice équivalent $n_2$ d'épaisseur géométrique $e_2$ conduit à approximer efficacement, au moins sous les conditions précisées de proximité des valeurs d'indices, l'indice équivalent de l'ensemble selon l'expression :

$$n_{eq} = {(e_1.n_{eff} + e_2.n_1)}\Big/{(e_1 + e_2)}$$

- une « dimension sub-longueur d'onde » désigne une grandeur inférieure à la borne inférieure de la bande d'intérêt ;
- un « matériau inerte à la gravure » désigne un matériau qui est très peu ou pas attaqué par une gravure destinée à graver un autre matériau, par exemple un matériau vérifiant *V(matériau) /V(autre matériau)* <1/10, de préférence inférieure à 1/100 et de préférence encore inférieure à 1/1000, où *V(matériau)* est la vitesse d'attaque du matériau par la gravure et *V(autre matériau)* est la vitesse d'attaque de l'autre matériau par la gravure ;
- le terme « sur » ou « au-dessus », ou encore « superposé », i.e. une deuxième couche « sur » une première couche, signifie « formé ultérieurement, en continuité structurale », sauf précision contraire.

## BREVE DESCRIPTION DES FIGURES

L'invention sera mieux comprise à la lecture de la descriptions qui va suivre, donnée uniquement à titre d'exemple, et réalisée en relation avec les dessins annexés dans lesquels des références identiques désignent des éléments identiques ou équivalents, et dans lesquels :

- la figure 1 est une vue schématique en coupe d'une membrane bolométrique d'un détecteur infrarouge logée dans un boitier individuel selon l'état de la technique ;
- les figures 2A à 21 sont des vues schématiques en coupe illustrant une fabrication monolithique du détecteur de la figure 1 ;
- les figures 3A et 3B illustrent deux transmittances de la fenêtre du détecteur de la figure 1 pour des épaisseurs différentes des couches constitutives de la fenêtre :
- les figures 4A à 4F sont des vues schématiques en coupe d'un procédé de fabrication monolithique d'un capot/fenêtre selon un premier mode de réalisation non revendiqué ;

- les figures 5A à 5C sont des tracés illustrant des spectres de transmittance de capots selon le premier mode de réalisation non revendiqué ;
- les figures 6A à 6E sont des tracés illustrant des spectres de transmittance de capots selon le second mode de réalisation non revendiqué ;
- les figures 7A à 7E sont des vues schématiques en coupe illustrant la fabrication d'un capot/fenêtre dont la première structure optique est texturée selon l'invention ;
- les figures 8A et 8B sont une vue schématique en coupe de premières couches texturées obtenues selon le procédé des figures 7A à 7E ;
- les figures 9A et 9B sont des vues schématiques en coupe de troisièmes structures optiques du capot/fenêtre :
- la figure 10 est un ensemble de spectres d'absorption d'une membrane bolométrique en présence de différentes fenêtres et sans fenêtre ;
- les figures 11A à 11F sont des abaques reliant différents paramètres de conception afin d'obtenir une absorption dans la membrane supérieure à 90% ;
- les figures 12A à 12C illustrent différents spectres d'absorption dans la membrane en fonction de différentes valeurs des paramètres de conception.

## DESCRIPTION DETAILLEE DE L'INVENTION

Il va à présent être décrit la fabrication monolithique d'un boitier, par exemple hermétique, d'un détecteur bolométrique à membrane suspendue destiné à détecter la bande de gamme de longueur d'onde [8 ; 14μm]. Comme pour l'état de la technique décrit précédemment, la forme, la géométrie, le nombre de membranes par boitier, etc., ne sont pas des caractéristiques essentielles dans le cadre des modes de réalisation revendiqués et non revendiqués. Les étapes de fabrication sont identiques à celles décrites précédemment, sauf s'il est précisé autrement.

Le mode de réalisation non revendiqué consiste notamment à fabriquer de manière monolithique pour le capot/fenêtre du boitier une première structure optique d'épaisseur optique $e_1$ sur la couche sacrificielle, transparente au rayonnement d'intérêt, d'indice de réfraction équivalent $n_{eq}^1$ inférieur ou égal à 2,6, et de préférence supérieur ou égal à 1,3. De préférence, l'épaisseur optique est supérieure à 0,5μm et préférentiellement voisine de, ou égale à, $\lambda_{10}/4$, où $\lambda_{10}$ est la longueur d'onde centrale de la bande d'intérêt, par exemple 10μm ou 1 1μm pour la détection *LWIR.*

Il sera détaillé d'abord des premier et deuxième modes de réalisation non revendiqués pour lesquels la fabrication de la fenêtre est réalisée à l'aide uniquement de dépôts successifs de couches de matériaux, le réglage des différents indices de réfraction et indice de réfraction équivalent étant basé sur le choix des matériaux déposés et leurs épaisseurs. Il sera ensuite détaillé des troisième mode de réalisation revendiqué et quatrième mode de réalisation utilisant en outre des texturations pour former la première structure optique afin d'obtenir un paramètre de réglage supplémentaire des indices de réfraction.

Le quatrième mode de réalisation selon l'invention comprend une première structure optique texturée selon le troisième mode de réalisation revendiqué. Le quatrième mode de réalisation combiné avec un premier ou un deuxième mode de réalisation non revendiqué ne fait pas partie de l'invention revendiquée.

Dans un cinquième mode de réalisation, il sera détaillé une optimisation de la première structure optique et de l'emplacement de la membrane par rapport à la capsule et à un réflecteur disposé sur le circuit de lecture.

Le cinquième mode de réalisation selon l'invention comprend une première structure optique texturée selon le troisième mode de réalisation revendiqué. Le cinquième mode de réalisation combiné avec un premier ou un deuxième mode de réalisation non revendiqué ne fait pas partie de l'invention revendiquée.

## A. FABRICATION MONOLITHIQUE PAR DEPOTS SUCCESSIFS

### PREMIER MODE DE REALISATION

Le premier mode de réalisation non revendiqué illustré en relation avec les figures 4A a 4F consiste notamment à remplacer la première couche de l'état de la technique constituée entièrement de *a-Si CVD* par une première structure optique comprenant une couche de *ZnS,* ou tout autre matériau d'indice adapté à l'objectif et productible selon un procédé adapté au contexte microélectronique. Cette première structure optique présente donc une constitution qui définit l'indice de réfraction équivalent souhaité inférieur ou égal à 2,6.

Le procédé de fabrication monolithique du boitier débute par exemple en poursuivant le procédé de fabrication monolithique de la rétine sensible telle que décrit en relation avec la figure 2A, en déposant sur la seconde couche sacrificielle **24** une première couche **40A** de matériau d'enrobage, ou « *liner* », (figure 4A) ayant essentiellement la fonction de contre-masque dur pour la gravure anisotrope des couches sacrificielles, et de protection de la couche de *ZnS* (sur sa face inférieure) ultérieurement déposée, lors de la gravure et le retrait des couches sacrificielles **22**, **24**. Le liner **40A** a aussi pour fonction d'assurer l'adhérence, la continuité physique et la stabilité mécanique de la première structure optique. Notamment, son épaisseur est choisie pour assurer ces fonctions tout en étant limitée, l'herméticité n'étant donc pas ici l'objectif poursuivi.

Dans une première variante, la couche **40A** est une couche d'épaisseur géométrique comprise entre 0,05 et 0,1μm de silicium amorphe *(a-Si).* De préférence, la couche de *a-Si* est obtenue à l'aide d'un dépôt à basse température (en dessous de 300°C), notamment un dépôt *CVD* assisté par plasma (*PECVD*), ce qui permet d'obtenir un silicium amorphe ayant un indice de réfraction inférieur au silicium cristallin (~3,4) dans la bande *LWIR,* de sorte que la couche **40A** est moins perturbatrice de l'indice de réfraction équivalent de la première structure optique. Notamment, il est avantageux de recourir à une couche de silicium amorphe obtenu par des procédés de dissociation essentiellement non thermique de silane ($SiH_4$) en dessous de 300°C typiquement, voire à température ambiante. Les méthodes d'activation par décharge gazeuse « *Glow Discharge* » (*GD*) dites aussi *PECVD* ou apparentées, opérées généralement mais pas nécessairement sous dilution d'hydrogène permettent d'accéder à des formes particulières de silicium (notées habituellement *a-Si:H*) à bas indice de réfraction de l'ordre de 2,5 - 2,6 en infrarouge lointain (*LWIR*).

De manière avantageuse, mais optionnelle, il est tout d'abord déposé sur la couche sacrificielle une couche dense à faible teneur en hydrogène, par exemple 20nm de *a-Si CVD.* Les potentielles effusions d'hydrogène adverses à la qualité du vide recherché dans le boitier sont ainsi limitées à ce que produit la technique connue. On notera que cette couche étant très fine, elle ne perturbe pas le comportement optique de la structure décrite ci-après.

Dans une seconde variante, la couche liner *a-Si* peut cependant être obtenue entièrement à l'aide d'un dépôt *CVD,* dont l'épaisseur limitée permet d'obtenir l'indice équivalent dans la gamme recherchée pour la première structure optique.

Une couche de *ZnS* **40B** est ensuite déposée (figure 4B) sur la première couche **40A**, notamment par évaporation, épaisse d'au moins 0,2μm, de manière à former avec la couche **40A** une première structure optique **40** d'épaisseur optique préférentiellement voisine de $\lambda_{10}/4$. Par exemple, pour compléter optiquement une couche **40A** constituée de 0,1μm *a-Si CVD* (n ~3,6), la couche **40B** a une épaisseur supérieure ou égale à 0,2μm. Par exemple, une épaisseur géométrique de *ZnS* comprise entre 0,8μm et 1μm permet l'obtention d'une première structure optique **40** d'indice de réfraction équivalent $n_{eq}^1 \sim 2{,}45$ sensiblement quart d'onde à 10μm.

Hormis un indice relativement bien adapté à un rôle optique efficace, le *ZnS* ne présente aucun des caractères nécessaires ou utiles à la construction des boitiers hermétiques, en particulier de petites dimensions (en dessous de 30μm par exemple) comme il est typiquement envisagé. Dit autrement, la première structure optique **40** n'est pas une couche hermétique, l'herméticité étant assurée par les couches supérieures.

Le procédé se poursuit par exemple comme dans l'état de la technique par la réalisation de vias (ou/et rainures) **28** dans la première couche optique **40** et les couches sacrificielles **22**, **24** jusqu'au substrat **10** (figure 4C), de dépôt *CVD* ou *PECVD* d'une couche de *a-Si* **30** de manière à tapisser, voire remplir les vias et former les parois latérales **18** du boitier (figure 4D), la réalisation des évents **22** au travers de la première couche optique **40** (figure 4E) et de la couche **30**, le retrait des couches sacrificielles et le dépôt des couches de *Ge* et *ZnS* (figure 4F).

On notera plus particulièrement que la couche de *a-Si* **30** peut être déposée par *CVD* sur la couche de *ZnS* **40B**. Si la couche de *ZnS* est réputée problématique en termes de stabilité physico-chimique au-delà de 300°C, les inventeurs ont cependant observé qu'elle supporte au contraire de manière acceptable l'activation thermique, usuellement de l'ordre de 350°C, requise pour la formation ultérieure de la couche **30** par *CVD.*

La figure 5A illustre un exemple de spectre théorique de transmittance résultant d'un empilement constitué de 0,1μm de *a-Si CVD* (couche **40A**), de 0,8μm de *ZnS* (couche **40B**), de 0,6 μm de *a-Si CVD* (couche **30**), de 1,2μm de *Ge* (couche **36**), et de 1,15μm de *ZnS* (couche **38).** La courbe en gras indique une transmittance calculée en tenant compte de l'indice de réfraction de chaque matériau en présence, et la courbe en trait fin en tenant compte de l'indice de réfraction équivalent de la structure optique **40A**, **40B**. Les trois structures optiques (première **40**, deuxième **30**+**36**, troisième **38**) sont ici toutes sensiblement accordées quart d'onde au voisinage de $\lambda_{10}$=10μm avec $p_1$=1, $p_2$=2 et $p_3$=1 de manière à produire une des formes préférentielles de fenêtre-capot précisées ultérieurement. Il est ici obtenu ~93% de transmittance moyenne sur la bande [8 ; 14μm] malgré des oscillations intra-bande non négligeables quoique très acceptables. L'estimation de transmittance résultant de la même structure sans « *liner* » **40A**, c'est-à-dire avec la couche de *ZnS* supposée seul constituant de la première structure optique accordée quart d'onde, est ~94%. La construction techniquement raisonnable à deux couches **40A**-**40B** n'induit ainsi qu'une dégradation de second ordre.

La figure 5B illustre le spectre résultant de l'empilement ci-dessus à la seule différence de l'épaisseur géométrique de *ZnS* de la couche **40B** égale à 0,4μm, soit très en dessous de la gamme jugée optimale en termes de transmittance moyenne (0,8 - 1μm). La figure 5C illustre le comportement de la transmittance moyenne en fonction de l'épaisseur géométrique de *ZnS* de la couche **40B** sans couche **40A**. Les deux courbes des figure 5A-C, indiquent respectivement le résultat soit d'un calcul détaillé tenant compte des indices et épaisseurs géométriques respectifs des couches **40A** et **40B**, soit au moyen d'une couche optique unique d'indice équivalent $n_{eq}^{1}$ , et d'épaisseur totale optique supérieure à $\lambda_{10}/10$, en particulier égale à $\lambda_{10}/4$. Il est ainsi obtenu, sur toute la partie de la fenêtre recouverte de la couche **40B**, une amélioration substantielle de la transmittance dans la bande d'intérêt. La transmittance moyenne étant déjà améliorée d'environ 10 points par la mise en oeuvre d'une couche **40B** de *ZnS* d'épaisseur géométrique très limitée (de l'ordre de 0,3μm), et la structure préférentielle optimisée procurant un gain très substantiel de plus de 20 points, sans par ailleurs qu'il soit observé une dégradation de la variation intra-bande de la transmittance.

La similitude acceptable entre les résultats détaillés (tenant compte des indices de réfraction distribués) ou simplifiés (tenant compte des indices de réfraction équivalents) justifie par ailleurs l'usage simplificateur des indices équivalents en termes de définition des caractères des modes de réalisation revendiqués et non revendiqués. Il a été retenu dans les exemples relatifs aux figures 5A-C une épaisseur géométrique de 0,1μm pour le « liner » **40A** *a-Si CVD* d'indice ~3,6, c'est-à-dire qui correspond à une épaisseur optique de la première structure délibérément un peu plus épaisse que la limite indicative (pour $\lambda_{10}$ = 10μm) $\lambda_{10}/30$ d'exploitabilité de l'indice $n_{eq}^{1}$ . L'erreur résultante sur le spectre de transmittance et plus encore sur la transmittance intégrée sur la bande d'intérêt reste très limitée, et tout-à-fait acceptable.

DEUXIEME MODE DE REALISATION

Selon un second mode de réalisation non revendiqué, la première structure optique est obtenue au moins partiellement, au moyen d'une couche d'alliage amorphe de carbone et silicium (*a-*$Si_xC_{(1-x)}$ avec 0<x<1) ou de carbone amorphe (*a-C*), ces deux cas étant par la suite désignés par les termes « *a-*$Si_xC_{(1-x)}$, $0 \leq x < 1$ ».

En termes optiques, les matériaux de type *a-*$Si_xC_{(1-x)}$ sont connus pour présenter des bandes d'absorption en particulier vers 12,8μm (780cm$^{-1}$ en notation spectroscopique) et donc dans la bande *LWIR*. Ces bandes d'absorption au-delà de 9μm disparaissent en pratique des matériaux proches de *x* = 0 et *x* = 1, car liées en particulier aux liaisons *C-Si,* et sont en conséquence particulièrement intenses dans les alliages plus ou moins équilibrés en proportions *C*/*Si* (c'est-à-dire proches de *a-SiC*). Ce trait défavorable est *a priori* rédhibitoire en bande *LWIR* dans le cadre de la formation de fenêtres attendues essentiellement transparentes sur toute la bande. Cependant, on préconise d'une part l'usage de matériaux peu chargés en silicium, de transparence très acceptable, soit peu chargés ou exempts de carbone, et d'autre part selon des épaisseurs géométriques très faibles de l'ordre de 1μm. Par ailleurs, même pour une formulation «pire cas » au voisinage de la forme stoechiométrique du carbure de silicium amorphe *a-SiC (x* ~0,5) le facteur d'absorption peut être contenu sur tout le spectre *LWIR* en dessous de 200cm$^{-1}$.

Cette valeur produit une atténuation en incidence normale de 1% du rayonnement à la longueur d'onde d'absorption maximale pour une épaisseur géométrique de 0,5μm, et sensiblement moins après intégration sur toute la bande d'intérêt. Ainsi même dans le cas de composition *a priori* le moins favorable (*x* ~0,5), la perte de sensibilité engendrée du détecteur reste modérée, et en outre très largement compensée par l'amélioration de la transmittance moyenne induite par le choix de ce matériau.

Notamment, le second mode de réalisation non revendiqué diffère du premier mode de réalisation non revendiqué en ce que la couche **40A** de *a-Si* ou les couches **40A** de *a-Si* et **40B** de *ZnS* du premier mode de réalisation non revendiqué est (sont) remplacée(s) par une couche de *a-*$Si_xC_{(1-x)}$, $0 \leq x < 1$, par exemple déposée au moyen d'une méthode de dépôt *PECVD.*

De tels matériaux ont été largement documentés dans la littérature, et disponibles relativement aisément par diverses techniques connues, en particulier de type *PECVD.* On verra par exemple les documents : A. Carbone et Al in J. Mat. Res., Vol 5, N°12, Dec 1990 ; ou I. Pereyra et Al in Brasilian J. of Phys., Vol. 30, Sept 2000 ; ou B. Racine et Al in J. Ap.Phys., Vol 90, Nr 10, Nov 2001 ; ou encore *A.* El Khalfi et Al in Arabian J. for Sci. and Eng., Volume 39, Issue 7, July 2014, pp 5771-5776.

Notamment, il est connu la fabrication d'une couche de silicium amorphe obtenu par des procédés de dissociation non thermique de silane ($SiH_4$) en dessous de 300°C typiquement, voire à température ambiante. Les méthodes d'activation par décharge gazeuse « *Glow Discharge* » (*GD*) dites aussi *PECVD* ou apparentées, opérées généralement, mais pas nécessairement sous dilution d'hydrogène, permettent d'accéder à des formes particulières (notées habituellement *a-Si:H*) à bas indice jusqu'à 2,5 - 2,6 en infrarouge lointain (*LWIR*). En alliant le silicium amorphe obtenu par ces méthodes avec une quantité modérée, par exemple 5 à 20% (At) de carbone au moyen d'additifs gazeux organiques appropriés (e.g. hydrocarbures divers tels $CH_4$, $C_2H_2$, $C_2H_4$, etc.), il est connu de former un alliage de type *a-*$Si_xC_{(1-x)}$.

Dans une première variante, particulièrement avantageuse en termes de transparence, la première structure optique **40** est au moins partiellement constituée, et de préférence essentiellement, de carbone amorphe (cas *x* = 0). Une couche de *a-C* est usuellement produite au moyen de précurseurs gazeux carbonés (hydrocarbures divers tels

$CH_4$, $C_2H_2$, $C_2H_4$, etc.) décomposés sous basse pression et basse température, voire à température ambiante, par activation plasma parfois libellée « *glow discharge* » dans la littérature anglo-saxonne, typiquement pour former des couches fines dites « *DLC* » (*Diamond Like Carbon).*

Les matériaux en couches minces *a-C* présentent un indice de réfraction de l'ordre de 2 à 2,2 sur la bande *LWIR* selon leurs détails structuraux, et une transparence optique très acceptable dans l'infrarouge. Ces valeurs d'indice faibles sont très avantageuses pour limiter les pertes dioptriques en réflexion (dites de Fresnel) à l'interface vide interne du boitier - paroi inférieure de la fenêtre, et exploiter au mieux les réflexions partielles à l'interface avec la seconde couche optique « haut indice » disposée au-dessus (e.g. couche **30** de *a-Si* + couche **36** de *Ge*).

En effet, du point de vue optique, la fenêtre est constituée :

- d'une première structure optique **40**, d'indice de réfraction équivalent $n_{eq}^1$ ;
- surmontée d'une deuxième structure optique formée des couches **30** et **36**, d'indice de réfraction équivalent $n_{eq}^2$ ;
- surmontée d'une troisième structure optique constituée de la couche **38**, d'indice de réfraction équivalent $n_{eq}^3$ .

Or, au moins dans le cas où la deuxième structure optique **30**, **36** est très épaisse, c'est-à-dire sans nécessiter de considérations interférentielles, il est connu comme avantageux que les première et deuxième structures optiques soient conçues de manière à vérifier la relation $n_{eq}^1 = \sqrt{(n_{eq}^2)}$ , ce qui permet d'annuler la réflexion lorsque la première structure est accordée quart d'onde ($\lambda_{10}/4$). Il en va de même dans le cas présent d'empilement de structures d'épaisseurs optiques limitées participant toutes au processus interférentiel. Cette relation est plus aisée à obtenir en raison de l'indice de réfraction du *a-C.* Par exemple, la construction de référence mettant en oeuvre par ailleurs avantageusement du germanium d'indice 4 - 4,2 en bande *LWIR* comme constituant principal de l'ensemble **30** + **36**, un indice de l'ordre de 2 - 2,1 pour la première structure optique **40** permet d'obtenir ou de s'approcher de ladite relation.

De manière avantageuse, une couche de liner **40A** constituée de *a-Si CVD,* d'épaisseur géométrique comprise par exemple entre 0,05$\mu$m et 0,1 $\mu$m, est préalablement déposée sur la couche sacrificielle afin de limiter l'érosion de la couche de *a-C* sous l'effet du plasma oxydant typiquement mis en oeuvre lors de la « gravure » subséquente (*ashing*) d'évacuation des matériaux sacrificiels organiques. Cette couche de liner présente également l'avantage de former une barrière contre l'hydrogène contenu dans la structure du carbone amorphe, et ainsi de se prémunir contre la possible effusion à long terme dans le boitier une fois scellé.

Alternativement, la couche de liner **40A** est une couche de $a\text{-}Si_xC_{(1-x)}$ où $x$ n'est pas négligeable en proportion atomique, typiquement ≥ 0,05, et de préférence ≤ 0,5, par exemple d'une épaisseur géométrique comprise entre 0,05$\mu$m et 0,1$\mu$m. Non seulement cette couche est avantageusement compatible chimiquement avec le *a-C* qui la surmonte, mais en outre l'indice de réfraction du $a\text{-}Si_xC_{(1-x)}$ est nettement inférieur à celui du *a-Si CVD.* En effet l'indice en bande *LWIR* de ces matériaux alliés croit avec le taux de silicium ajouté, mais reste au voisinage de valeurs idéales procurées par le carbone amorphe aux basses concentrations de silicium, sans dépasser typiquement 2,4 jusqu'à près de 50% de Si ($x$ = 0,5). En procédant de la sorte, le silicium même en proportion faible contenu dans le matériau de la couche **40A** s'oxyde sur les premières couches superficielles et protège la matière sous-jacente de l'érosion oxydative typique des procédés d'élimination des couches sacrificielles organiques. De manière avantageuse, mais optionnelle, il est tout d'abord déposé sur la couche sacrificielle une couche formant barrière contre l'hydrogène, par exemple 20nm de *a-Si CVD* pour se prémunir comme indiqué plus haut des éventuelles effusions d'hydrogène contenu dans la structure du matériau $a\text{-}Si_xC_{(1-x)}$. Là encore, cette couche étant très fine, elle ne perturbe que très peu le comportement optique de la structure.

Cependant, une couche « liner » **40A**, ou l'incorporation de silicium dans la masse de la couche **40**, n'est pas nécessaire si le matériau des couches sacrificielles **22**, **24** est de nature minérale, c'est-à-dire ne nécessite pas de procédé oxydant pour son élimination.

Dans une seconde variante, la première structure optique **40** est constituée en totalité d'une unique couche de $a\text{-}Si_xC_{(1-x)}$, avec $0,05 \leq x \leq 0,5$, ce matériau permettant de jouer la fonction de contre masque dur et présentant un indice de réfraction inférieur à 2,6. La première structure optique **40** est avantageusement déposée en une seule fois, ce qui a également pour avantage d'économiser une étape de fabrication, à savoir celle de la couche de liner **40A**. Optionnellement, il peut tout d'abord être déposé sur la couche sacrificielle une couche formant barrière contre l'hydrogène, par exemple 20nm de *a-Si CVD,* pour les raisons évoquées précédemment.

Dans une troisième variante, prolongeant la première ou la seconde variante, la couche **30**, déposée pour former les parois latérales **18** du boitier, est également réalisée en partie ou totalement en $a\text{-}Si_xC_{(1-x)}$, $0 \leq x < 1$, par exemple du *a-C* ou du $a\text{-}Si_xC_{(1-x)}$ avec $0,05 \leq x \leq 0,5$. Une première structure optique est ainsi obtenue qui inclut partiellement ou totalement la couche **30** du premier mode de réalisation non revendiqué.

Dans les premier et second modes de réalisation non revendiqués, il est ainsi obtenu une première structure optique, constituée de la superposition des couches **40A**, **40B** (ou **40B** seule) d'indice de réfraction équivalent $n_{eq}^1$ typiquement inférieur à 2,6 et préférentiellement de l'ordre de 2 à 2,2. Une épaisseur optique totale typiquement supérieure ou égale à $\lambda_{10}/10$ (soit 1µm pour $\lambda_{10}$=10µm), et préférentiellement voisine de $\lambda_{10}/4$, est ainsi réalisable, et préférentiellement mise en oeuvre.

Les figures 6A, 6B et 6C représentent le spectre de transmittance d'une fenêtre selon la troisième variante du second mode de réalisation non revendiqué, constituée d'une première structure optique préférentielle d'indice de réfraction équivalent $n_{eq}^1 = 2{,}0$ et d'épaisseur optique sensiblement quart d'onde au premier ordre ($p_1$=1) à 10µm, soit ~1,2µm (e.g. une couche liner **40A** de 0,05µm de *a-*$Si_xC_{(1-x)}$ avec x=0,05 et une couche de *a-C* pour les couches **40B** et **30**), d'une seconde structure optique uniforme « haut indice » (*Ge*) puis d'une troisième structure optique « bas indice » adaptée (par exemple ZnS). La Figure 6A correspond au cas particulier où $p_2$=1 soit $e_2$ ~0,6µm, la figure 6B au cas particulier préférentiel où $p_2$=2 soit $e_2$ ~1,2µm, et la figure 6C à un autre cas particulier préférentiel où $p_2$=4 soit $e_2$ ~2,4µm. Il est obtenu dans ces cas préférés des spectres très proches de l'objectif poursuivi, soit au-delà de 93% de 7,3 à 16µm pour $p_2$=2 (fenêtre excellente largement « débordante ») et au-delà de 97% de 8,2 à 13µm pour $p_2$=4 (fenêtre presque parfaite légèrement « inscrite »).

De fait, tous les spectres obtenus avec un empilement de ce type sont nettement avantageux par rapport aux spectres de l'état de la technique (illustrés par exemple aux figures 3A et 3B), et ce quelle que soit l'épaisseur optique de la seconde couche optique haut indice. En effet, le cas $p_2$=1 est déjà de loin préférable au spectre de la figure 3A au vu des critères de qualité privilégiés. Les valeurs $e_2$ inférieures, intermédiaires ou supérieurs aux points préférentiels $p_2$ = 1, 2 et 4 conduisent simplement à atténuer plus ou moins profondément, une ou les deux marges de la bande *LWIR* (et la valeur moyenne sur la bande), sans criticité spécifique. La préférence finale est alors définie par la praticité variable de mise en oeuvre technologique au voisinage des divers points préférentiels indiqués.

On note en particulier que dans la cadre de la troisième variante du deuxième mode de réalisation non revendiqué, la couche **30** étant totalement constituée de *a-*$Si_xC_{(1-x)}$, $0 \leq x < 1$, le réglage des épaisseurs optiques des différentes structures optiques est grandement simplifié et résulte en une très bonne transmittance, comme cela est illustré ci-dessus en relation avec les figures 6A-6D. Dans le cadre des première et seconde variantes et du premier mode de réalisation, la seconde structure optique est constituée de la couche de *a-Si* **30** et de la couche de *Ge* **36**. Cette complexité supplémentaire n'est cependant pas critique pour le réglage des différentes épaisseurs optiques. En effet, en partant des règles de conception de l'état de la technique, à savoir une couche **30** de l'ordre de 0,6µm de *a-Si CVD* au moins pour réaliser les parois **18** et d'au moins 0,6µm de *Ge* pour fermer les évents **22**, il s'ensuit que l'épaisseur géométrique totale de la deuxième couche optique de haut indice (*a-Si* et *Ge*) s'établit au moins vers 1,2µm. L'épaisseur optique $e_2$ de la deuxième structure optique est avantageusement choisie de manière à obtenir un accord quart d'onde d'ordre pair, à savoir $e_2 \sim 2k.\lambda_{10}/4$. Une transmittance de la fenêtre très proche de celle illustrée aux figures 6B et 6C est ainsi obtenue. Divers détails de réalisation sont explicités dans ce sens par la suite. Il est aussi préféré éviter les constructions « très épaisses » ($k$ > 2), qui impliquent que le rapport de l'épaisseur totale des seconde et troisième structures optiques sur l'aire transversale des parois latérales **18** qui les supportent est important, ce qui pourrait poser un problème de tenue mécanique.

Ainsi, on note que pour les premier et second modes de réalisation non revendiqués la fenêtre selon l'invention présente au plus une épaisseur géométrique totale $\lambda_{10}/4n_{eq}^1 + \lambda_{10}/n_{eq}^2 + \lambda_{10}/4n_{eq}^3 \leq \lambda_{10}/2$. Le premier terme et troisième terme correspondent aux première et troisième structures optiques dotées d'un indice voisin de 2 (ou supérieur jusqu'à 2,6), et le second terme représente la seconde structure optique dotée d'un indice supérieur à 3,4 et typiquement compris entre 3,6 et 4,2 et à l'ordre d'accord préféré supérieur ($p_2$ = 4). Au regard de l'épaisseur géométrique faible de la fenêtre, il est obtenu une très bonne tenue mécanique, et il est possible de prévoir des variantes de fabrication ayant des parois latérales plus fines ou de manière générique d'emprise totale plus faible sur la surface d'un pixel, certaines d'entre elles étant par exemple utilisées en tant que pilier de support mécanique, plutôt qu'en tant que parois définissant une cavité hermétique.

Il convient de noter que l'insertion d'une première structure optique d'indice de réfraction équivalent inférieur ou égal à 2,6 à la base d'un empilement de l'état de la technique améliore très efficacement la transmittance moyenne de la fenêtre sur la bande d'intérêt, et ce d'autant mieux bien entendu que l'indice $n_{eq}^1$ se rapproche de la valeur idéale $(n_{eq}^2)^{0,5}$. La figure 6D illustre par exemple la transmittance moyenne de la fenêtre en fonction de l'épaisseur géométrique $e_1$ de la première structure optique ayant un indice de réfraction $n_{eq}^1$ « idéal » de l'ordre de 2. Une amélioration très sensible de l'ordre de 10 points apparaît dans ce cas dès 0,2μm d'épaisseur géométrique (soit une épaisseur optique de ~0,4μm). On notera que même une première structure optique d'indice de réfraction équivalent à 2,6 permet de définir la transmittance illustrée à la figure 6E. Il est obtenu là encore une amélioration substantielle de transmittance moyenne par rapport à la fenêtre de l'état de la technique, grâce à l'augmentation sensible du contraste d'indice $\frac{n_{eq}^2 - n_{eq}^1}{0{,}5 \times (n_{eq}^2 + n_{eq}^1)}$, et ce bien que l'indice $n_{eq}^1$ soit nettement supérieur aux valeurs idéales (proches de 2).

**B. FABRICATION MONOLITHIQUE PAR DEPOTS SUCCESSIFS ET TEXTURATION DE SURFACE DE LA PREMIERE COUCHE OPTIQUE**

TROISIEME MODE DE REALISATION SELON L'INVENTION

Une première variante du troisième mode de réalisation revendiqué consiste à modifier la fenêtre de l'état de la technique comprenant la première structure optique constituée de la couche de *a-Si CVD* **26** déposée sur la couche sacrificielle **24** en vue, notamment, de jouer la fonction de contre-masque dur, et de la couche de *a-Si CVD* **30**, déposée pour la formation des parois latérales **18** du boitier (figure 21 par exemple). Dans cette variante, illustrée sur les schématiques en coupe des figures 7A-7E, le procédé de fabrication monolithique de la fenêtre débute par exemple de manière similaire au procédé de l'état de la technique par le dépôt de la couche de *a-Si CVD* **26** sur la deuxième couche sacrificielle **24** (figure 7A).

A ce stade, la couche **26** et la couche sacrificielle **24** sont texturées par gravure de manière à former des cavités **60** dans la couche sacrificielle **24** selon un réseau bidimensionnel régulier de symétrie d'ordre au moins 2, réparti sur l'essentiel de l'emprise de chaque membrane élémentaire **12** (figure 7B). La gravure est réalisée de manière connue au moyen de procédés dits anisotropes, permettant de réaliser des flancs verticaux ou peu inclinés (entre typiquement 70° et 90°) à la portée de l'homme de l'art. Le pas de répétition, le facteur de remplissage (e.g. la proportion des surfaces gravées à cette étape) et la profondeur (mesurée normalement au plan des couches) du réseau de cavités **60** définissent ceux d'un réseau de motifs tel que décrit ci-après.

Le procédé se poursuit, comme dans l'état de la technique, par la gravure anisotrope de la couche **26** et des couches sacrificielles **22**, **24** jusqu'au substrat **10**, afin de réaliser les vias ou des tranchées **28** dans lesquels sont formées les parois latérales **18** (figure 7B), et par le dépôt de la seconde couche **30** de *a-Si CVD* de manière à au moins recouvrir, voire combler totalement, les vias **28** formant ainsi les parois latérales **18**. Ce deuxième dépôt a également pour effet de remplir au moins partiellement de *a-Si* les cavités **60** (figure 7D). Le procédé se poursuit comme dans l'état de la technique (réalisation d'évents, retrait des couches sacrificielles, dépôt d'une couche de haut indice fermant hermétiquement les évents, et dépôt d'une couche de plus bas indice) pour aboutir à la fenêtre illustrée à la figure 7E. En se référant à la figure 8 de détail, il est ainsi obtenu une première structure optique **64** en *a-Si CVD* dont la face inférieure comprise dans la cavité **34** est texturée par un réseau périodique de motifs bidimensionnels saillants **62,** par exemple des motifs cylindriques (de section circulaire, carrée, etc...), coniques (de révolution, pyramidaux, etc...) ou selon une grille.

Les propriétés du réseau de motifs **62** (pas, facteur de remplissage, épaisseur géométrique ou hauteur des motifs $e_T$ depuis la couche **26**) sont choisies de manière à ce que l'épaisseur $e_T$ constitue la première structure optique selon l'invention pour la bande d'intérêt, et donc se comporte comme une couche de matériau homogène d'indice de réfraction équivalent (ici effectif) inférieur ou égal à 2,6. Plus particulièrement, le réseau de motifs **62** ne fait pas apparaître de phénomène interférentiel de type diffractif dans la bande d'intérêt. Notamment, le pas *p* du réseau est très inférieur à la longueur d'onde considérée, ledit pas est inférieur à $\lambda_{10}/3$, et la hauteur $e_T$ des motifs est typiquement comprise entre $\lambda_{10}/10n_{eq}^1$ et $\lambda_{10}/4$, où $n_{eq}^1$ est l'indice de réfraction équivalent (ici effectif) recherché pour la structure optique d'épaisseur géométrique $e_T$. Par exemple le pas du réseau est inférieur à 3,5 micromètres pour la bande *LWIR,* ou de manière générique inférieur à $\lambda_{10}/3$, et plus typiquement de l'ordre de 1,5 à 2 micromètres, de manière à rester d'une part dans des règles de conception pratiques en termes de lithographie, et d'autre part qui conduisent à un remplissage substantiel des cavités par la couche **30**.

Par exemple, pour des motifs **62** ayant à parois verticales et un indice de réfraction dans la cavité égal à 1, l'indice de réfraction effectif $n_{eff}$ de l'épaisseur $e_T$ est égal au premier ordre à $((ff.n^2 + (1-ff))^{1/2}$, où n est l'indice de réfraction du matériau des motifs **62**, c'est-à-dire celui du *a-Si CVD*, et *ff* le facteur de remplissage (0<*ff*<1) du réseau de motifs **62**, défini par la proportion (*1-ff*) de surface masquée par les motifs (e.g. l'aire occupée par la couche **26**) par rapport à son aire totale.

Selon une deuxième variante, les cavités **60** sont réalisées avant le dépôt de la couche de *a-Si CVD* **26**. La couche sacrificielle **24** subit une texturation de manière à former celles-ci, soit directement sans recours à un contre-masque dur, soit en ayant recours à un contre-masque dur qui est ensuite éliminé aisément après usage, par exemple en aluminium. La profondeur de gravure peut être avantageusement réduite bien en dessous de 1$\mu$m, auquel cas une lithogravure directe est facilement faisable, et de fait plus pratique, en particulier s'il est souhaité obtenir des flancs inclinés (non verticaux). Cette variante permet par exemple avantageusement de protéger l'intégralité de la surface de la couche sacrificielle **24** (hors celle correspondant aux vias **28)** par la couche de *a-Si* **26** pendant l'opération de réalisation des vias **28**. La couche **26** constitue alors une partie du remplissage matériel des cavités **60** formées dans la couche sacrificielle **24**. Elle peut ainsi participer selon son propre indice à l'indice effectif de l'épaisseur $e_T$ dans le cas où les matériaux de la couche **26** et de la couche **30** sont différents.

Ces deux premières variantes présentent divers avantages par rapport aux premier et second modes de réalisation non revendiqués précédemment décrits. Notamment, hormis la réalisation des motifs, il n'est pas nécessaire de modifier la fabrication monolithique de l'état de la technique. Le résultat est ainsi avantageux, non seulement en termes optiques, mais aussi économiques malgré le recours à une étape supplémentaire de litho gravure relativement peu critique.

Il est ainsi obtenu une couche optique $e_T$ dont l'indice $n_{eq}^1$ est ajustable au moyen du facteur *ff* défini par lithogravure directement au voisinage des valeurs les plus efficaces pour l'optimisation de l'empilement complet. Lorsque le remplissage de la structure du réseau est constitué d'une variété de silicium amorphe d'indice élevé (proche du silicium cristallin *c-Si*) de l'ordre de 3,4 à 3,7 typiquement, un facteur *ff* voisin de 0,3 produit un indice effectif proche de 2,1. Ceci améliore très substantiellement la transmittance moyenne de la fenêtre dans la bande *LWIR,* la transmittance étant en effet proche de celle de la figure 6C.

Afin de limiter le risque, par rapport à la technique de référence de contact mécanique induit par le rapprochement des extrémités des motifs **62** et de la membrane **12**, il est avantageux de prévoir une couche sacrificielle **24** plus épaisse, par exemple plus épaisse de l'épaisseur $e_T$ des motifs **62**.

Dans une troisième variante, en particulier avantageuse en cas de gravure directe du réseau sans contre-masque dur ou après élimination d'un masque dur temporaire d'aluminium par exemple, les motifs **62** du réseau sont constitués de deux, ou plus, matériaux différents. Dans une première alternative illustrée à la vue de détail de la figure 8B, la troisième variante diffère de la seconde variante par le dépôt d'une première couche *a-Si CVD* **26** sur la couche sacrificielle texturée **24** qui ne remplit pas totalement les cavités **60**, suivi du dépôt d'une seconde couche **70** de *a-$Si_xC_{(1-x)}$* $0 < x < 1$, et de préférence $x \geq 0,05$. Il est ainsi formé des motifs bicouches **62.** Comme l'indice de réfraction du *a-$Si_xC_{(1-x)}$* est inférieur à celui du *a-Si CVD*, pour un réseau géométriquement identique à celui de la première variante, l'indice de réfraction effectif du réseau est donc inférieur. Il est ainsi possible de déposer une couche relativement épaisse de *a-$Si_xC_{(1-x)}$*, par exemple 0,2$\mu$m à 0,3$\mu$m, pour renforcer la constitution du contre-masque dur de gravure des vias **28**. Comme illustré sur la figure 7E avec les légères dépressions **66** sur la face supérieure de la couche **30**, l'épaisseur géométrique totale des matériaux **26** et **70** déposés sur la couche sacrificielle peut ne pas résulter en une surface plane. Cependant, la planarisation de la texture, c'est-à-dire l'atténuation d'amplitude des dépressions **66**, est complétée au moyen de la couche **30** en *a-Si CVD* destinée dans ce cas essentiellement au comblement des vias **28** pour la formation des parois latérales. Le bilan de matière à haut indice avant dépôt de la couche **36** (typiquement en *Ge*) est ainsi réduit par rapport à la technique de référence, en compensation la couche **36** peut alors être épaissie dans l'objet de sécuriser le scellement des évents.

Dans une quatrième variante, la couche de *a-Si CVD* de la deuxième variante est remplacée par une couche de *a-$Si_xC_{(1-x)}$* $0 < x < 1$, et de préférence $x \geq 0,05$. L'épaisseur géométrique de cette couche est choisie pour obtenir le remplissage complet des cavités **60** de la couche sacrificielle afin d'obtenir un effet substantiel de planarisation, ce qu'autorise notamment l'indice de réfraction du *a-$Si_xC_{(1-x)}$* qui est inférieur à celui du *a-Si CVD.* Notamment, pour obtenir cet effet, l'épaisseur géométrique de la couche de a-*$Si_xC_{(1-x)}$* déposée est supérieure au demi-espace moyen entre les cavités **60** gravées dans la couche sacrificielle **24**. Alternativement, la couche de *a-$Si_xC_{(1-x)}$* est formée après la réalisation des vias **28**, ce qui est réalisable au moins dans le cas où le facteur de forme desdits motifs est compatible avec les caractères spécifiques de conformité structurale du procédé *PECVD* mis en oeuvre à cette étape.

Dans une cinquième variante, le remplissage partiel ou complet des cavités **60** de la couche sacrificielle est obtenu au moyen d'une ou plusieurs couches d'un alliage de type *a-$Si_xGe_{(1-x)}$*, $0 < x < 1$. Dans ce cas, l'indice propre de cette couche (ou chacune de ces couches) est intermédiaire entre au moins 3,4 et 4,2 et plus typiquement entre 3,6 et 4,2 dans la bande *LWIR.* La formation de l'indice effectif visé de la première structure optique, par exemple voisin de 2, est obtenue au moyen du taux de remplissage matériel *ff* du réseau qui sera typiquement plus faible (pour un même résultat $n_{eq}^1$ ) que dans le cadre de la première variante par exemple. Un facteur *ff* de 0,35 sera par exemple préféré avec un matériau allié de remplissage d'indice moyen proche de 3,9, menant ainsi à un indice effectif voisin de 2,4.

Un avantage de cette variante est la facilité de mise en oeuvre de ces alliages par une technique *CVD* qui présente naturellement toutes les caractéristiques technologiques favorables attendues, dont en particulier la capacité à recouvrir ou remplir très efficacement les vias **28**, s'il s'en trouve, et de transparence élevée en *LWIR*. Avantageusement, les couches **26** et **30** en *a-Si CVD* sont donc remplacées par une unique couche de *a-*$Si_xGe_{(1-x)}$. Il peut ainsi être formé directement des première et deuxième structures optiques dont les indices $n_{eq}^1$ et $n_{eq}^2$ sont idéalement adaptés en terme d'indice de réfraction effectif sans compromis technologique pour satisfaire la relation $n_{eq}^1 \approx \sqrt{n_{eq}^2}$, c'est à dire la possibilité de construire des assemblages optiques dont les spectres de transmittance réels (mesurés) sont très proches des spectres théoriques des figures 6B et 6C. En effet, l'incorporation de par exemple 30% (At) de germanium dans l'alliage d'un même matériau de formation des couches **26** et **30** de remplissage du réseau, porte l'indice moyen $n_{eq}^1$ de la seconde structure optique typiquement au-delà de 4 en tout point de son épaisseur. L'ajustement de l'indice $n_{eq}^1$ de la première structure au voisinage de 2 à 2,1 est par ailleurs assuré par une valeur adaptée du facteur de remplissage *ff.* Les couplages interférentiels s'expriment alors idéalement entre les deux premières structures optiques pour optimiser la transmittance intégrée.

Un autre avantage est la possibilité de former ce couple de structures optiques $e_1$ et $e_2$ simultanément optimisées selon les budgets préférentiels particuliers de matière haut indice correspondant à $p_2$ = 2 ou 4, sans recourir à une épaisseur continue plus élevée que celle combinée des couches **26**, **30** et **36** de l'état de la technique, ni à des matériaux de nature éloignée. Le terme « épaisseur continue » désigne ici la distance entre les deux plans parallèles les plus espacés traçables à l'intérieur de l'assemblage formant fenêtre, entre lesquels n'apparaît que de la matière. En effet, une épaisseur continue totale sensiblement plus élevée résulte nécessairement d'une construction préférentielle optimisée selon les premier et second modes de réalisation non revendiqués. Or, les contraintes différentielles intrinsèques ou/et thermiques entre couches de natures sensiblement différentes (*ZnS* évaporé ou alliages *PECVD*) peuvent induire par exemple des complications technologiques additionnelles, particulièrement d'ordre mécanique. Il est donc préférable de mettre en oeuvre une épaisseur continue aussi faible que possible.

Les figures 7 et 8 représentent des motifs de réseau gravés avec une pente régulière, destinée à faciliter le remplissage de la texture et ainsi garantir une structure finale exempte de cavités. Cette conformation préférentielle dans le cas général est aisée à produire par l'homme du métier, en particulier s'il est pratiqué une gravure directe (sans contre-masque dur) de la couche sacrificielle **24**, mais n'est en rien nécessaire, tout particulièrement lorsqu'il est mis en oeuvre des procédés de dépôt par *CVD* d'alliages de type *a-*$Si_xGe_{(1-x)}$. Il est bien entendu que le profil de la texture facilite la formation d'un gradient favorable d'indice progressif entre le sommet des motifs **62** jusqu'au voisinage des couches internes (Ge évaporé) de la fenêtre.

Un avantage complémentaire des diverses variantes de ce troisième mode de réalisation revendiqué est lié à la continuité des indices optiques maitrisables aisément entre celui du carbone et du silicium amorphes, ou entre le silicium et le germanium amorphes, par la mise en oeuvre au moyen des techniques disponibles d'alliages de composition définie selon l'indice particulier préféré. Il est ainsi aisé de déposer une ou des couches physiques d'indices répartis (étagés) ou même à gradient continu selon la position en altitude dans l'épaisseur géométrique d'une même couche formée dans une unique étape technologique de type *PECVD* ou *CVD,* typiquement entre 1,9 et 4,2 pour former les structures transmissives.

Il peut être observé la persistance d'ondulations **66** de faible amplitude représentées sur la figure 7E en surface de la couche **30**. Ces reliefs résultent du recouvrement progressif essentiellement isotrope des cavités réalisées dans la couche sacrificielle **24**. L'atténuation de l'amplitude de ces ondulations avec l'épaisseur géométrique croissante de la couche **30** dans le cas du silicium amorphe ou matériaux apparentés obtenus par *CVD,* et dans une légèrement moindre mesure *PECVD,* est typiquement idéale. Bien entendu, cette amplitude est aussi d'autant plus faible que le pas des structures est petit, à épaisseur géométrique déposée identique. Ces ondulations résiduelles d'interfaces entre couches s'atténuent donc d'elles-mêmes d'une interface à la suivante, et si encore présentes à un niveau donné ne peuvent être que favorables à l'atténuation des réflexions internes partielles à chaque saut d'indice de la structure. Par ailleurs leur pas reste égal au pas *p* du réseau initial de « moulage » de la matière de remplissage, quel que soit l'épaississement global de l'empilement, et par quelque procédé que ce soit.

L'homme de l'art saura déterminer les compromis technologiques les plus avantageux selon ses préférences et contraintes particulières, mais les facilités additionnelles offertes par l'invention conduiront toujours à un gain substantiel de performance du dispositif terminé en termes de transmittance optique, donc de sensibilité du détecteur.

Bien entendu les premier et second modes de réalisation non revendiqués peuvent être combinés avec une texturation telle que décrite précédemment. Notamment, selon des variantes de réalisation décrites en relation avec ces modes de réalisation, une couche d'un alliage amorphe de type *a-*$Si_xC_{(1-x)}$ est choisi avec un taux *x* qui induit un indice de réfraction équivalent de la première structure optique (sans texturation) proche de ou égal à 2,6. La présence de la texturation permet ainsi de baisser davantage l'indice de réfraction équivalent de la première structure optique résultante, et notamment de régler l'indice à une valeur proche de 2.

**C. FABRICATION MONOLITHIQUE DE LA TROISIEME STRUCTURE OPTIQUE**

QUATRIEME MODE DE REALISATION

Dans l'état de la technique, la troisième et dernière structure optique **38** est constituée de *ZnS*. Cette couche a pour objectif de limiter les pertes dioptriques et interférentielles avec le milieu extérieur (air) dans la bande d'intérêt. Or, comme décrit précédemment, cette couche implique des limitations technologiques. Le quatrième mode de réalisation modifie la troisième structure optique, en complément de chacun des modes de réalisation précédents.

Le quatrième mode de réalisation selon l'invention comprend une première structure optique texturée selon le troisième mode de réalisation revendiqué. Le quatrième mode de réalisation combiné avec un premier ou un deuxième mode de réalisation non revendiqué ne fait pas partie de l'invention revendiqué.

Selon une première variante, la troisième structure optique **38** de la fenêtre est formée au moyen d'un alliage amorphe de type $a\text{-}Si_xC_{(1-x)}$ $0 \leq x \leq 1$ en lieu et place du *ZnS*. Avantageusement, en particulier si un tel matériau $a\text{-}Si_xC_{(1-x)}$ est déjà mis en oeuvre pour la formation partielle de la première couche, c'est à dire si les équipements et procédés nécessaires sont disponibles, il est tout indiqué de recourir à un alliage amorphe (ou une série étagée ou continue d'alliages) de même type $a\text{-}Si_xC_{(1-x)}$ quoique non nécessairement identique, pour former la troisième structure. En effet, s'il est considéré utile de moduler le profil d'indice vertical pour optimiser dans le détail la transmittance de la fenêtre, le profil d'indice recherché est facilement distribué au moyen de la maîtrise des paramètres de procédé de dépôt entre les bornes indicatives 1,9 et 2,6 dans la bande *LWIR*.

Typiquement les valeurs plus élevées d'indice de réfraction sont préférentiellement formées à la base de la troisième structure optique, au contact de la couche **36** en *Ge*, avec un taux de silicium relativement élevé, voire 100% (x=0), et un indice plus bas sera visé pour terminer la couche optique **38**, à l'extrême formée en surface externe uniquement de carbone amorphe ($x$=1). Naturellement, quoique pas nécessairement, l'épaisseur optique de la troisième structure optique **38** est préférentiellement ajustée au point optimal de formation d'interférences favorables sur le spectre global de transmittance de la structure, par exemple et typiquement autour de $\lambda_{10}/4$ ($p_3$=1), et préférentiellement encore selon un indice voisin de $\sqrt{n_{eq}^2}$ soit idéalement au voisinage de 2,1 si la seconde structure optique est essentiellement constituée de germanium.

Cette option permet avantageusement de former la partie superficielle de la capsule d'une matière connue pour être particulièrement dure et typiquement résistante à l'abrasion. Ce trait est avantageux en termes de vulnérabilité réduite aux divers procédés de nettoyage, ou contacts et frottements divers délibérés ou accidentels pouvant survenir en fin de fabrication ou intégration dans le système final, voire pendant l'exploitation du détecteur.

Selon une deuxième variante, la surface externe de la fenêtre est texturée selon un réseau bidimensionnel de manière à former la troisième structure optique. Une telle configuration est représentée sur la vue de détail de la figure 9A. Diverses possibilités et avantages sont maintenant proposés pour réaliser cette troisième structure.

En premier lieu, l'option la plus simple est de ne pas prévoir de couche externe de *ZnS* et de texturer directement la surface du germanium de la couche **36** de l'état de la technique, selon un taux *ff* de remplissage et une profondeur $e_3$ pour former la couche **38** antireflet supérieur. Préférentiellement, il sera visé un indice $n_{eq}^3$ voisin de 2 - 2,1 associé à une profondeur (épaisseur géométrique $e_3$) voisine de 1,2μm. Bien entendu, il convient de porter l'épaisseur géométrique initiale de la couche **36** telle que déposée, ou post-épaissie au moyen d'un procédé *CVD* complémentaire produisant un matériau d'indice élevé, à la valeur adéquate utile au meilleur résultat. Un intérêt additionnel d'un dépôt par *CVD* à cette étape est le complément structural avantageux d'obturation des évents **32** par la couche **36** évaporée.

Un avantage particulier spécifique à la formation de la troisième couche optique au moyen d'une structuration du ou des matériau(x) haut indice constitutif(s) de la seconde structure optique mérite mention. Il s'agit de la possibilité, sans contrainte de budget technologique de matière haut indice, de construction en final d'un empilement préférentiel dont la seconde structure optique est accordée quart d'onde au premier ordre ($p_2$=1). Un spectre de transmittance relativement étroit inscrit dans la bande *LWIR* et positionnable autour d'une valeur centrale $\lambda_{10}$ selon besoin, au moyen de l'accord général $\lambda_{10}/4n_i$ pour les épaisseurs géométriques (ou de manière équivalente $\lambda_{10}/4$ pour les épaisseurs optiques), comparable à celui de la figure 3A, ou très transmissif sur une bande plus large ajustable entre les spectres 3A et 3B est ainsi aisément réalisable, si jugé préférentiel. Pour l'obtenir, il sera d'abord formé une couche **36** évaporée, éventuellement post-épaissie avec un matériau haut indice *CVD* à une épaisseur géométrique adaptée à la gravure ultérieure d'un réseau antireflet d'indice $n_{eq}^3$ tel que préféré, et simultanément accordé lui-même au premier ordre

($p_3$=1), et qui laisse après gravure une épaisseur optique intacte (continue) haut indice au voisinage de $\lambda_{10}$/4. En d'autres termes, il est gagné 1,2μm de marge (pour $\lambda_{10}$ = 10μm) sur le budget de matière haut indice (pour $n_{eq}^2 \sim 4{,}2$ ). Par exemple, il est déposé au total une épaisseur géométrique haut indice de 1,8μm, dans laquelle est gravé un antireflet supérieur ($e_3$=1,2μm) posé sur une couche $e_2$ résiduelle après gravure de ~0,6μm.

Une troisième variante combine les première et deuxième variantes, un réseau texturé étant formé par gravure à travers un empilement d'une ou plusieurs couches d'alliages de type $a\text{-}Si_xC_{(1-x)}$ ou de type $a\text{-}Si_xGe_{(1-x)}$. Un exemple est représenté à la vue de détail en coupe de la figure 9B. Cette variante propose trois degrés de liberté en termes de taux de remplissage *ff*, de profil de gravure ou pente des motifs du réseau, et de distribution des indices dans les couches matérielles superposées mises en oeuvre, pour former dans tout le détail utile le profil d'indice que l'homme de l'art saura définir et mettre en oeuvre sans difficulté particulière. Dans le présent contexte cette définition visera bien entendu à optimiser la transmittance spectrale dans la bande d'intérêt, sans qu'il soit besoin de détailler davantage.

De manière avantageuse, l'empilement texturé **38** des variantes précédentes, est recouvert par une couche **72** déposé selon un dépôt conforme (et donc recouvrante) de bas indice, par exemple une couche de $a\text{-}Si_xC_{(1-x)}$ avec préférentiellement une proportion *x* de silicium supérieure ou égale à 5%. L'intérêt d'une telle couche d'enrobage final ou de « passivation», par exemple d'une épaisseur géométrique entre 0,1μm et 0,5μm, est d'une part de protéger la ou les couches précédentes, même sur leurs tranches, contre l'agression des plasmas oxygénés comme déjà discuté, dans la mesure où ces procédés sont en général utiles à mettre en oeuvre à des fins de nettoyage ou de retrait des masques lithographiques, en plus de leur intérêt pour l'élimination des couches sacrificielles. D'autre part, cette option particulière procure comme il a été dit une surface totalement constituée de matière très dure et résistante à l'abrasion, avec les avantages attachés déjà précisés.

Bien qu'il ne soit pas exclu de former un nombre quelconque de couches entre la première structure optique et une dernière structure optique de numéral quelconque pour optimiser encore la transmittance moyenne, le fait de disposer d'une transmittance moyenne sur la bande d'intérêt au-delà de 95%, et essentiellement dépourvue de sélectivité spectrale (sans bande(s) sensiblement moins transmissive(s)) dès la disposition de trois structures optiques, conduit à caractériser les modes préférentiels par cette limite générale. Compte tenu des propriétés des matériaux utilisables mis en oeuvre, cette limite implique de fait une épaisseur géométrique totale inférieure à $\lambda_{10}$/2. On ne considère pas ici les pertes liées à l'absorption en général non nulle des diverses couches mises en oeuvre, qui ne pourraient qu'exacerber les difficultés d'optimisation en cas d'empilements plus épais, en sus de diverses difficultés structurales d'ordre thermomécanique. Ce maximum spécifique quoique seulement indicatif borne par excès un empilement de trois structures optiques, formées des matériaux et techniques proposés, chacune accordée à l'ordre préférentiel maximal ($p_1$=1, $p_2$=4, $p_3$=1).

Selon tous les modes de réalisation de l'invention et toutes leurs variantes, la surface interne du capot supérieur et des parois latérales sont inertes au procédé de gravure prédéterminé. Selon ledit procédé, oxydant sous plasma oxygéné pour la gravure des couches sacrificielle organiques, ou procédé apparenté (par exemple à base d'ozone $O_3$) mis ordinairement en oeuvre pour le retrait sec des résines lithographiques, ou acide *HFv* pour la gravure des couches minérales de type *SiO* ou apparentées, la construction peut parfois être simplifiée comme il a été suggéré lors du développement.

## D. OPTIMISATION DE L'ABSORBANCE DES MEMBRANES SENSIBLES AU MOYEN DES CAPSULES

### CINQUIEME MODE DE REALISATION

Le cinquième mode de réalisation selon l'invention comprends une première structure optique texturée selon le troisième mode de réalisation revendiqué. Le cinquième mode de réalisation combiné avec un premier ou un deuxième mode de réalisation non revendiqué ne fait pas partie de l'invention revendiqué.

Les modes de réalisation décrits ci-dessus s'attachent essentiellement à optimiser la transmittance de la fenêtre en termes, notamment, de valeur moyenne dans la bande d'intérêt et de variations minimales, indépendamment des membranes sensibles et du substrat. Toutefois, par construction, la distance entre la face inférieure de la fenêtre et la membrane bolométrique est préférentiellement supérieure à 1μm, pour éviter un contact entre la fenêtre et la membrane après le retrait des couches sacrificielles et éviter les effets électrostatiques et de « stiction », et inférieure à 3μm en raison des contraintes de fabrication des appuis sur le substrat (vias / rainures intermédiaires). D'autre part, l'épaisseur de la membrane sensible est délibérément choisie très faible de manière à limiter la masse totale suspendue, et un réflecteur métallique est formé sur la face supérieure du substrat. Il apparait ainsi un ventre d'interférences stationnaires constructives au niveau de la membrane entre l'onde incidente et l'onde transmise puis réfléchie sur le réflecteur métallique lorsque la membrane est placée à une distance égale à $\lambda_{10}/(4.n)$, soit 2,5μm de vide (*n*=1) au-dessus du réflecteur pour une longueur d'onde de travail centrale de 10μm. Dans le contexte proposé, l'absorbeur disposé dans la membrane est constitué de manière classique par une couche métallique dont la résistance de couche *Rs* est de l'ordre de 380 Ohm/carré en présence d'un réflecteur sur le substrat. Une telle architecture permet une absorbance élevée du rayonnement par la membrane, avec un maximum large dans la bande d'intérêt. Dans le cadre du cinquième mode, on considère une membrane constituée d'une couche de nitrure de titane (*TiN*) d'épaisseur géométrique 8nm, de résistance de couche de 380 Ohm/carré et d'indices optiques *n*=10,5 et *k*=16 (*k* étant le coefficient d'extinction), à 10μm de longueur d'onde, sur laquelle est disposée une couche de *Si* amorphe d'épaisseur géométrique 200nm et d'indices *n*=3,42 et *k*=0 à 10μm. D'autres épaisseurs et dispositions de matériaux sont bien entendu possibles, mais au moins à l'intérieur de 30% de variation de ces paramètres il n'y a pas d'incidence au premier ordre sur les configurations géométriques préférentielles résultantes.

Or, les inventeurs ont noté que la capsule et l'ensemble membrane/réflecteur sont tous deux des résonateurs optiques à faible facteur de qualité qui interagissent optiquement en raison de la faible distance qui les sépare, rapportée à la longueur d'onde de travail, ce qui impacte l'absorbance de la membrane. Plus particulièrement, la position en altitude des franges d'interférence constructives n'est pas uniquement réglée par la distance séparant la membrane du réflecteur, comme lorsque la membrane est face à un demi-espace libre, mais également de la distance séparant la membrane de la fenêtre, et de l'indice de réfraction de la première structure optique. Le cinquième mode de réalisation consiste donc à optimiser le placement de la membrane semi-absorbante vis-à-vis des interférences constructives dans la cavité, en choisissant de manière concomitante l'épaisseur et l'indice de réfraction de la première structure optique de la fenêtre, la distance entre la membrane et le réflecteur, et la distance entre la membrane et la face inférieure de la fenêtre. De cette manière, les inventeurs ont constaté que l'absorbance de la membrane peut être sensiblement augmentée lorsque la fenêtre est construite selon l'un quelconque des modes proposés. Toutefois, il est aussi constaté que le réglage optimal de la première structure optique de la fenêtre mérite ajustement dans le contexte de maximisation d'absorbance de la membrane telle que définie.

La figure 10 illustre ce phénomène, la courbe **A** est le spectre de l'absorbance d'une membrane sensible telle que décrite ci-dessus placée dans le vide à $\lambda_{10}/(4.n)$ = 2,7μm ($\lambda_{10}$ = 11μm) au-dessus d'un réflecteur métallique et en absence de fenêtre, la courbe **B** est le spectre d'absorbance de cette même membrane placée à une distance de 1,5μm d'une fenêtre constituée d'un tri-couche *a-Si* (0,8μm) + *Ge* (1,7μm) + *ZnS* (1,2μm) usuel de l'état de la technique réglé sur $\lambda_{10}$ = 11μm, et la courbe **C** est le spectre d'absorbance de cette même membrane placée sous une fenêtre selon le cinquième mode de réalisation tel que décrit ci-dessous, notamment à une distance du réflecteur métallique inférieure à $\lambda_{10}/4$. La courbe **A** représente donc le cas « idéal » où il n'y a pas de fenêtre, donc pas de perturbation du simple effet Fabry-Perot (quart d'onde) induit par la présence du réflecteur métallique. La courbe **B** illustre quant à elle cette perturbation, la valeur moyenne de l'absorbance de la membrane sur la gamme [8 ; 14μm] chute à 73% : selon l'état de l'art, l'absorbance de la membrane est de fait nettement dégradée par la proximité de la capsule. La courbe **C** montre qu'il est possible d'obtenir une absorbance nettement plus élevée en présence de la fenêtre, par rapport au cas de l'état de l'art, quoique légèrement dégradé par rapport au cas sans fenêtre (courbe B), en ajustant conjointement l'indice de réfraction et l'épaisseur optique de la première structure optique de la fenêtre, l'absorbance moyenne dans la gamme [8 ; 14μm] étant égale dans ce cas à 93%, sans modifier dans un premier temps la distance entre la membrane et le réflecteur (2,7μm) et la distance entre la membrane et la fenêtre (1,5μm).

Un procédé de fabrication d'un détecteur avec un placement optimisé d'une membrane sensible telle que décrite dans un boitier hermétique sous vide consiste à :

a. déterminer les deuxième et troisième structures optiques de la fenêtre, par exemple un bicouche *Ge* + anti-reflet *ZnS* de l'état de la technique ou tel que décrit dans les modes de réalisation décrits précédemment ;

b. déterminer la variation de l'absorbance de la membrane en fonction de l'épaisseur optique et l'indice de réfraction de la première structure optique de la fenêtre et des distances entre la membrane et le réflecteur métallique et la première structure optique de la fenêtre. Cette détermination peut être réalisée par exemple par simulation numérique à l'aide de logiciels tels que « DiffractMOD™ » de la société Synopsis, Inc. (www.rsoftdesign.com) ou du « VirtualLab™ » de la société Light Trans Gmbh. (www.lighttrans.com), notamment le module « Grating Toolbox » concernant une première structure optique texturée ;

c. déterminer des gammes de valeurs pour l'indice et/ou les distances tenant compte de contraintes de fabrication ou de fonctionnement, par exemple une distance minimale entre la membrane et la fenêtre, une période et un facteur de remplissage concernant une première structure optique texturée (s'il y est fait recours) compatible avec une technique de fabrication monolithique, etc. ;

d. choisir dans les gammes déterminées, le quadruplet (épaisseur géométrique, indice de réfraction ou caractères du réseau structuré (période *p*, facteur *ff* couplé à l'indice *n* du matériau de remplissage), distance au réflecteur, distance à la première structure optique de la fenêtre) induisant une absorbance moyenne de la membrane dans la gamme [8-14μm] supérieure à l'absorbance de l'état de la technique, notamment une absorbance supérieure à 90%, avantageusement supérieure à 95% ;

e. fabriquer le détecteur présentant les valeurs sélectionnées.

La fabrication de la membrane et de la fenêtre diffère des modes de réalisation précédents par des précisions sur l'épaisseur préférentielle des couches sacrificielles **22** et **24** qui permettent de régler les distances entre la membrane sensible **12** et d'une part le réflecteur formé sur le substrat **10** et d'autre part la fenêtre **20**, et par des précisions en termes d'indice effectif de la première structure optique ou des caractères du réseau, s'il y est fait recours pour la construire.

Dans une première variante, la première structure optique est constituée de *a-Si CVD* texturée de manière analogue au troisième mode de réalisation décrit précédemment, le facteur de remplissage *ff* des motifs en *a-Si CVD* et leur profondeur $e_T$ permettant de régler respectivement l'indice de réfraction équivalent (effectif) et l'épaisseur optique de la première structure optique. La fabrication consiste alors par exemple pour une détection dans la gamme [8 ; 14µm] à choisir :

- la période *p* du réseau de motifs inférieure ou égale à $\lambda_{10}$/3 (e.g. 3,5µm pour $\lambda_{10}$ = 11µm) pour éviter les pertes par diffraction dans la bande d'intérêt, préférentiellement supérieure ou égale à 1,5µm pour ne pas contraindre inutilement la réalisation des motifs, et de préférence inférieure ou égale à 3µm pour obtenir une absorption optimale (>95%) sur la bande [8 ; 14µm]. La texturation est de préférence réalisée selon une symétrie dans le plan horizontal élevée au moins d'ordre deux, pour assurer un fonctionnement insensible à la polarisation de la lumière, la forme des motifs élémentaires important peu (carrés, disques, hexagones...). La texturation finale (après complétion du processus) est par exemple une grille en *a-Si CVD* ou un réseau de plots en *a-Si CVD* ;
- la distance *hP* fenêtre/membrane entre 1µm et 3µm pour des raisons mécaniques (e.g. supérieure ou égale à 1µm pour éviter le contact entre la fenêtre et la membrane et inférieure ou égale à 3µm pour faciliter la réalisation des supports mécaniques de la fenêtre) ;
- la distance *hR* membrane/réflecteur, la profondeur $e_T$ de gravure du réseau (de fait équivalente dans cette configuration à l'épaisseur géométrique $e_1$ de la première structure optique) et le facteur de remplissage *ff* en *a-Si CVD* du réseau en fonction de la distance *hP* choisie au moyen des abaques tels qu'illustrés aux figures 11A-11F pour obtenir une absorption moyenne dans la gamme [8 ; 14µm] supérieure ou égale à 95%. En particulier, pour un réseau de motifs carrés d'arête *a* en *a-Si CVD*, $ff = (a/p)^2$, tandis que pour une grille en *a-Si* percée de trous carrés d'arête a, $ff = 1 - (a/p)^2$.

En particulier, pour obtenir une absorption supérieure à 95%, les paramètres du tableau suivant sont mis en oeuvre pour un réseau de plots ou en forme de grille, les lignes numérotés 1, 2 et 3 correspondant respectivement aux gammes numérotées 1, 2 et 3 des figures 11A à 11C :

| | | | | plots | grilles |
|---|---|---|---|---|---|
| 1 | 1,0µm < *hP* < 1,5µm | 1,8µm < *hR* < 2,3µm | 1,8µm < $e_T$ < 2,1µm | 40% < *ff* < 65% | 15% < *ff* < 35% |
| 2 | 1,5µm < *hP* < 2,0µm | 1,6µm < *hR* < 2,0µm | 1,8µm < $e_T$ < 2,1µm | 30% < *ff* < 50% | 10% < ff < 25% |
| 3 | 2,0gm < *hP* < 3,0µm | 1,4µm < *hR* < 1,8µm | 1,5µm < $e_T$ < 2,1µm | 25% < *ff* < 40% | 5% < *ff* < 20% |

Les gammes de facteurs de remplissage *ff* du réseau présentées au tableau ci-dessus pour un réseau de plots ou en grille en silicium amorphe *CVD* correspondent respectivement aux gammes d'indices de réfraction effectifs 1,45-1,80, 1,35-1,60, 1,30-1,50.

Pour obtenir une absorption supérieure à 95%, les paramètres du tableau suivant sont mis en oeuvre pour une première couche optique non structurée, les lignes numérotés 1, 2 et 3 correspondant respectivement aux gammes numérotés 1, 2 et 3 des figures 11D à 11F et $e_1$ étant l'épaisseur géométrique de la première couche optique et $n_{eq}^1$ étant l'indice de réfraction équivalent de celle-ci :

| | | | | |
|---|---|---|---|---|
| 1 | 1,0µm < *hP* < 1,5µm | 1,8µm < *hR* < 2,3µm | 1,8µm < $e_1$ < 2,1µm | $1,45 < n_{eq}^1 < 1,80$ |
| 2 | 1,5µm < *hP* < 2,0µm | 1,6µm < *hR* < 2,0µm | 1,8µm < $e_1$ < 2,1µm | $1,35 < n_{eq}^1 < 1,60$ |
| 3 | 2,0µm < *hP* < 3,0µm | 1,5µm < *hR* < 2,1µm | 1,5µm < $e_1$ < 2,1µm | $1,30 < n_{eq}^1 < 1,50$ |

On note en particulier sur l'abaque de la figure 11A, que la distance *hR* entre la membrane et le réflecteur métallique du substrat est très inférieure à $\lambda_{10}/4$ = 0,25.$\lambda_{10}$, puisqu'elle est au maximum égale à 2,25 μm alors que 0,25.$\lambda_{10}$ = 2,7μm pour $\lambda_{10}$ = 11μm. Notamment, pour *hP* = 1,5μm qui est une distance usuelle de l'état de la technique, la distance *hR* entre la membrane et le réflecteur métallique est égale à 1,9μm.

La figure 12A illustre l'absorption dans la membrane en fonction de la longueur d'onde, pour différentes valeurs du couple *hR*/*hP*, pour la configuration de l'état de la technique (fenêtre tri-couche *a-Si CVD* + *Ge* + *ZnS*). L'optimisation sans contraintes sur *hP* et *hR* conduit aux valeurs *hR* = 3,4μm et *hP* = 0,7μm (courbe **A**), avec une absorption intégrée sur [8 ; 14μm] de 89%. Lorsque l'on contraint *hP* à des valeurs de plus en plus élevées (0,9, 1,2, 1,5 et 2,0μm) pour tenir compte de la précaution d'éloignement entre la membrane et la fenêtre, la valeur optimale de *hR* diminue ainsi que l'absorption moyenne. Le cas *hP* = 1,5μm / *hR* = 2,7μm = 0,25.$\lambda_{10}$ correspond à la configuration de l'état de la technique (absorption moyenne = 73%, courbe **B**). On constate donc que dans cette configuration, l'absorption dans la membrane est pénalisée non seulement par l'absence d'antireflet inférieur (i.e. un indice de réfraction équivalent de la première structure optique adapté au vide du boitier), mais aussi par la contrainte d'éloignement de la fenêtre par rapport à la membrane.

La figure 12B illustre des réponses spectrales optimisées en absorbance avec une première structure optique texturée sur la face inférieure de la fenêtre selon une grille en *a-Si.* La période *p* du réseau est fixée à 2μm. Les valeurs optimales des paramètres *hR*, *hP*, $e_T$ et *ff* déterminées sans contraintes sont respectivement égales à 2,3μm, 1,2μm, 1,5μm et 34%. Le rapport d'aspect du réseau, (défini par le paramètre $e_T/(p-a)$, c'est-à-dire le rapport profondeur / plus petite dimension latérale des motifs) est de 4. L'absorption optimale correspondante est de 97% sur la plage [8 ; 14μm]. La valeur optimale de *hP* (1,2μm) est dans la plage des valeurs acceptables pour éviter le contact mécanique, au contraire de la configuration dépourvue de première structure optique. L'absorption avec les paramètres accessibles en pratique est améliorée pour deux raisons : l'introduction de l'antireflet interne sous forme d'une première structure optique d'indice adapté, et le fait que la distance optimale fenêtre/membrane (*hP*) est plus élevée, tout en restant dans la gamme de valeurs technologiquement pratiques.

Il est possible d'augmenter encore la distance *hP* en conservant une absorption très élevée, avec une diminution simultanée de la distance *hR,* et une augmentation du rapport d'aspect du réseau (figure 12B). Augmenter la distance *hP* sans réajustement de *hR* et des paramètres du réseau conduit à une absorption intégrée moins favorable (figure 12C). Le dimensionnement concomitant des deux couches sacrificielles **22** et **24** est indispensable pour optimiser l'absorption.

Il est à noter que l'absorption dans la membrane peut être légèrement supérieure à la configuration dite « idéale » c'est-à-dire sans capsule-fenêtre, ou avec une fenêtre épaisse supposée parfaitement transparente, très éloignée et traitée avec un antireflet supposé parfait sur ses deux faces ; indiquée « sans PLP » dans les figures). Cette observation s'explique par le fait que les interférences plus complexes de l'empilement complet du dispositif encapsulé peuvent s'exprimer favorablement en maintenant la membrane dans un lobe de forte amplitude dans la zone en dessous de 10μm, où la membrane seule est bien en-dessous de 100% d'absorption comme indiqué en figure 10A.

Pour faciliter la réalisation technologique du réseau, il peut être préféré de réduire la profondeur de gravure $e_T$ de façon à réduire le rapport d'aspect et faciliter le remplissage conforme des dépressions lors du dépôt du ou des matériaux de remplissage, en particulier s'il est recouru à un procédé de type *PECVD.* Il s'avère que l'optimisation de l'absorption, à profondeur de gravure limitée, conduit à un facteur de remplissage également plus favorable, vers des valeurs plus proches de 50%. Le rapport d'aspect s'en trouve d'autant modifié dans le sens favorable. L'absorption moyenne est quelque peu dégradée par rapport au cas où la profondeur de gravure n'est pas limitée, mais reste nettement supérieure au cas de la capsule de référence sans antireflet interne. Pour une profondeur de gravure $e_T$ limitée à 1μm en borne supérieure (et *hP* limité à 1,2μm en borne inférieure), la largeur optimale des plots gravés dans la couche sacrificielle est de 1,4μm, ce qui donne un facteur de remplissage de 50% et un rapport d'aspect des gravures de 1,6. L'absorption moyenne sur la gamme [8 ; 14μm] est alors de 92%, soit une valeur encore très supérieure aux 73% de l'état de la technique. La distance *hR* optimale est de 2,5μm, un peu plus élevée que pour la gravure à 1,5μm de profondeur, mais similaire au standard du domaine des microbolomètres, ce qui constitue un avantage supplémentaire de cette variante.

Pour une profondeur de gravure $e_T$ limitée à 0,5μm en borne supérieure (et *hP* limité à 1,2μm en borne inférieure), les paramètres optimaux sont *ff* = 67%, *hR* = 2,8μm, mais l'absorption moyenne de 84%, se place encore plus de 10 points au-dessus de la référence.

Dans une seconde variante, la première structure optique est non texturée. La fabrication consiste alors par exemple pour une détection dans la gamme [8 ; 14μm] à choisir :

- la distance *hP* fenêtre/membrane entre 1μm et 3μm pour les raisons mécaniques déjà exposées ;
- la distance *hR* membrane/réflecteur, l'épaisseur géométrique $e_1$ de la première structure optique et l'indice équivalent $n_{eq}^1$ de cette première structure optique en fonction de la distance *hP* choisie au moyen des abaques tels qu'illustrés aux figures 11A-F pour obtenir une absorption moyenne dans la gamme [8 ; 14μm] supérieure ou égale à 95%.

## Revendications

**1.** Procédé de fabrication d'un détecteur apte à détecter une gamme de longueurs d'onde [$\lambda_8$ ; $\lambda_{14}$] centrée sur une longueur d'onde $\lambda_{10}$, le détecteur comprenant un dispositif de détection apte à détecter ladite gamme [$\lambda_8$ ; $\lambda_{14}$] et un boitier hermétique sous une pression prédéterminée dans laquelle est logé ledit dispositif, ledit boitier étant formé d'un substrat, de parois latérales solidaires du substrat et d'un capot supérieur solidaire des parois latérales et comprenant une partie au droit du dispositif qui est transparente dans ladite gamme [$\lambda_8$ ; $\lambda_{14}$], le procédé comprenant :

- la réalisation dudit dispositif sur le substrat, ladite réalisation comprenant le dépôt d'une couche sacrificielle noyant totalement ledit dispositif ;
- la réalisation du capot sur la couche sacrificielle, ledit capot étant constitué d'un empilement de première, seconde et troisième structures optiques transparentes dans ladite gamme [$\lambda_8$ ; $\lambda_{14}$], la seconde et la troisième structures optiques ayant des indices de réfraction équivalents à la longueur d'onde $\lambda_{10}$ respectivement supérieur ou égal à 3,4 et inférieur ou égal à 2,3 ;
- suite à la réalisation d'une partie du capot comprenant au moins la première structure optique, la réalisation d'un évent d'accès à la couche sacrificielle au travers de ladite partie du capot, suivie de l'application, au travers de l'évent, d'une gravure pour retirer en totalité la couche sacrificielle, dans lequel :

  - l'épaisseur optique de la première structure optique est supérieure ou égale à $\lambda_{10}/10$ ;
  - l'indice de réfraction équivalent $n_{eq}^1$ à la longueur d'onde $\lambda_{10}$ de la première structure optique est inférieur ou égal à 2,6 ; et
  - la face de la première structure optique formée sur la couche sacrificielle, est inerte à la gravure mise en oeuvre pour retirer la couche sacrificielle ;

***et*** dans lequel la réalisation de la première structure optique comporte en outre la formation d'un réseau périodique de dépressions dans la couche sacrificielle, le pas ou la période du réseau périodique étant inférieur à $\frac{\lambda_{10}}{3}$, la réalisation de la première structure optique conduisant au remplissage au moins partiel des dépressions dudit réseau.

**2.** Procédé de fabrication d'un détecteur selon la revendication 1, dans lequel :

- la gravure est une gravure isotrope prédéterminée à base de vapeur acide fluorhydrique (*HFv*) ;
- et le matériau inerte à la gravure isotrope prédéterminée est du silicium amorphe (*a-Si*) ou du carbone amorphe (a-*C*) ou un alliage amorphe de carbone (C) et de silicium (Si) de type $a\text{-}Si_xC_{(1-x)}$, ou un alliage amorphe de silicium (Si) et de Germanium (Ge) de type $a\text{-}Si_xGe_{(1-x)}$, où $0 < x < 1$.

**3.** Procédé de fabrication d'un détecteur selon la revendication 1, dans lequel:

- la gravure est une gravure isotrope prédéterminé sèche oxydante ;
- et le matériau inerte à la gravure isotrope prédéterminée est du silicium amorphe (*a-Si*) ou un alliage amorphe de carbone (C) et de silicium (Si) de type $a\text{-}Si_xC_{(1-x)}$, où $0{,}05 \leq x < 1$, ou un alliage amorphe de silicium (Si) et de Germanium (Ge) de type $a\text{-}Si_xGe_{(1-x)}$, où $0 \leq x < 1$ .

**4.** Procédé de fabrication d'un détecteur selon l'une quelconque des revendications précédentes, dans lequel la première structure optique a une épaisseur optique $e_1$ vérifiant la relation :

$$e_1 = \frac{\lambda_{10}}{4}$$

**5.** Procédé de fabrication d'un détecteur selon l'une quelconque des revendications précédentes, dans lequel la deuxième structure optique est constituée entièrement de germanium (*Ge*) ou d'un empilement d'une couche de silicium amorphe (*a-Si*) et d'une couche de germanium (*Ge*).

**6.** Procédé de fabrication d'un détecteur selon l'une quelconque des revendications précédentes, dans lequel la deuxième structure optique a une épaisseur optique $e_2$ vérifiant la relation :

$$e_2 = p_2 \times \frac{\lambda_{10}}{4}$$

expression dans laquelle $p_2$ = 1, 2 ou 4.

**7.** Procédé de fabrication d'un détecteur selon l'une quelconque des revendications précédentes, dans lequel la troisième structure optique est constituée entièrement de sulfure de zinc.

**8.** Procédé de fabrication d'un détecteur selon l'une quelconque des revendications 1 à 6, dans lequel la troisième structure optique est constituée entièrement d'un alliage amorphe de carbone (*C*) et de silicium (*Si*) de type $a\text{-}Si_xC_{(1-x)}$, où $0 < x < 1$, notamment $x \leq 0{,}4$.

**9.** Procédé de fabrication d'un détecteur selon l'une quelconque des revendications précédentes, dans lequel la troisième structure optique a une épaisseur optique $e_3$ vérifiant la relation :

$$e_3 = \frac{\lambda_{10}}{4}$$

**10.** Procédé de fabrication d'un détecteur selon l'une quelconque des revendications précédentes, dans lequel l'épaisseur géométrique totale des première, seconde et troisième structures optique est inférieure ou égale à $\frac{\lambda_{10}}{2}$.

**11.** Procédé de fabrication d'un détecteur selon l'une quelconque des revendications précédentes, dans lequel le dispositif de détection comprend au moins une membrane bolométrique apte à absorber une partie du rayonnement dans ladite gamme [$\lambda_8$ ; $\lambda_{14}$] et suspendue au-dessus d'un réflecteur métallique, le procédé comportant :

- la détermination des variations de l'absorbance de ladite membrane en fonction de ladite structure optique de ladite fenêtre ;
- la détermination de gammes de valeurs pour l'indice de réfraction équivalent $n_{eq}^1$ de la première structure optique de la fenêtre, la distance entre la membrane bolométrique et le réflecteur métallique et/ou la distance entre la membrane bolométrique et la fenêtre ; et
- la sélection, dans lesdites gammes déterminées, d'un quadruplet induisant une absorbance moyenne supérieure à 90% de ladite membrane dans ladite gamme [$\lambda_8$ ; $\lambda_{14}$];
- ledit quadruplet comportant au moins l'épaisseur géométrique, l'indice de réfraction équivalent $n_{eq}^1$ de la première structure optique de la fenêtre, la distance entre la membrane bolométrique et le réflecteur métallique et la distance entre la membrane bolométrique et la fenêtre.

**12.** Procédé de fabrication d'un détecteur selon la revendication 11, dans lequel la réalisation de la première structure optique comporte la formation du réseau périodique de motifs dans sa face au contact de la couche sacrificielle, et l'épaisseur du réseau, le facteur de remplissage et la période du réseau, la distance entre la membrane et le réflecteur métallique et la distance entre la membrane et le capot sont choisies de manière à régler l'absorption moyenne de la membrane dans ladite gamme [$\lambda_8$ ; $\lambda_{14}$] sur une valeur supérieure à 90%.

**13.** Procédé de fabrication d'un détecteur selon la revendication 12, dans lequel les motifs du réseau forment des plots ou une grille en silicium amorphe (*a-Si*), l'indice de réfraction du silicium amorphe (*a-Si*) étant compris entre $0{,}9 \times 3{,}4$ et $1{,}1 \times 3{,}4$, la période du réseau étant comprise entre 1 et 3 micromètres, et en ce que :

- la distance *hP* entre la membrane et le capot est comprise entre 1 micromètre et 1,5 micromètre ;
- la distance *hR* entre la membrane et le réflecteur est comprise entre 1,8 micromètre et 2,3 micromètres ;

- la profondeur $e_T$ des plots du réseau est comprise entre 1,8 micromètre et 2,1 micromètres ; et
- le facteur de remplissage *ff* du réseau de plots est compris entre 40% et 65% ou le facteur de remplissage *ff* de la grille est compris entre 15% et 35%.

**14.** Procédé de fabrication d'un détecteur selon la revendication 12, dans lequel les motifs du réseau forment des plots ou une grille en silicium amorphe *(a-Si)*, l'indice de réfraction du silicium amorphe *(a-Si)* étant compris entre 0,9×3,4 et 1,1×3,4, la période du réseau étant comprise entre 1 et 3 micromètres, et en ce que :

- distance *hP* entre la membrane et le capot est comprise entre 1,5 micromètre et 2 micromètres ;
- la distance *hR* entre la membrane et le réflecteur est comprise entre 1,6 micromètre et 2 micromètres ;
- la profondeur $e_T$ des plots du réseau est comprise entre 1,8 micromètre et 2,1 micromètres ; et
- le facteur de remplissage *ff* du réseau de plots est compris entre 30% et 50% et le facteur de remplissage *ff* de la grille est compris entre 10% et 25%.

**15.** Procédé de fabrication d'un détecteur selon la revendication 12, dans lequel les motifs du réseau forment des plots ou une grille en silicium amorphe *(a-Si)*, l'indice de réfraction du silicium amorphe *(a-Si)* étant compris entre 0,9×3,4 et 1,1 ×3,4, la période du réseau étant comprise entre 1 et 3 micromètres, et en ce que :

- distance *hP* entre la membrane et le capot est comprise entre 2 micromètres et 3 micromètres ;
- la distance *hR* entre la membrane et le réflecteur est comprise entre 1,4 micromètre et 1,8 micromètre ;
- la profondeur *et* des plots du réseau est comprise entre 1,5 micromètre et 2,1 micromètres ; et
- le facteur de remplissage *ff* du réseau de plots est compris entre 25% et 40% et le facteur de remplissage *ff* de la grille est compris entre 5% et 20%.

**16.** Procédé de fabrication d'un détecteur selon la revendication 12, dans lequel, ladite première structure optique étant formée d'une ou plusieurs couches de matériau non structurée,

- la distance *hP* entre la membrane et le capot est comprise entre 1 micromètre et 1,5 micromètre ;
- la distance *hR* entre la membrane et le réflecteur est comprise entre 1,8 micromètre et 2,3 micromètres ;
- l'épaisseur géométrique $e_1$ de la première couche optique est comprise entre 1,8 micromètre et 2,1 micromètres ; et
- l'indice de réfraction équivalent $n_{eq}^1$ de la première couche optique est compris entre 1,45 et 1,80.

**17.** Procédé de fabrication d'un détecteur selon la revendication 12, dans lequel, ladite première structure optique étant formée d'une ou plusieurs couches de matériau non structurée,

- la distance *hP* entre la membrane et le capot est comprise entre 1,5 micromètre et 2,0 micromètre ;
- la distance *hR* entre la membrane et le réflecteur est comprise entre 1,6 micromètre et 2,0 micromètres ;
- l'épaisseur géométrique $e_1$ de la première couche optique est comprise entre 1,8 micromètre et 2,1 micromètres ; et
- l'indice de réfraction équivalent $n_{eq}^1$ de la première couche optique est compris entre 1,35 et 1,60.

**18.** Procédé de fabrication d'un détecteur selon la revendication 12, dans lequel, ladite première structure optique étant formée d'une ou plusieurs couches de matériau non structurée,

- la distance *hP* entre la membrane et le capot est comprise entre 2,0 micromètre et 3,0 micromètre ;
- la distance *hR* entre la membrane et le réflecteur est comprise entre 1,5 micromètre et 2,1 micromètres ;
- l'épaisseur géométrique $e_1$ de la première couche optique est comprise entre 1,5 micromètre et 2,1 micromètres ; et
- l'indice de réfraction équivalent $n_{eq}^1$ de la première couche optique est compris entre 1,30 et 1,50.

**19.** Procédé de fabrication d'un détecteur selon l'une quelconque des revendications 13 à 18, dans lequel la membrane bolométrique est constituée de :

- une couche de nitrure de titane (*TiN*), de résistance de couche 380 Ohm/carré, d'épaisseur 8 nanomètres et d'indices optiques $n$=10,5 et $k$=16, à 10μm de longueur d'onde ; et
- sur laquelle est déposée une couche de silicium amorphe (*a-Si*), d'épaisseur 200 nanomètres et d'indices $n$ = 3,42 et $k$ = 0 à 10μm.

**20.** Détecteur apte à détecter une gamme de longueurs d'onde [$\lambda_8$ ; $\lambda_{14}$] centrée sur une longueur d'onde $\lambda_{10}$ obtenu selon un procédé conforme à l'une quelconque des revendications 1 à 19, le détecteur comprenant un dispositif de détection apte à détecter ladite gamme [$\lambda_8$ ; $\lambda_{14}$] et un boitier hermétique sous une pression prédéterminée dans laquelle est logé ledit dispositif, ledit boitier étant formé d'un substrat, de parois latérales solidaires du substrat et d'un capot supérieur solidaire des parois latérales et comprenant une partie au droit du dispositif qui est transparente dans ladite gamme [$\lambda_8$ ; $\lambda_{14}$], ledit capot étant constitué d'un empilement de première, seconde et troisième structures optiques transparentes dans ladite gamme [$\lambda_8$ ; $\lambda_{14}$], la première structure optique étant la structure optique la plus proche du substrat ; la seconde et la troisième structures optiques ayant des indices de réfraction équivalents à la longueur d'onde $\lambda_{10}$ respectivement supérieur ou égal à 3,4 et inférieur ou égal à 2,3, dans lequel :

- l'épaisseur optique de la première structure optique est supérieure ou égale à $\lambda_{10}/10$ ;
- et l'indice de réfraction équivalent $n_{eq}^{1}$ à la longueur d'onde $\lambda_{10}$ de la première structure optique est inférieur ou égal à 2,6 ;
- *et* dans lequel la première structure optique présente un réseau périodique de motifs bidimensionnels saillants (62), le pas ou la période du réseau périodique étant inférieur à $\frac{\lambda_{10}}{3}$.

## Patentansprüche

**1.** Verfahren zur Herstellung eines Detektors, der geeignet ist, einen Wellenlängenbereich [$\lambda_8$; $\lambda_{14}$] zu erfassen, der auf einer Wellenlänge $\lambda_{10}$ zentriert ist, wobei der Detektor eine Detektionseinrichtung, die geeignet ist, den besagten Bereich [$\lambda_8$; $\lambda_{14}$] zu erfassen, und ein hermetisches Gehäuse unter einem vorbestimmten Druck, in dem die besagte Einrichtung untergebracht ist, umfasst, wobei das besagte Gehäuse aus einem Substrat, mit dem Substrat fest verbundenen Seitenwänden und einer mit den Seitenwänden fest verbundenen oberen Abdeckung gebildet ist und einen Abschnitt an der rechten Seite der Einrichtung umfasst, der in dem besagten Bereich [$\lambda_8$; $\lambda_{14}$ ] transparent ist, wobei das Verfahren Folgendes umfasst:

- die Umsetzung der besagten Einrichtung auf dem Substrat, wobei die besagte Umsetzung das Aufbringen einer Opferschicht umfasst, die die besagte Einrichtung vollständig einbettet;
die Umsetzung der Abdeckung auf der Opferschicht, wobei die besagte Abdeckung aus einem Stapel aus einer ersten, zweiten und dritten transparenten optischen Struktur in dem besagten Bereich [$\lambda_8$; $\lambda_{14}$] besteht, wobei die zweite und dritte optische Struktur Brechungsindizes aufweisen, die äquivalent zur Wellenlänge $\lambda_{10}$ und größer oder gleich 3,4 bzw. kleiner oder gleich 2,3 sind;
- nach der Umsetzung eines Teils der Abdeckung, der zumindest die erste optische Struktur umfasst, die Umsetzung einer Zugangsöffnung zur Opferschicht durch den besagten Teil der Abdeckung, gefolgt von der Anwendung eines Ätzvorgangs durch die Öffnung, um die Opferschicht vollständig zu entfernen;
worin:

  - die optische Dicke der ersten optischen Struktur größer oder gleich $\lambda_{10}/10$ ist,
  - der Brechungsindex der ersten optischen Struktur $n_{eq}^{1}$, der äquivalent zur Wellenlänge $\lambda_{10}$ ist, kleiner oder gleich 2,6 ist; und
  - die Fläche der ersten optischen Struktur, die auf der Opferschicht gebildet ist, inert gegenüber dem Ätzen, das zum Entfernen der Opferschicht durchgeführt wird, ist;

und worin
die Umsetzung der ersten optischen Struktur weiter die Bildung eines periodischen Rasters mit Vertiefungen in der Opferschicht umfasst, wobei das Maß oder die Periode des periodischen Rasters kleiner als $\frac{\lambda_{10}}{3}$ ist, wobei die Umsetzung der ersten optischen Struktur zu einer zumindest teilweisen Füllung der Vertiefungen des Rasters führt.

**2.** Verfahren zur Herstellung eines Detektors nach Anspruch 1, worin - das Ätzen ein vorbestimmtes isotropes Ätzen auf der Basis von Flusssäuredampf (*HFv)* ist;

- und das dem vorbestimmten isotropen Ätzen gegenüber inerte Material amorphes Silizium (*a-Si*) oder amorpher Kohlenstoff (*a-C*) oder eine amorphe Legierung aus Kohlenstoff (*C*) und Silizium (*Si*) vom Typ $a\text{-}Si_xC_{(1-x)}$ oder eine amorphe Legierung aus Silizium (*Si*) und Germanium (Ge) vom Typ $a\text{-}Si_xGe_{(1-x)}$ ist, wobei $0 < x < 1$ ist.

**3.** Verfahren zur Herstellung eines Detektors nach Anspruch 1, worin

- das Ätzen ein vorgegebenes trockenes oxidierendes isotropes Ätzen ist;
- und das dem vorbestimmten isotropen Ätzen gegenüber inerte Material amorphes Silizium (*a-Si*) oder eine amorphe Legierung aus Kohlenstoff (*C*) und Silizium (*Si*) vom Typ $a\text{-}Si_xC_{(1-x)}$ ist, wobei $0{,}05 \leq x < 1$ ist, oder eine amorphe Legierung aus Silizium (*Si*) und Germanium (*Ge*) vom Typ $a\text{-}Si_xGe_{(1-x)}$ ist, wobei $0 \leq x < 1$ ist.

**4.** Verfahren zur Herstellung eines Detektors nach einem der vorstehenden Ansprüche, worin die erste optische Struktur eine optische Dicke $e_1$ aufweist, für die die folgende Beziehung gilt:

$$e_1 = \frac{\lambda_{10}}{4}$$

**5.** Verfahren zur Herstellung eines Detektors nach einem der vorstehenden Ansprüche, worin die zweite optische Struktur vollständig aus Germanium (*Ge*) oder einem Stapel aus einer amorphen Siliziumschicht (*a-Si*) und einer Germaniumschicht (*Ge*) besteht.

**6.** Verfahren zur Herstellung eines Detektors nach einem der vorstehenden Ansprüche, worin die zweite optische Struktur eine optische Dicke $e_2$ aufweist, für die die folgende Beziehung gilt:

$$e_2 = p_2 \times \frac{\lambda_{10}}{4}$$

wobei in diesem Ausdruck $p_2$ = 1, 2 oder 4 ist.

**7.** Verfahren zur Herstellung eines Detektors nach einem der vorstehenden Ansprüche, worin die dritte optische Struktur vollständig aus Zinksulfid besteht.

**8.** Verfahren zur Herstellung eines Detektors nach einem der Ansprüche 1 bis 6, worin die dritte optische Struktur vollständig aus einer amorphen Legierung aus Kohlenstoff (*C*) und Silizium (*Si*) vom Typ $a\text{-}Si_xC_{(1-x)}$ besteht, wobei $0 < x < 1$, insbesondere $x \leq 0{,}4$ ist.

**9.** Verfahren zur Herstellung eines Detektors nach einem der vorstehenden Ansprüche, worin die dritte optische Struktur eine optische Dicke $e_3$ aufweist, für die die folgende Beziehung gilt:

$$e_3 = \frac{\lambda_{10}}{4}$$

**10.** Verfahren zur Herstellung eines Detektors nach einem der vorstehenden Ansprüche, worin die geometrische Dicke der ersten, zweiten und dritten optischen Struktur insgesamt kleiner oder gleich $\frac{\lambda_{10}}{2}$ ist,

**11.** Verfahren zur Herstellung eines Detektors nach einem der vorstehenden Ansprüche, worin die Detektionseinrichtung zumindest eine bolometrische Membran umfasst, die geeignet ist, einen Teil der Strahlung in dem besagten Bereich $[\lambda_8; \lambda_{14}]$ zu absorbieren, und die über einem Metallreflektor aufgehängt ist, wobei das Verfahren Folgendes umfasst:

- die Bestimmung der Schwankungen der Absorption der besagten Membran in Abhängigkeit von der besagten optischen Struktur des besagten Fensters;

- die Bestimmung der Wertebereiche für den äquivalenten Brechungsindex der ersten $n_{eq}^{1}$ optischen Struktur des Fensters, den Abstand zwischen der bolometrischen Membran und dem Metallreflektor und/oder den Abstand zwischen der bolometrischen Membran und dem Fenster; und
- die Auswahl eines Quadrupletts in den besagten bestimmten Bereichen, das eine mittlere Absorption der besagten Membran in dem besagten Bereich [$\lambda_8$; $\lambda_{14}$] von mehr als 90 % bewirkt;
- wobei das besagte Quadruplett zumindest die geometrische Dicke, den äquivalenten Brechungsindex der $n_{eq}^{1}$ ersten optischen Struktur des Fensters, den Abstand zwischen der bolometrischen Membran und dem Metallreflektor und den Abstand zwischen der bolometrischen Membran und dem Fenster umfasst.

**12.** Verfahren zur Herstellung eines Detektors nach Anspruch 11, worin die Umsetzung der ersten optischen Struktur das Bilden des periodischen Rasters von Mustern in seiner Fläche in Kontakt mit der Opferschicht umfasst, und die Dicke des Rasters, der Füllfaktor und die Periode des Rasters, der Abstand zwischen der Membran und dem Metallreflektor und der Abstand zwischen der Membran und der Abdeckung so ausgewählt werden, dass die mittlere Absorption der Membran in dem besagten Bereich [$\lambda_8$; $\lambda_{14}$ ] auf einen Wert größer als 90 % eingestellt wird.

**13.** Verfahren zur Herstellung eines Detektors nach Anspruch 12, worin die Muster des Rasters Zapfen oder ein Gitter aus amorphem Silizium *(a-Si)* bilden, wobei der Brechungsindex des amorphen Siliziums *(a-Si)* zwischen 0,9x3,4 und 1,1x3,4 liegt, wobei die Periode des Rasters zwischen 1 und 3 Mikrometern liegt, und dass:

- der Abstand *hP* zwischen der Membran und der Abdeckung zwischen 1 Mikrometer und 1,5 Mikrometern liegt;
- der Abstand *hR* zwischen der Membran und dem Reflektor zwischen 1,8 Mikrometern und 2,3 Mikrometern liegt;
- die Tiefe $e_T$ der Zapfen des Rasters zwischen 1,8 Mikrometern und 2,1 Mikrometern liegt; und
- der Füllfaktor *ff* des Zapfenrasters zwischen 40 % und 65 % oder der Füllfaktor *ff* des Gitters zwischen 15 % und 35 % liegt.

**14.** Verfahren zur Herstellung eines Detektors nach Anspruch 12, worin die Muster des Rasters Zapfen oder ein Gitter aus amorphem Silizium (*a-Si*) bilden, wobei der Brechungsindex des amorphen Siliziums (*a-Si*) zwischen 0,9x3,4 und 1,1x3,4 liegt, wobei die Periode des Rasters zwischen 1 und 3 Mikrometern liegt, und dass:

- der Abstand *hP* zwischen der Membran und der Abdeckung zwischen 1,5 Mikrometern und 2 Mikrometern liegt;
- der Abstand *hR* zwischen der Membran und dem Reflektor zwischen 1,6 Mikrometern und 2 Mikrometern liegt;
- die Tiefe $e_T$ der Zapfen des Rasters zwischen 1,8 Mikrometern und 2,1 Mikrometern liegt; und
- der Füllfaktor *ff* des Zapfenrasters zwischen 30 % und 50 % und der Füllfaktor *ff* des Gitters zwischen 10 % und 25 % liegt.

**15.** Verfahren zur Herstellung eines Detektors nach Anspruch 12, worin die Muster des Rasters Zapfen oder ein Gitter aus amorphem Silizium *(a-Si)* bilden, wobei der Brechungsindex des amorphen Siliziums *(a-Si)* zwischen 0,9x3,4 und 1,1x3,4 liegt, wobei die Periode des Rasters zwischen 1 und 3 Mikrometern liegt, und dass:

der Abstand *hP* zwischen der Membran und der Abdeckung zwischen 2 Mikrometern und 3 Mikrometern liegt;
der Abstand hR zwischen der Membran und dem Reflektor zwischen 1,4 Mikrometern und 1,8 Mikrometern liegt;
die Tiefe $e_T$ der Zapfen des Rasters zwischen 1,5 Mikrometern und 2,1 Mikrometern liegt; und
der Füllfaktor *ff* des Zapfenrasters zwischen 25 % und 40 % und der Füllfaktor *ff* des Gitters zwischen 5 % und 20 % liegt.

**16.** Verfahren zur Herstellung eines Detektors nach Anspruch 12, worin die besagte erste optische Struktur aus einer oder mehreren Schichten aus unstrukturiertem Material gebildet wird,

- der Abstand *hP* zwischen der Membran und der Abdeckung zwischen 1 Mikrometer und 1,5 Mikrometern liegt;
- der Abstand *hR* zwischen der Membran und dem Reflektor zwischen 1,8 Mikrometern und 2,3 Mikrometern liegt;
- die geometrische Dicke $e_1$ der ersten optischen Schicht zwischen 1,8 Mikrometern und 2,1 Mikrometern liegt; und

- der äquivalente Brechungsindex $n_{eq}^{1}$ der ersten optischen Schicht zwischen 1,45 und 1,80 liegt.

**17.** Verfahren zur Herstellung eines Detektors nach Anspruch 12, worin die besagte erste optische Struktur aus einer oder mehreren Schichten aus unstrukturiertem Material gebildet wird,

- der Abstand *hP* zwischen der Membran und der Abdeckung zwischen 1,5 Mikrometern und 2,0 Mikrometern liegt;
- der Abstand *hR* zwischen der Membran und dem Reflektor zwischen 1,6 Mikrometern und 2,0 Mikrometern liegt;
- die geometrische Dicke $e_1$ der ersten optischen Schicht zwischen 1,8 Mikrometern und 2,1 Mikrometern liegt; und
- der äquivalente Brechungsindex $n_{eq}^1$ der ersten optischen Schicht zwischen 1,35 und 1,60 liegt.

**18.** Verfahren zur Herstellung eines Detektors nach Anspruch 12, worin die besagte erste optische Struktur aus einer oder mehreren Schichten aus unstrukturiertem Material gebildet wird,

- der Abstand *hP* zwischen der Membran und der Abdeckung zwischen 2,0 Mikrometern und 3,0 Mikrometern liegt;
- der Abstand *hR* zwischen der Membran und dem Reflektor zwischen 1,5 Mikrometern und 2,1 Mikrometern liegt;
- die geometrische Dicke $e_1$ der ersten optischen Schicht zwischen 1,5 Mikrometern und 2,1 Mikrometern liegt; und
- der äquivalente Brechungsindex $n_{eq}^1$ der ersten optischen Schicht zwischen 1,30 und 1,50 liegt.

**19.** Verfahren zur Herstellung eines Detektors nach einem der Ansprüche 13 bis 18, worin die bolometrische Membran aus Folgendem besteht:

- einer Schicht aus Titannitrid (*TiN*) mit einem Schichtwiderstand von 380 Ohm/sq, einer Dicke von 8 Nanometern und optischen Indizes *n*=10,5 und *k*=16 bei 10 μm Wellenlänge; und
- auf der eine Schicht aus amorphem Silizium *(a-Si)* mit einer Dicke von 200 Nanometern und den Indizes *n* = 3,42 und *k* = 0 bei 10 μm aufgebracht ist.

**20.** Detektor, der geeignet ist, einen Wellenlängenbereich [$\lambda_8$; $\lambda_{14}$] zu erfassen, der auf einer Wellenlänge $\lambda_{10}$ zentriert ist, der durch ein Verfahren nach einem der Ansprüche 1 bis 19 erhalten wird, wobei der Detektor eine Detektionseinrichtung, die geeignet ist, den besagten Bereich [$\lambda_8$; $\lambda_{14}$] zu erfassen, und ein hermetisches Gehäuse unter einem vorbestimmten Druck, in dem die besagte Einrichtung untergebracht ist, umfasst, wobei das besagte Gehäuse aus einem Substrat, fest mit dem Substrat verbundenen Seitenwänden und einer fest mit Seitenwänden verbundenen oberen Abdeckung gebildet ist und einen Abschnitt auf der rechten Seite der Einrichtung umfasst, der in dem besagten Bereich [$\lambda_8$; $\lambda_{14}$] transparent ist, wobei die Abdeckung aus einem Stapel aus einer ersten, zweiten und dritten, in dem besagten Bereich [$\lambda_8$; $\lambda_{14}$] transparenten, optischen Struktur besteht, wobei die erste optische Struktur die dem Substrat am nächsten liegende optische Struktur ist; wobei die zweite und dritte optische Struktur Brechungsindizes aufweisen, die äquivalent zur Wellenlänge $\lambda_{10}$ und größer oder gleich 3,4 bzw. kleiner oder gleich 2,3 sind, worin

- die optische Dicke der ersten optischen Struktur größer oder gleich $\lambda_{10}/10$ ist,
- und der Brechungsindex $n_{eq}^1$ der ersten optischen Struktur, der äquivalent zur Wellenlänge $\lambda_{10}$ ist, kleiner oder gleich 2,6 ist;
und worin
- die erste optische Struktur ein periodisches Raster hervorragender zweidimensionaler Muster (62) aufweist, wobei das Maß oder die Periode des periodischen Rasters geringer als $\frac{\lambda_{10}}{3}$ ist.

## Claims

**1.** A method of manufacturing a detector capable of detecting a wavelength range [$\lambda_8$; $\lambda_{14}$] centered on a wavelength $\lambda_{10}$, the detector comprising a detection device capable of detecting said range [$\lambda_8$; $\lambda_{14}$] and a hermetic package under a predetermined pressure having said device housed therein, said package being formed of a substrate, of lateral walls attached to the substrate and of an upper cap attached to the lateral walls and comprising a portion vertically in line with the device which is transparent in said range [$\lambda_8$; $\lambda_{14}$], the method comprising:

- forming said device on the substrate, said forming comprising depositing a sacrificial layer totally embedding said device;
- forming the cap on the sacrificial layer, said cap being formed of a stack of first, second, and third optical structures transparent in said range [$\lambda_8$; $\lambda_{14}$], the second and third optical structures having equivalent refraction indexes at wavelength $\lambda_{10}$ respectively greater than or equal to 3.4 and smaller than or equal to 2.3;
- after the forming of a portion of the cap comprising at least the first optical structure, forming a vent of access to the sacrificial layer through said portion of the cap, and then applying, through the vent, an etching to totally remove the sacrificial layer,

***in which** :*

  - the optical thickness of the first optical structure is greater than or equal to $\lambda_{10}/10$;
  - the equivalent refraction index $n_{eq}^1$ at wavelength $\lambda_{10}$ of the first optical structure is smaller than or equal to 2.6; and
  - the surface of the first optical structure formed on the sacrificial layer is inert to the etching implemented to remove the sacrificial layer;

***and in which*** the forming of the first optical structure further comprises forming a periodic grating of depressions in the sacrificial layer, the pitch or the period of the periodic grating being smaller than $\frac{\lambda_{10}}{3}$, the forming of the first optical structure resulting in at least partially filling the depressions of said grating.

**2.** A method of manufacturing the detector of claim 1, ***in which :***

- the etching is a predetermined isotropic etching based on hydrofluoric acid vapor *(HFv);*
- the material inert to the predetermined isotropic etching is amorphous silicon (*a-Si*) or amorphous carbon (a-*C*) or an amorphous alloy of carbon (*C*) and of silicon (*Si*) of $a\text{-}Si_xC_{(1-x)}$ type, or an amorphous alloy of silicon (*Si*) et and of germanium (Ge) of $a\text{-}Si_xGe_{(1-x)}$ type, where $0 < x < 1$.

**3.** The detector manufacturing method of claim 1, ***in which:***

- the etching is a predetermined isotropic dry oxidizing etching ;
- the material inert to the predetermined isotropic etching is amorphous silicon (*a-Si*) or an amorphous alloy of carbon (*C*) and of silicon (*Si*) of $a\text{-}Si_xC_{(1-x)}$ type where $0.05 \leq x < 1$, or an amorphous alloy of silicon (*Si*) et and of germanium (Ge) of $a\text{-}Si_xGe_{(1-x)}$ type, where $0 \leq x < 1$.

**4.** The detector manufacturing method of any of the foregoing claims, ***in which*** the first optical structure has an optical thickness $e_1$ verifying relation:

$$e_1 = \frac{\lambda_{10}}{4}$$

**5.** The detector manufacturing method of any of the foregoing claims, ***in which*** the second optical structure is entirely made of (*Ge*) or of a stack of a layer of amorphous silicon *(a-Si)* and of a layer of germanium (*Ge*).

**6.** The detector manufacturing method of any of the foregoing claims, ***in which*** the second optical structure has an optical thickness $e_2$ verifying relation:

$$e_2 = p_2 \times \frac{\lambda_{10}}{4}$$

in which expression $p_2$ = 1, 2, or 4.

**7.** The detector manufacturing method of any of the foregoing claims, ***in which*** the third optical structure is entirely made of zinc sulfide.

**8.** The detector manufacturing method of any of claims 1 to 6, ***in which*** the third optical structure is entirely made of an amorphous alloy of carbon (*C*) and of silicon (*Si*) of $a\text{-}Si_xC_{(1-x)}$ type, where $0 < x < 1$, particularly $x \leq 0.4$.

**9.** The detector manufacturing method of any of the foregoing claims, ***in which*** the third optical structure has an optical thickness $e_3$ verifying relation:

$$e_3 = \frac{\lambda_{10}}{4}$$

**10.** The detector manufacturing method of any of the foregoing claims, ***in which*** the total geometric thickness of the first, second, and third optical structures is smaller than or equal to $\frac{\lambda_{10}}{2}$.

**11.** The detector manufacturing method of any of the foregoing claims, ***in which*** the detection device comprises at least one bolometric membrane capable of absorbing part of the radiation in said range [$\lambda_8$; $\lambda_{14}$] and suspended above a metal reflector, the method comprising:

- determining variations of the absorbance of said membrane according to said optical structure of said window;

- determining ranges of values for the equivalent refraction index $n_{eq}^1$ of the first optical structure of the window, the distance between the bolometric membrane and the metal reflector and/or the distance between the bolometric membrane and the window while taking into account manufacturing and/or operating constraints; and
- selecting, in said determined ranges, a quadruplet inducing an average absorbance greater than 90% of said membrane in said range [$\lambda_8$; $\lambda_{14}$];

- said quadruplet comprising at least the geometric thickness, the equivalent refraction index $n_{eq}^1$ of the first optical structure of the window, the distance between the bolometric membrane and the metal reflector, and the distance between the bolometric membrane and the window.

**12.** The detector manufacturing method of claim 11, ***in which*** the forming of the first optical structure comprises forming the periodic grating of patterns in its surface in contact with the sacrificial layer, and the grating thickness, the filling factor, and the grating period, the distance between the membrane and the metal reflector, and the distance between the membrane and the cap are selected to set the average absorption of the membrane in said range [$\lambda_8$; $\lambda_{14}$] to a value greater than 90%.

**13.** The detector manufacturing method of claim 12, ***in which*** the patterns of the grating form pads or a grid of amorphous silicon (*a-Si*), the refraction index of amorphous silicon (*a-Si*) being in the range from 0.9×3.4, to 1.1x3.4, the period of the grating being in the range from 1 to 3 micrometers, and :

- distance *hP* between the membrane and the cap is in the range from 1 micrometer to 1.5 micrometer;
- distance *hR* between the membrane and the reflector is in the range from 1.8 micrometer to 2.3 micrometers;
- depth $e_T$ of the grating pads is in the range from 1.8 micrometer to 2.1 micrometers; and
- filling factor *ff* of the grating of pads is in the range from 40% to 65% or filling factor *ff* of the grid is in the range from 15% to 35%.

**14.** The detector manufacturing method of claim 12, ***in which*** the patterns of the grating form pads or a grid of amorphous silicon *(a-Si),* the refraction index of amorphous silicon *(a-Si)* being in the range from 0.9×3.4, to 1.1x3.4, the period of the grating being in the range from 1 to 3 micrometers, and :

- distance *hP* between the membrane and the cap is in the range from 1.5 micrometer to 2 micrometers;
- distance *hR* between the membrane and the reflector is in the range from 1.6 micrometer to 2 micrometers;
- depth $e_T$ of the grating pads is in the range from 1.8 micrometer to 2.1 micrometers; and
- filling factor *ff* of the grating of pads is in the range from 30% to 50% and filling factor *ff* of the grid is in the range from 10% to 25%.

**15.** The detector manufacturing method of claim 12, ***in which*** the patterns of the grating form pads or a grid of amorphous silicon *(a-Si),* the refraction index of amorphous silicon (*a-Si*) being in the range from 0.9×3.4, to 1.1×3.4, the period of the grating being in the range from 1 to 3 micrometers, and:

- distance *hP* between the membrane and the cap is in the range from 2 micrometers to 3 micrometers;
- distance *hR* between the membrane and the reflector is in the range from 1.4 micrometer to 1.8 micrometer;
- depth $e_T$ of the grating pads is in the range from 1.5 micrometer to 2.1 micrometers; and
- filling factor *ff* of the grating of pads is in the range from 25% to 40% and filling factor *ff* of the grid is in the range from 5% to 20%.

**16.** The detector manufacturing method of claim 12, ***in which*** said first optical structure is formed of one or a plurality of non-structured layers of material, and:

- distance *hP* between the membrane and the cap is in the range from 1 micrometer to 1.5 micrometer;
- distance *hR* between the membrane and the reflector is in the range from 1.8 micrometer to 2.3 micrometers;
- geometric thickness $e_1$ of the first optical layer is in the range from 1.8 micrometer to 2.1 micrometers; and
- equivalent refraction index $n_{eq}^1$ of the first optical layer is in the range from 1.45 to 1.80.

**17.** The detector manufacturing method of claim 12, ***in which*** said first optical structure is formed of one or a plurality of non-structured layers of material, and :

- distance *hP* between the membrane and the cap is in the range from 1.5 micrometer to 2.0 micrometers;
- distance *hR* between the membrane and the reflector is in the range from 1.6 micrometer to 2.0 micrometers;
- geometric thickness $e_1$ of the first optical layer is in the range from 1.8 micrometer to 2.1 micrometers; and
- equivalent refraction index $n_{eq}^1$ of the first optical layer is in the range from 1.35 to 1.60.

**18.** The detector manufacturing method of claim 12, ***in which*** said first optical structure is formed of one or a plurality of non-structured layers of material, and :

- distance *hP* between the membrane and the cap is in the range from 2.0 micrometer to 3.0 micrometer;
- distance hR between the membrane and the reflector is in the range from 1.5 micrometer to 2.1 micrometers;
- geometric thickness $e_1$ of the first optical layer is in the range from 1.5 micrometer to 2.1 micrometers; and
- equivalent refraction index $n_{eq}^1$ of the first optical layer is in the range from 1.30 to 1.50.

**19.** The detector manufacturing method of any of claims 13 to 18, ***in which*** the bolometric membrane is formed of a titanium nitride layer (*TiN*) having a 380-Ohm/square sheet resistance, a 8-nanometer thickness, and optical indexes *n* = 10.5 and *k* = 16 at a 10-μm wavelength; and having an amorphous silicon layer (*a-Si*) with a 200-nanometer thickness and indexes *n* = 3.42 and *k* = 0 to 10 μm deposited thereon.

**20.** A detector capable of detecting a wavelength range [$\lambda_8$; $\lambda_{14}$] centered on a wavelength $\lambda_{10}$, obtained by a manufacturing method according to anyone of claims 1 to 19, the detector comprising a detection device capable of detecting said range [$\lambda_8$; $\lambda_{14}$] and a hermetic package under a predetermined pressure having said device housed therein, said package being formed of a substrate, of lateral walls attached to the substrate and of an upper cap attached to the lateral walls and comprising a portion vertically in line with the device which is transparent in said range [$\lambda_8$; $\lambda_{14}$], said cap being formed of a stack of first, second and third optical structures transparent in said range [$\lambda_8$; $\lambda_{14}$] , the first optical structure being the closer to the substrate, the second and the third optical structures having equivalent refraction indexes at wavelength $\lambda_{10}$ respectively greater than or equal to 3.4 and smaller than or equal to 2.3, and wherein;

- the optical thickness of the first optical structure is greater than or equal to $\lambda_{10}/10$;
- the equivalent refraction index $n_{eq}^1$ at wavelength $\lambda_{10}$ of the first optical structure is smaller than or equal to 2.6,

and wherein the first optical structure is provided with a periodic grating of raised two-dimensional patterns (62), the pitch or the period of the periodic grating being smaller than $\frac{\lambda_{10}}{3}$.

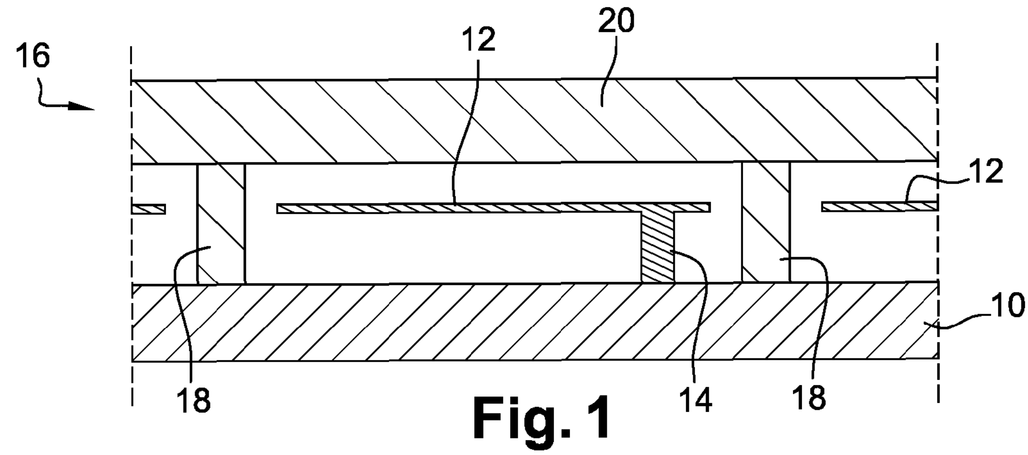


Fig. 1
(Etat de la technique)

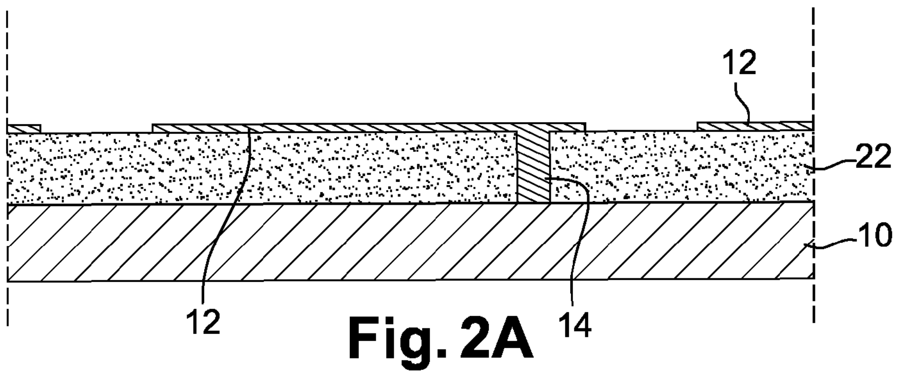


Fig. 2A
(Etat de la technique)

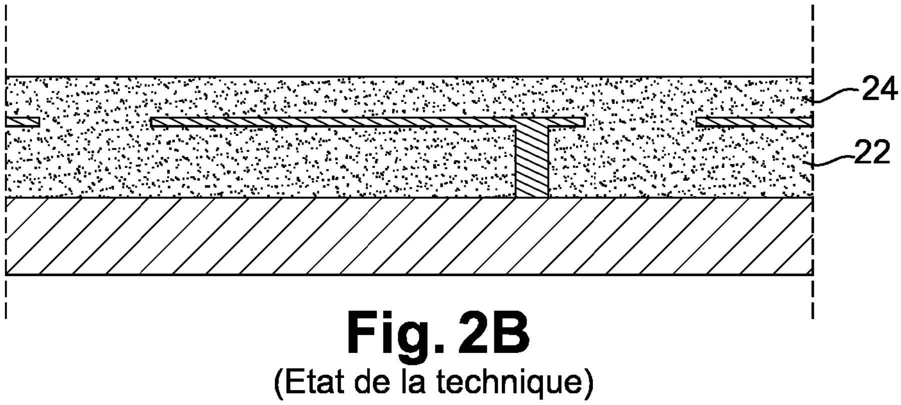


Fig. 2B
(Etat de la technique)

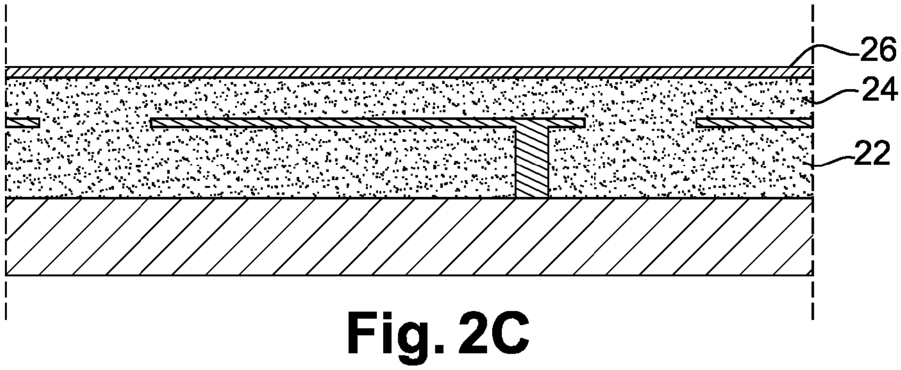


Fig. 2C
(Etat de la technique)

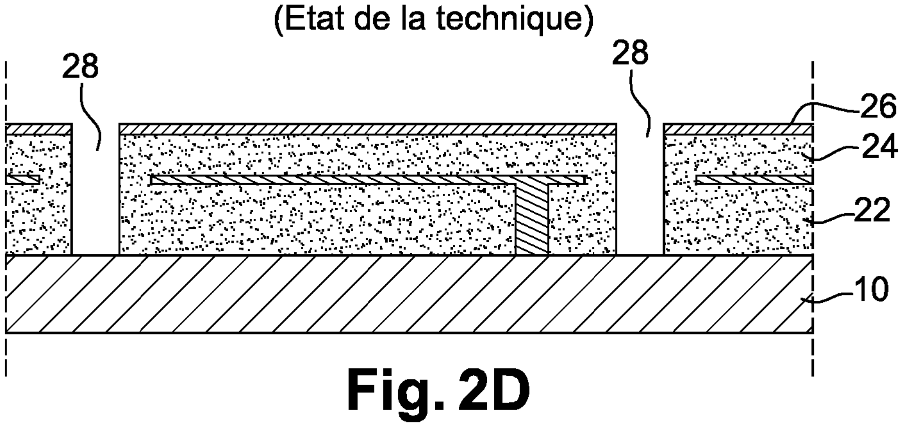


Fig. 2D
(Etat de la technique)

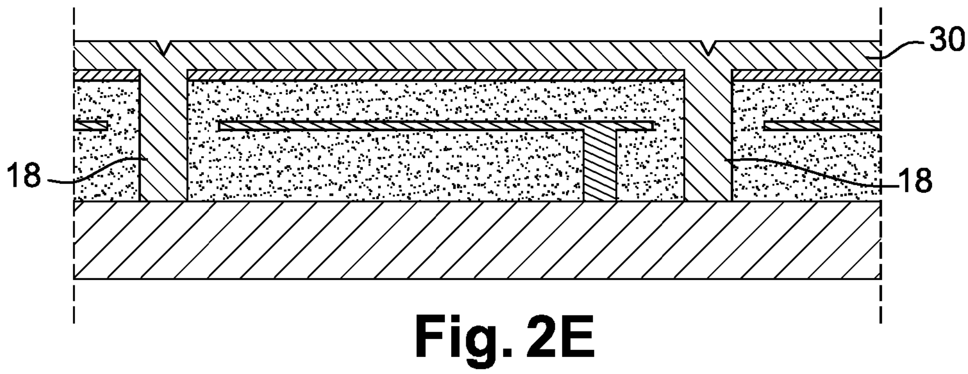


Fig. 2E
(Etat de la technique)

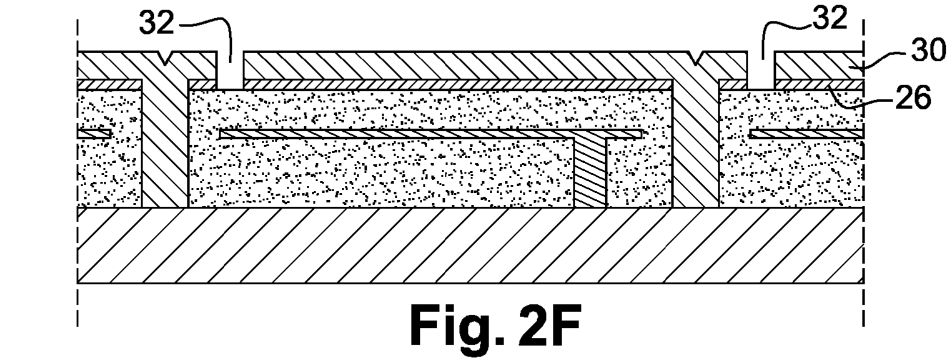


Fig. 2F
(Etat de la technique)

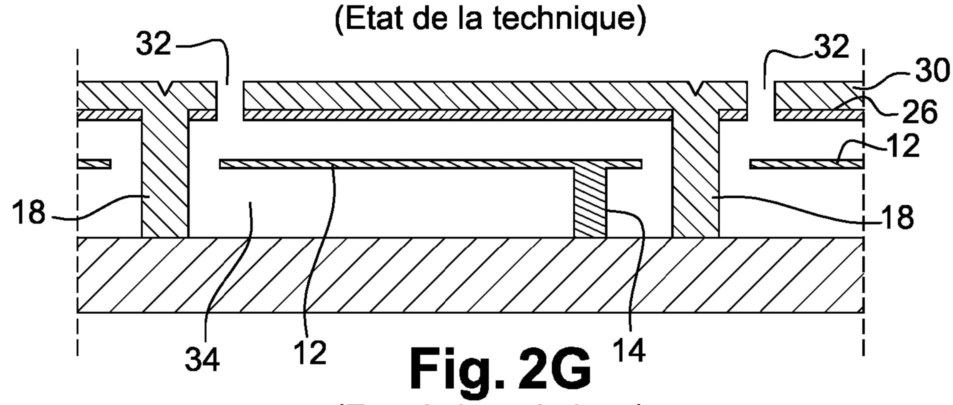


Fig. 2G
(Etat de la technique)

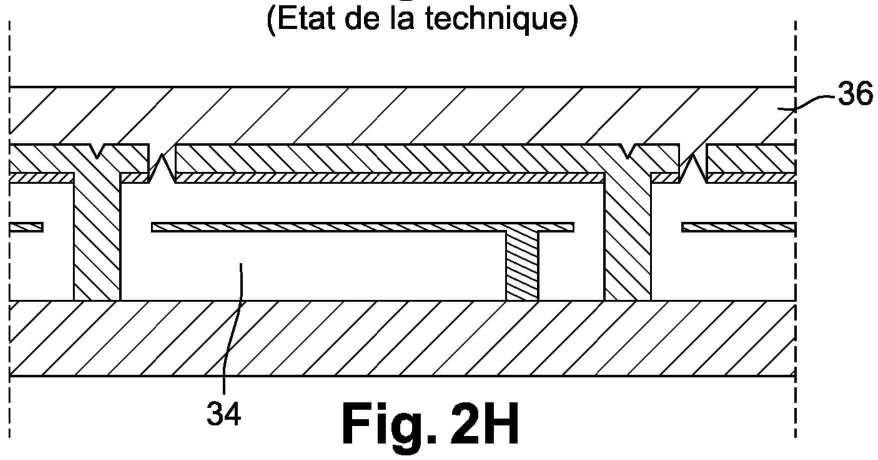


Fig. 2H
(Etat de la technique)

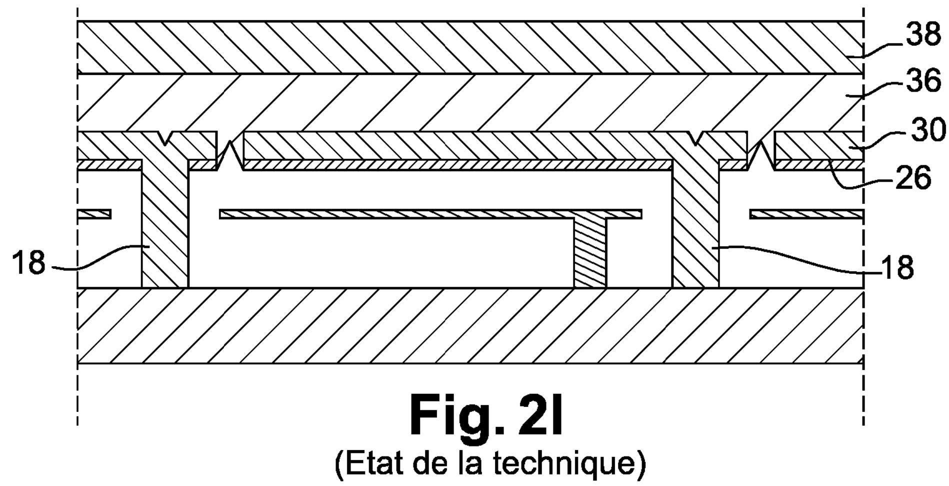


Fig. 2I
(Etat de la technique)

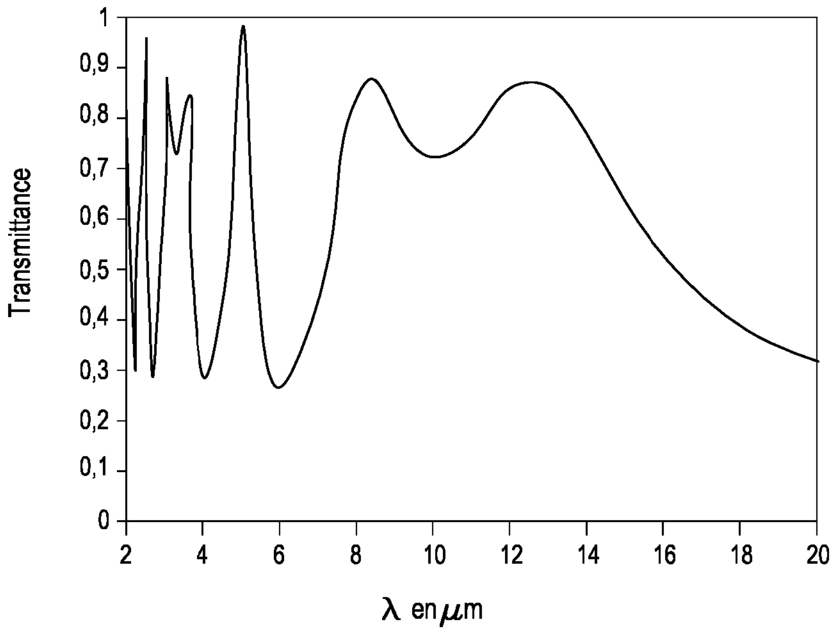


# Fig. 3A
(Etat de la technique)

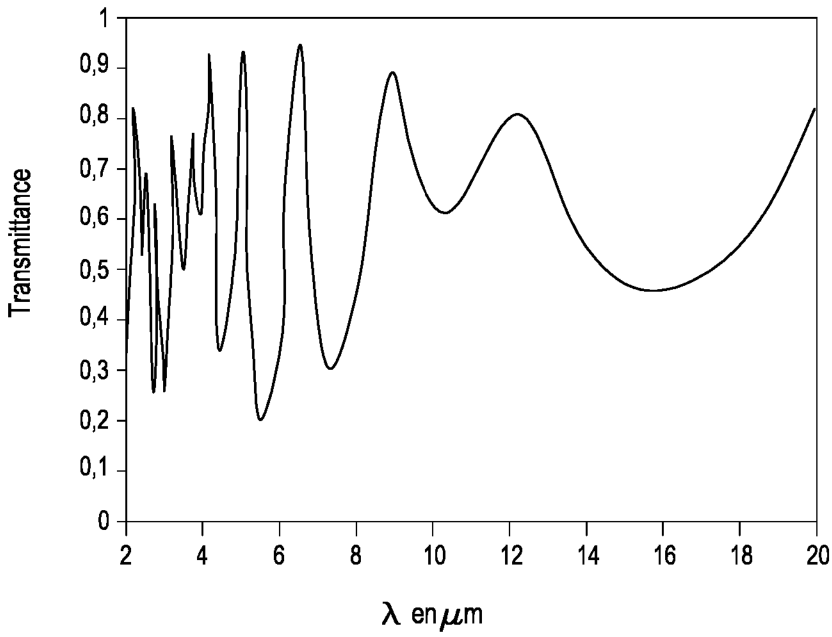


# Fig. 3B
(Etat de la technique)

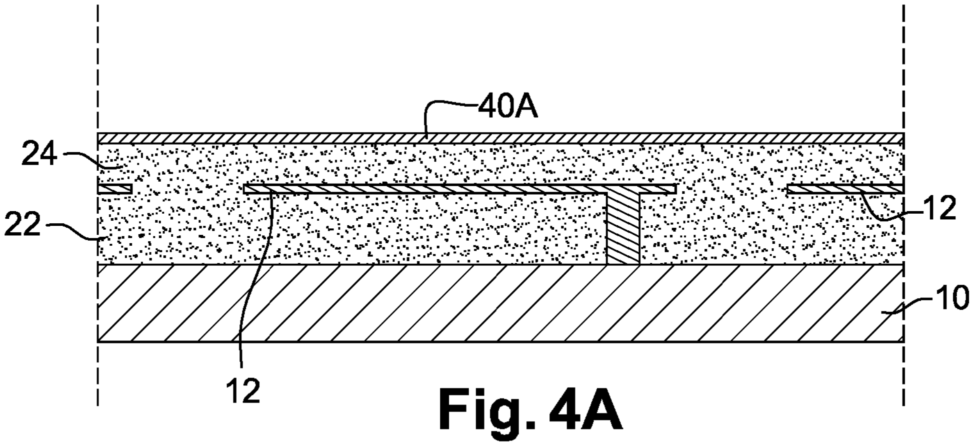


Fig. 4A

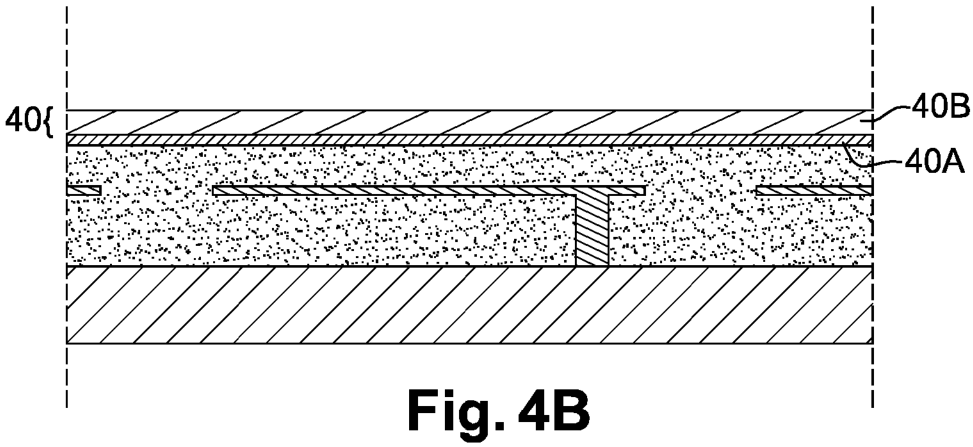


Fig. 4B

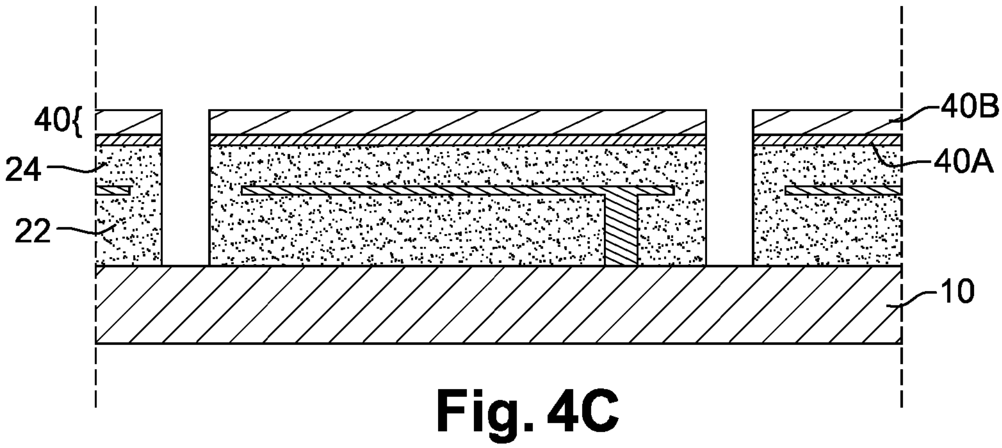


Fig. 4C

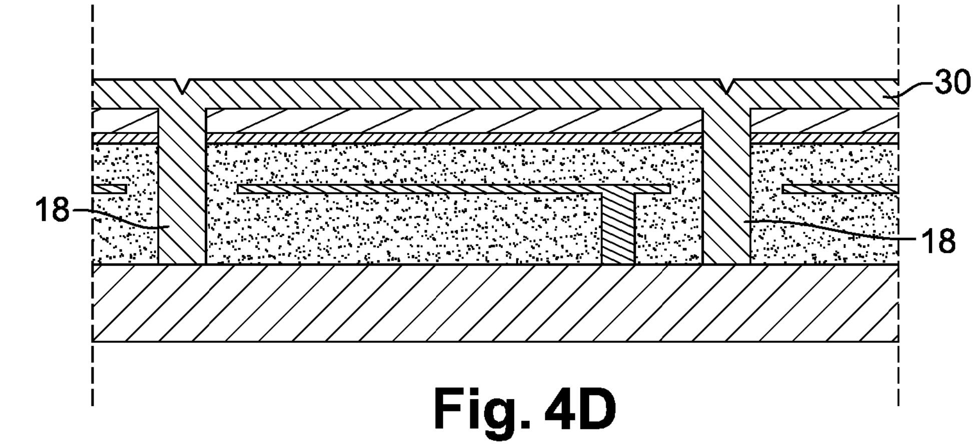


Fig. 4D

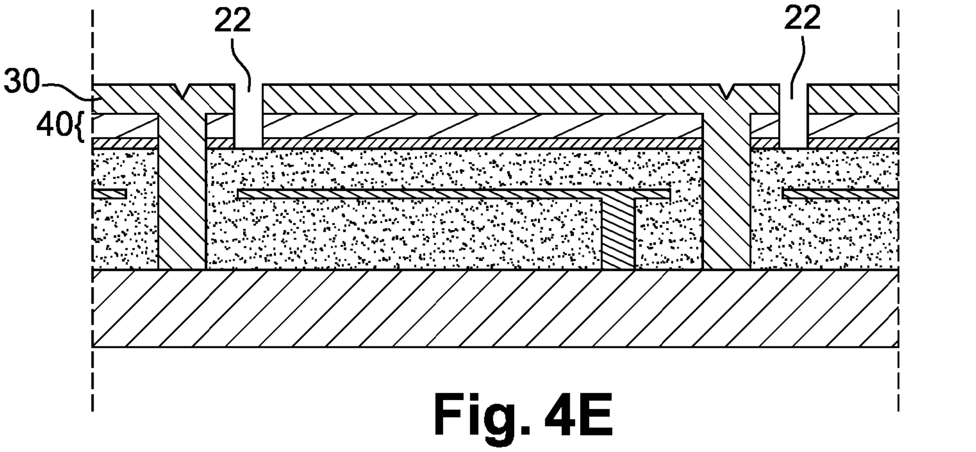


Fig. 4E

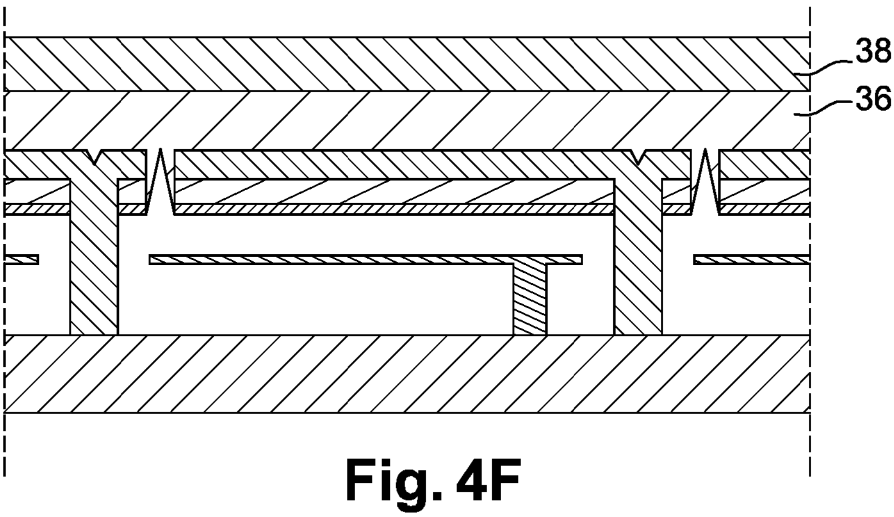


Fig. 4F

Fig. 5A

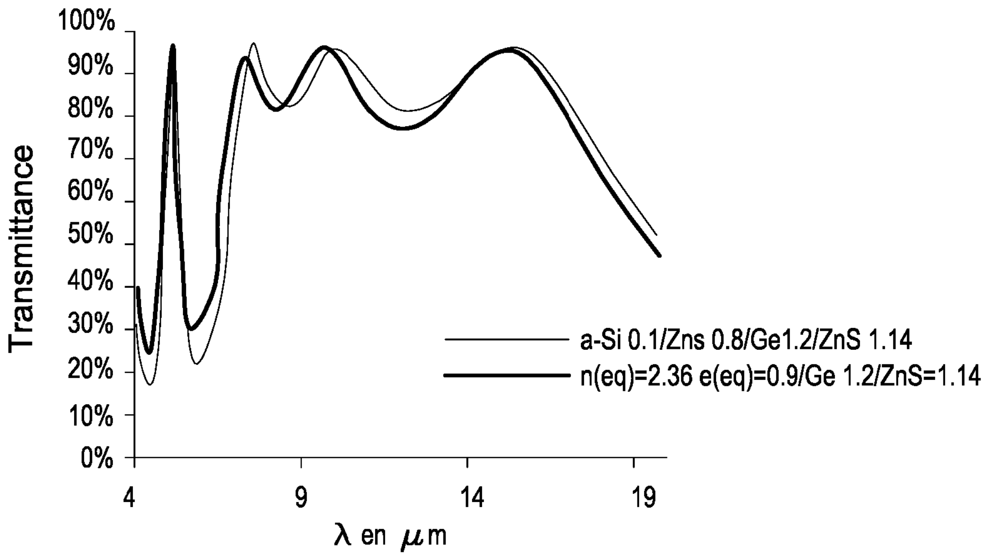


Fig. 5B

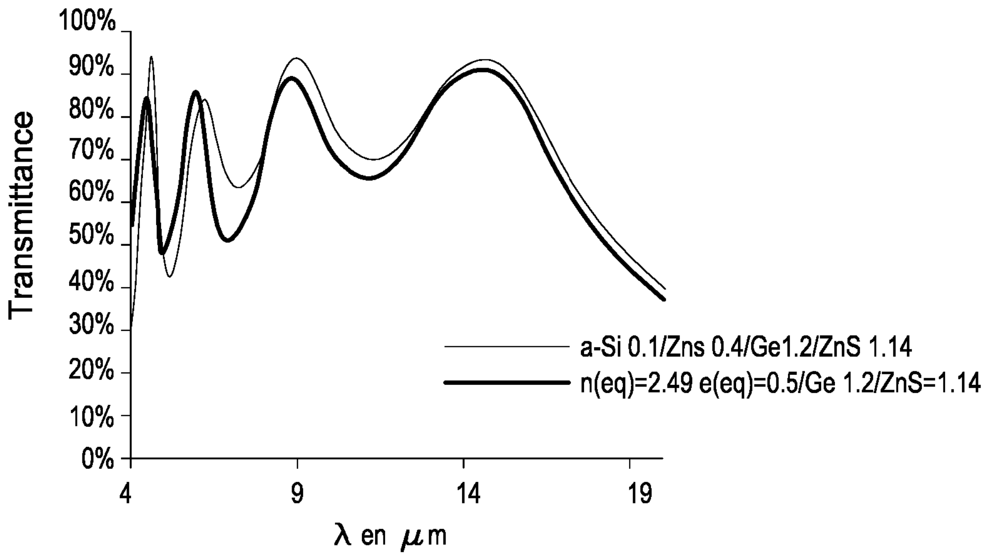


Fig. 5C

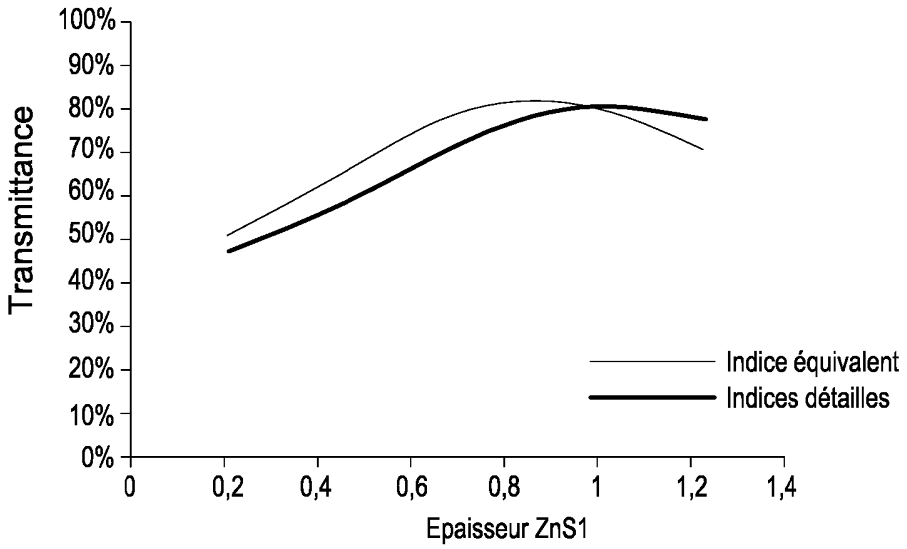

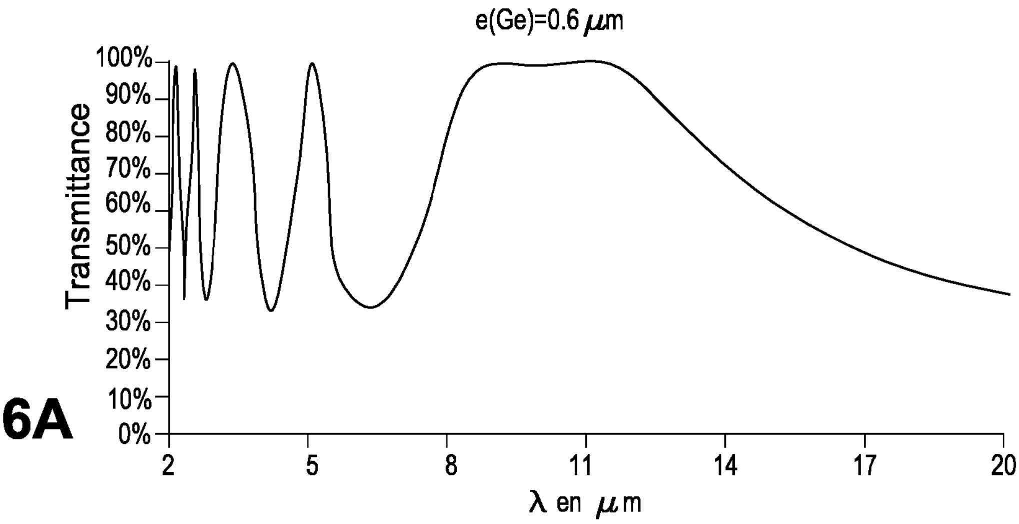


Fig. 6A

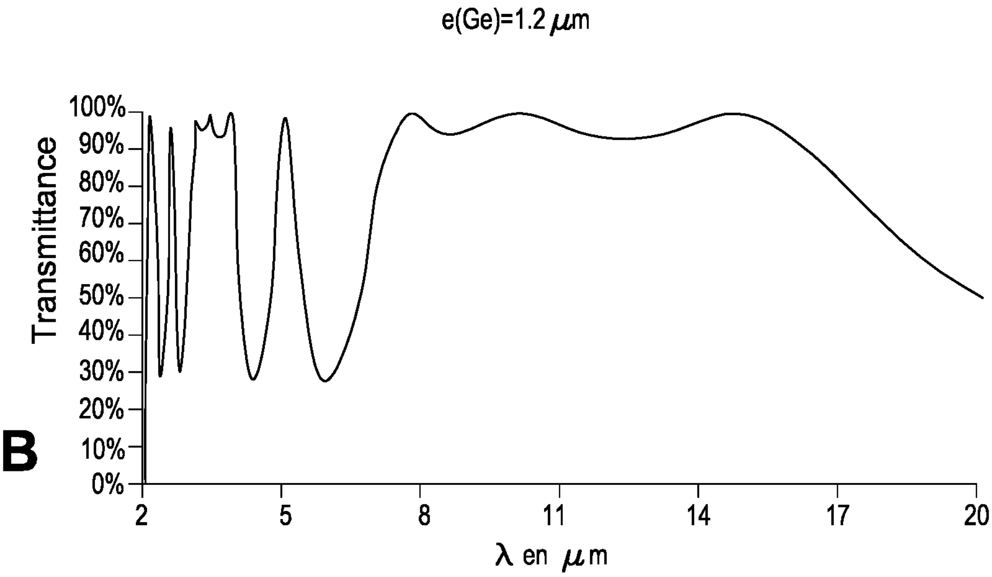


Fig. 6B

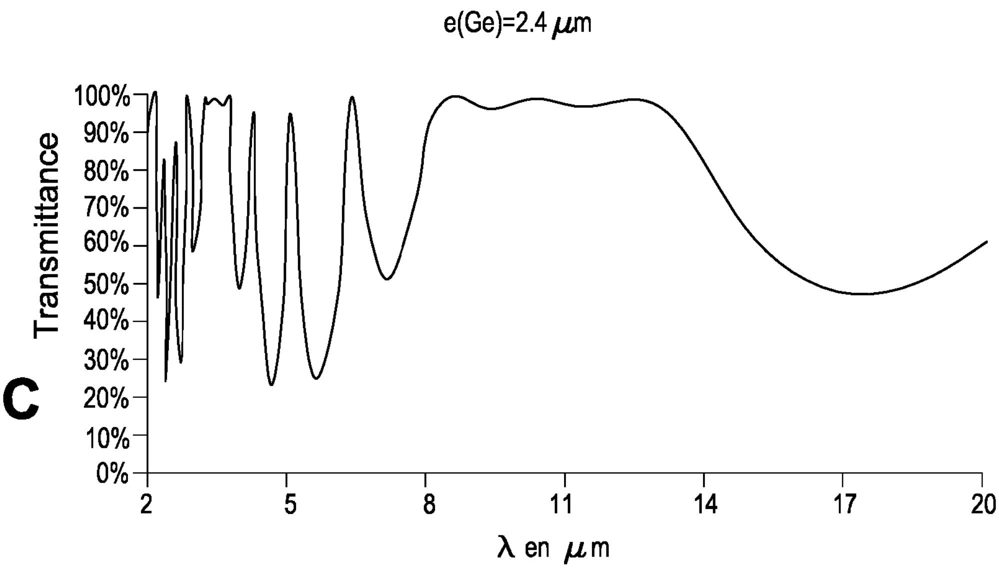


Fig. 6C

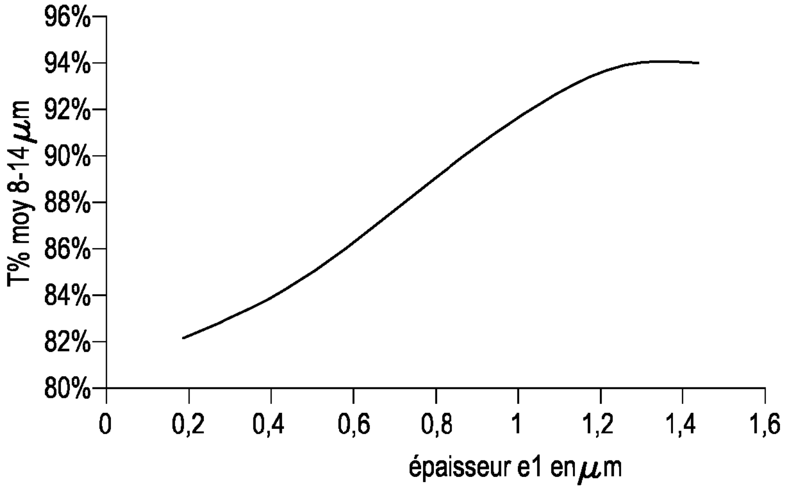
96%
94%
92%
90%
88%
86%
84%
82%
80%
T% moy 8-14 μm
0
0,2
0,4
0,6
0,8
1
1,2
1,4
1,6
épaisseur e1 en μm

Fig. 6D

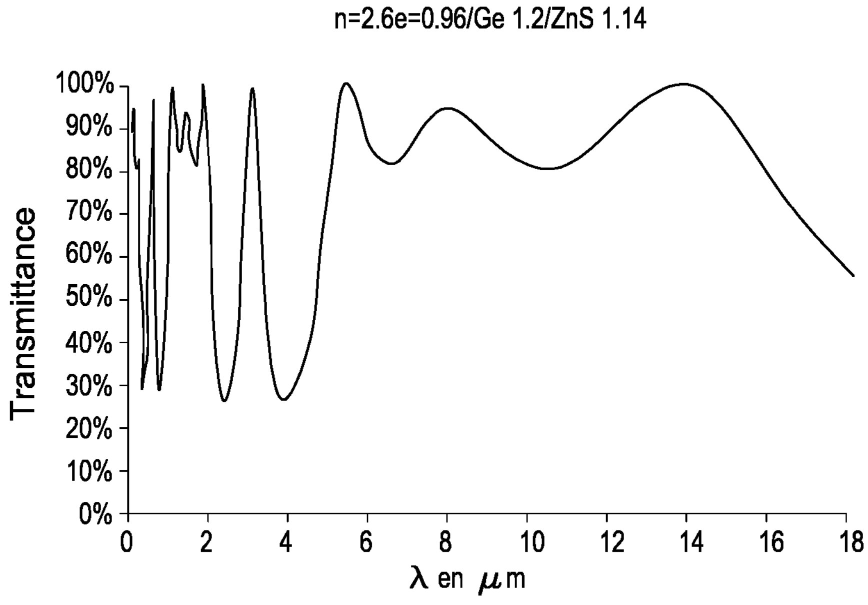
n=2.6e=0.96/Ge 1.2/ZnS 1.14
100%
90%
80%
70%
60%
50%
40%
30%
20%
10%
0%
Transmittance
0
2
4
6
8
10
12
14
16
18
λ en μm

Fig. 6E

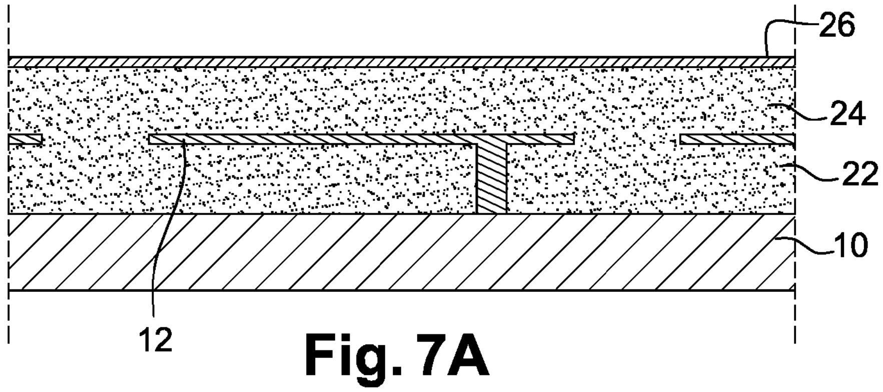


Fig. 7A

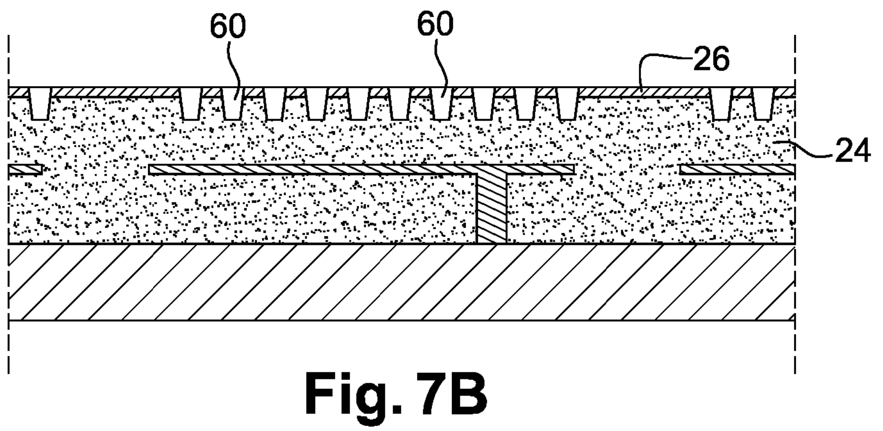


Fig. 7B

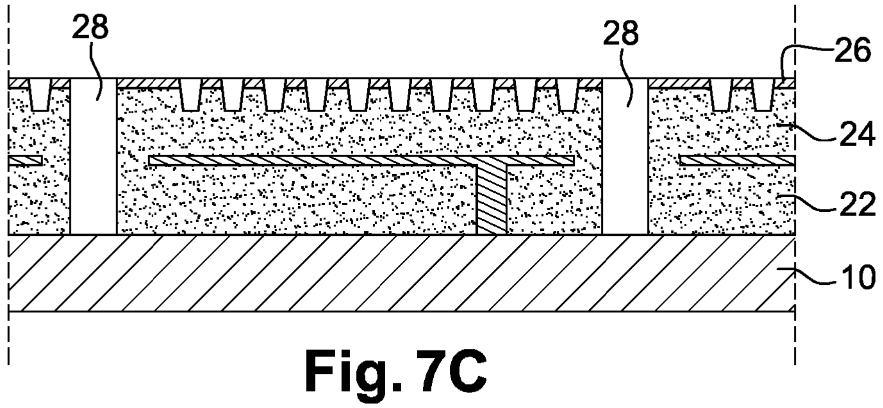


Fig. 7C

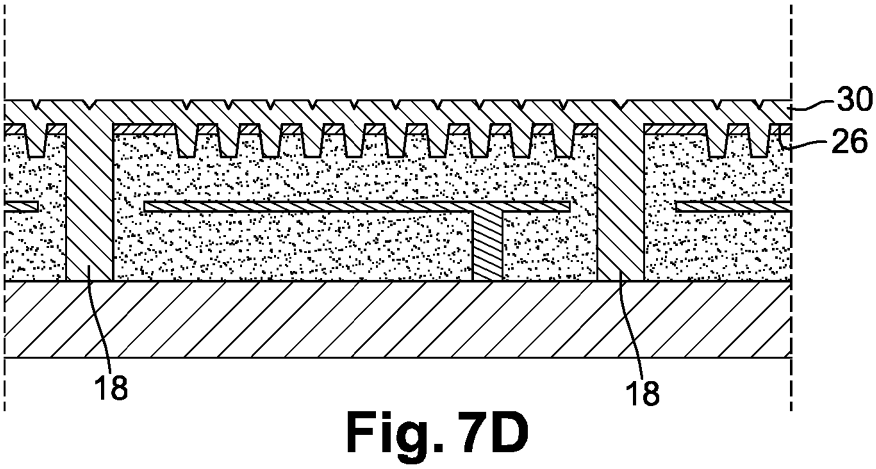


Fig. 7D

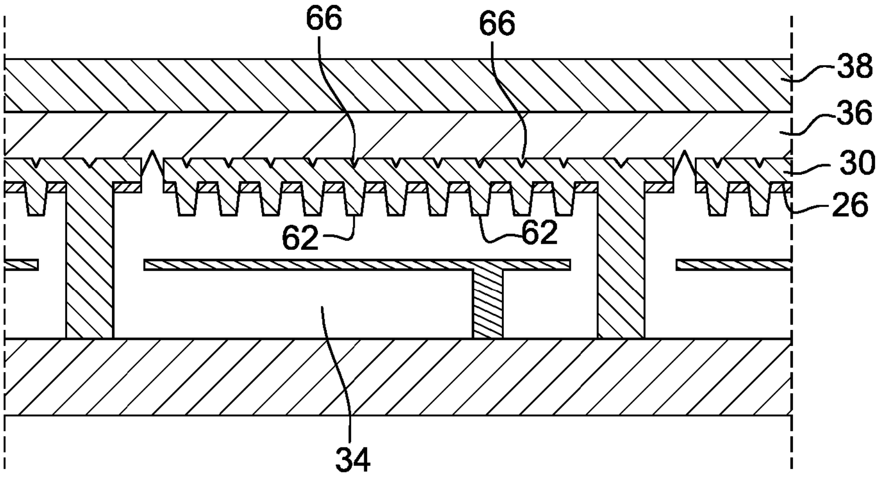


Fig. 7E

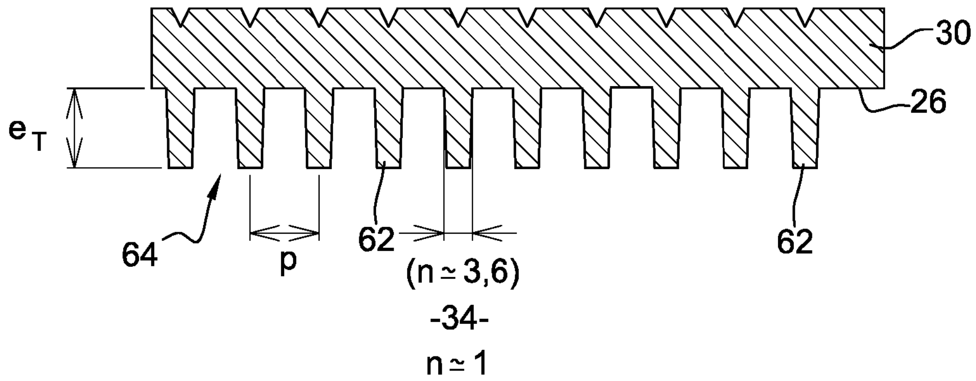


Fig. 8A

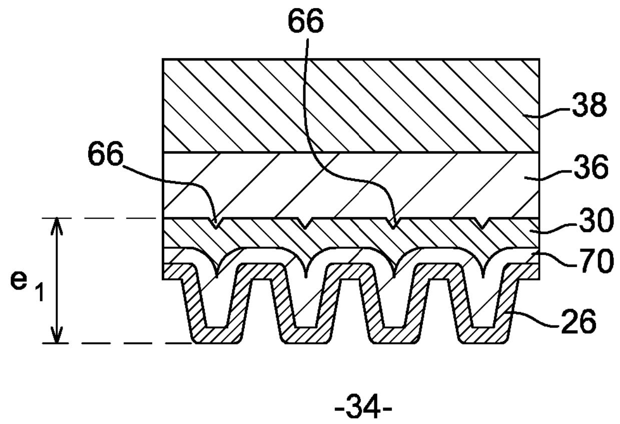


Fig. 8B

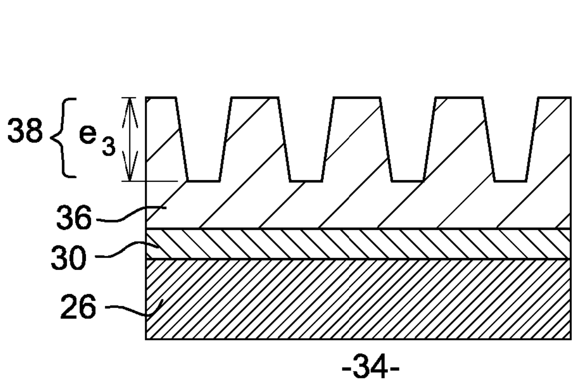


Fig. 9A

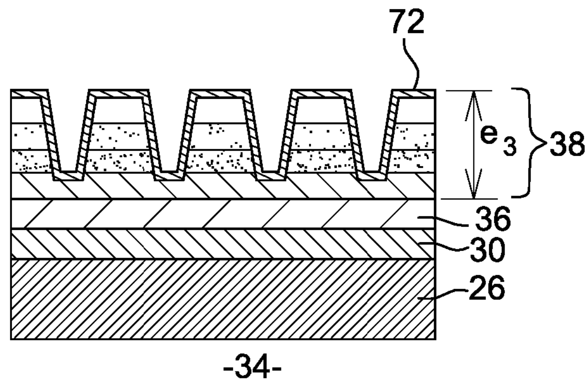


Fig. 9B

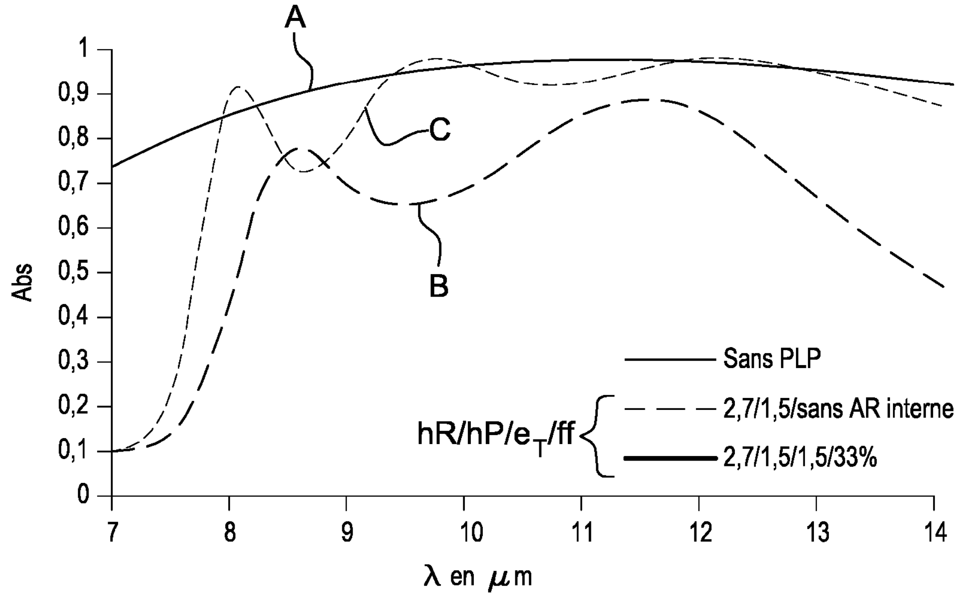


Fig. 10

Fig. 11A

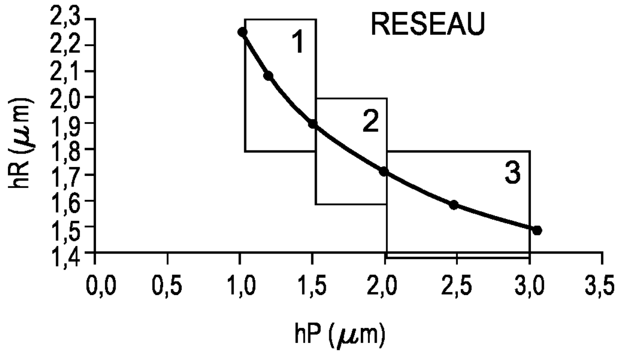


Fig. 11B

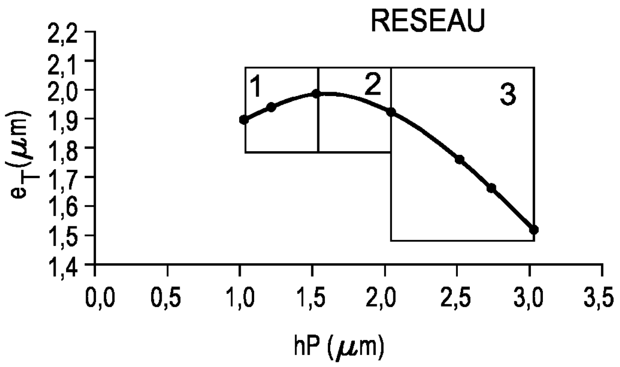


Fig. 11C

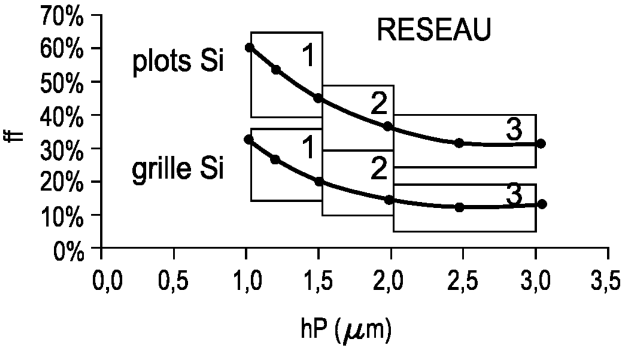

Fig. 11D

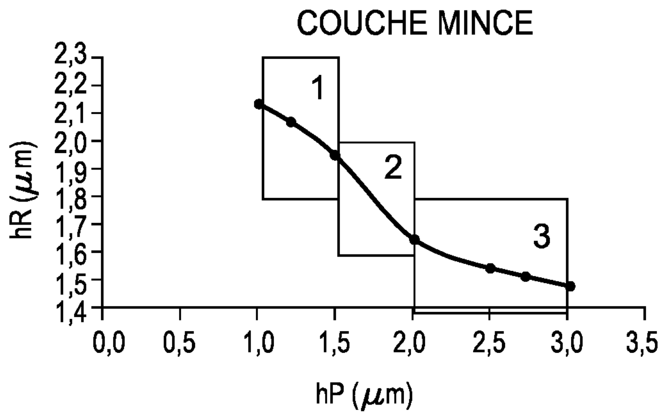


Fig. 11E

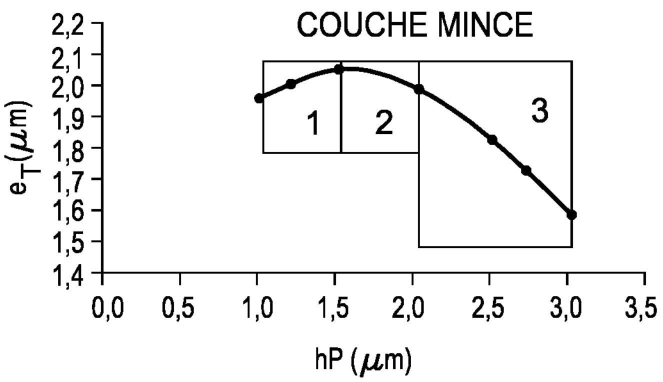


Fig. 11F

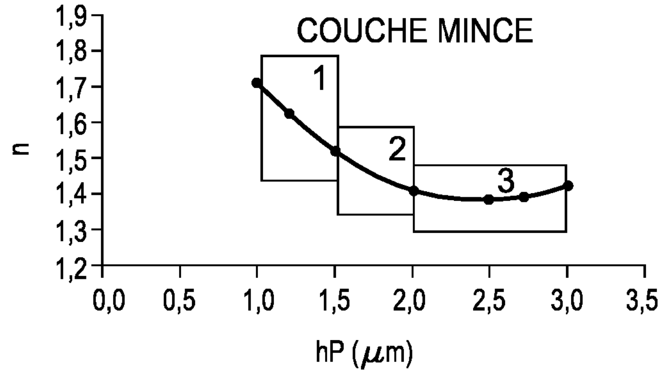

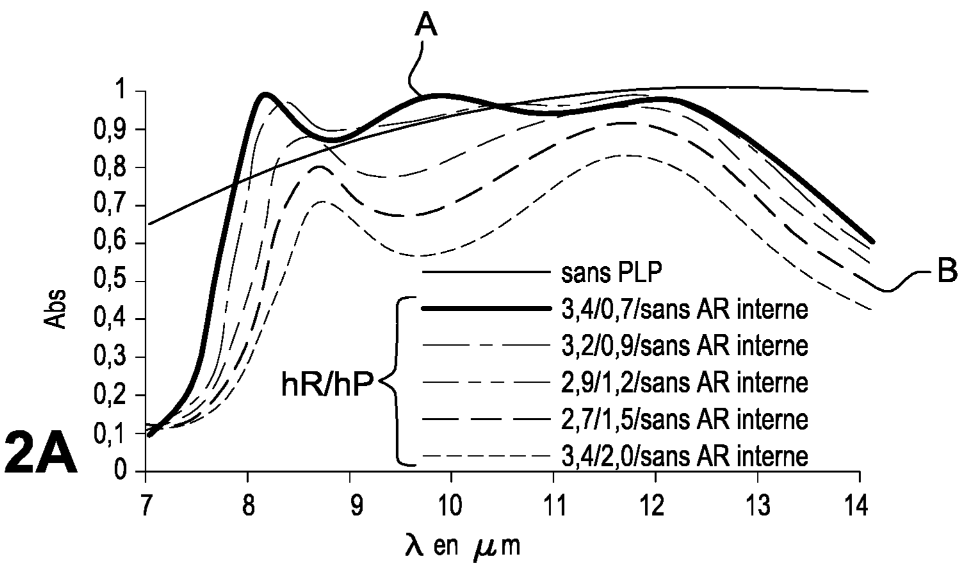


Fig. 12A

| hR/hP/$e_T$/ff | (8-14 μm) |
|---|---|
| sans PLP | 94% |
| 3,4/0,7/sans AR interne | 89% |
| 3,2/0,9/sans AR interne | 88% |
| 2,9/1,2/sans AR interne | 81% |
| 2,7/1,5/sans AR interne | 73% |
| 3,4/2,0/sans AR interne | 64% |

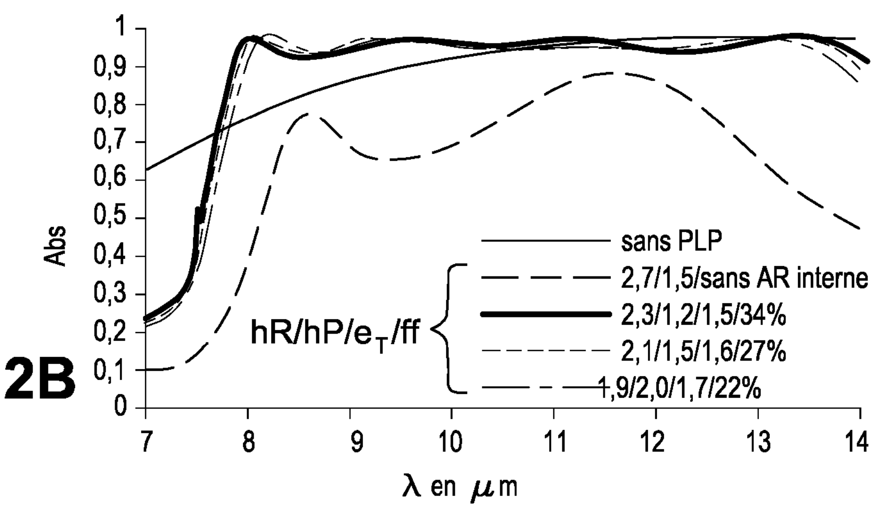


Fig. 12B

| hR/hP/$e_T$/ff | (8-14 μm) |
|---|---|
| sans PLP | 94% |
| 2,7/1,5/sans AR interne | 73% |
| 2,3/1,2/1,5/34% | 97% |
| 2,1/1,5/1,6/27% | 97% |
| 1,9/2,0/1,7/22% | 97% |

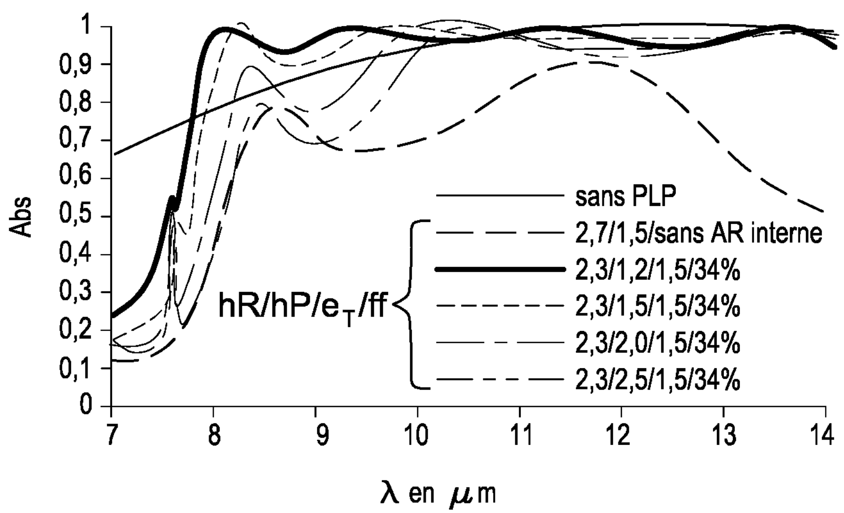


| hR/hP/$e_T$/ff | (8-14 μm) |
|---|---|
| sans PLP | 94% |
| 2,7/1,5/sans AR interne | 73% |
| 2,3/1,2/1,5/34% | 97% |
| 2,3/1,5/1,5/34% | 96% |
| 2,3/2,0/1,5/34% | 92% |
| 2,3/2,5/1,5/34% | 88% |

**Fig. 12C**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- EP 2447705 A
- WO 2013139403 A
- FR 2901264 A1
- FR 2822541
- FR 2822541 A
- FR 2936868
- CN 102935994
- WO 2014100648 A
- US 2003062480 A
- FR 2983297
- FR 2930639
- FR 2752299
- WO 2013079855 A1


### Littérature non-brevet citée dans la description


- **J.J. YON et al.** Latest improvements in microbolometer thin film packaging: paving the way for low-cost consumer applications. *Proc. SPIE 9070, Infrared Technology and Applications XL,* Juin 2014
- **MARVIN J. WEBER.** Handbook of Optical Materials (Laser & Optical Science & Technology. CRC Press, Septembre 2002
- **A. CARBONE et al.** *J. Mat. Res.,* Décembre 1990, vol. 5 (12
- **I. PEREYRA et al.** *Brasilian J. of Phys.,* Septembre 2000, vol. 30
- **B. RACINE et al.** *J. Ap.Phys.,* Novembre 2001, vol. 90 (10
- **EL KHALFI et al.** *Arabian J. for Sci. and Eng.,* Juillet 2014, vol. 39 (7), 5771-5776